# EUROPEAN PATENT APPLICATION

(11) **EP 4 554 360 A2**
(43) Date of publication of application: **14.05.2025**
(21) Application number: 24211524.4
(22) Date of filing: 07.11.2024
(51) Int. Cl.: H10K 39/34, H10K 59/126, H10K 59/131, H10K 59/65

(54) **DISPLAY DEVICE**

(30) Priority: 07.11.2023 KR 20230153021
(71) Applicant: Samsung Display Co., Ltd., Yongin-si, Gyeonggi-do 17113 (KR)
(72) Inventor: YOON, Soil, 17113 Yongin-si (KR); SONG, Heerim, 17113 Yongin-si (KR); LEE, Kyunghoe, 17113 Yongin-si (KR); LEE, Cheol-Gon, 17113 Yongin-si (KR)
(74) Representative: Walaski, Jan Filip

(57) **Abstract**

A display device includes a base layer, a circuit layer, and an element layer that is located on the circuit layer and that includes a light emitting element and a light receiving element. The circuit layer includes pixel drive circuits, sensor drive circuits, scan lines, and reset control lines. Lengths of the sensor drive circuits are greater than lengths of the pixel drive circuits. The scan lines are arranged in units of one pixel row. The reset control lines are arranged in units of p pixel rows, and p is greater than or equal to 2.

## Description

### BACKGROUND

### 1. Field

The disclosure relates to a display device having a biometric information recognition function.

### 2. Description of the Related Art

A display device provides various functions that enable a user to interact with the display device. For example, the display device may display an image to provide information to the user, or may sense a user input. Recent display devices include a function for sensing biometric information of a user.

The biometric information may be recognized by using a capacitive sensing technique for sensing a change in capacitance between electrodes, a light sensing technique for sensing incident light using an optical sensor, or an ultrasonic sensing technique for sensing vibration using a piezoelectric element.

### SUMMARY

Embodiments of the present disclosure provide a display device with improved biometric information recognition performance.

According to one or more embodiments, a display device includes a base layer having a display region and a non-display region, a circuit layer on the base layer, and an element layer on the circuit layer and that includes light emitting elements and light receiving elements located to correspond to the display region.

The circuit layer may include pixel drive circuits connected to the light emitting elements, sensor drive circuits connected to the light receiving elements, scan lines connected to the pixel drive circuits and extending in a first direction, and reset control lines connected to the sensor drive circuits and extending in the first direction.

Lengths of the sensor drive circuits in a second direction may be greater than lengths of the pixel drive circuits in the second direction. The scan lines may be arranged in units of one pixel row, the reset control lines may be arranged in units of p pixel rows, and p is greater than or equal to 2.

In one or more embodiments, the circuit layer further include reset voltage lines connected to the sensor drive circuits and extending in the first direction, and the reset voltage lines may be arranged in units of q pixel rows, and q is greater than or equal to 2.

In one or more embodiments, p is equal to q, and the reset voltage lines and the reset control lines may be alternately arranged.

In one or more embodiments, the scan lines may include: compensation scan lines; and initialization scan lines. A gap between the reset control lines in the second direction may be greater than a gap between the compensation scan lines in the second direction and a gap between the initialization scan lines in the second direction.

In one or more embodiments, the circuit layer may further include: a first gate pattern layer including a gate electrode; a second gate pattern layer on the first gate pattern layer, the second gate pattern layer including an upper gate electrode; an additional gate pattern layer on the second gate pattern layer, the additional gate pattern layer including first scan wirings and first reset control wirings; and a third gate pattern layer on the additional gate pattern layer, the third gate pattern layer including second scan wirings and second reset control wirings.

In one or more embodiments, the first scan wirings include: first compensation scan wirings; and first initialization scan wirings. The second scan wirings may include: second compensation scan wirings connected to the first compensation scan wirings, respectively; and second initialization scan wirings connected to the first initialization scan wirings, respectively. The compensation scan lines may include the first and second compensation scan wirings, respectively, and the initialization scan lines may include the first and second initialization scan wirings, respectively.

In one or more embodiments, the first reset control wirings may be connected to the second reset control wirings, respectively, and the reset control lines may include the first and second reset control wirings, respectively.

In one or more embodiments, the additional gate pattern layer may further include horizontal reset voltage wirings connected to the sensor drive circuits and extending in the first direction. The horizontal reset voltage wirings may be arranged in units of q pixel rows, and q is greater than or equal to 2. The first reset control wirings and the horizontal reset voltage wirings may be alternately arranged.

In one or more embodiments, the circuit layer may further include: a first gate pattern layer including a gate electrode; a second gate pattern layer on the first gate pattern layer, the second gate pattern layer including an upper gate electrode; a third gate pattern layer on the second gate pattern layer, the third gate pattern layer including first scan wirings and first reset control wirings; and an additional gate pattern layer on the third gate pattern layer, the additional gate pattern layer including second scan wirings and second reset control wirings.

In one or more embodiments, the first scan wirings may include: first compensation scan wirings; and first initialization scan wirings. The second scan wirings may include: second compensation scan wirings connected to the first compensation scan wirings, respectively; and second initialization scan wirings connected to the first initialization scan wirings, respectively. The compensation scan lines may be defined by the first and second compensation scan wirings, respectively, and the initialization scan lines may be defined by the first and second initialization scan wirings, respectively.

In one or more embodiments, the first reset control wirings may be connected to the second reset control wirings, respectively, and the reset control lines may be defined by the first and second reset control wirings, respectively.

In one or more embodiments, the additional gate pattern layer may further include horizontal reset voltage wirings connected to the sensor drive circuits and extending in the first direction. The horizontal reset voltage wirings may be arranged in units of q pixel rows, and q is greater than or equal to 2, and the first reset control wirings and the horizontal reset voltage wirings may be alternately arranged.

According to one or more embodiments, a display device includes a base layer having a display region and a non-display region, a circuit layer on the base layer, and an element layer on the circuit layer and that includes light emitting elements and light receiving elements located to correspond to the display region.

The circuit layer may include pixel drive circuits connected to the light emitting elements, sensor drive circuits connected to the light receiving elements, readout lines connected to the sensor drive circuits, first data lines connected to a first group of pixel drive circuits from among the pixel drive circuits, second data lines spaced (e.g., spaced apart) from the first data lines in a first direction and connected to a second group of pixel drive circuits from among the pixel drive circuits, data connecting lines electrically connected with the second data lines, respectively, in the display region, and shielding patterns located between the readout lines and the data connecting lines at points where the readout lines and the data connecting lines cross each other.

In one or more embodiments, the data connecting lines may include: a plurality of vertical connecting wirings extending along the first data lines; and a plurality of horizontal connecting wirings extending in the first direction and crossing the readout lines. The plurality of horizontal connecting wirings may electrically connect the plurality of vertical connecting wirings to the second data lines, and the shielding patterns may be located between the plurality of horizontal connecting wirings and the readout lines.

In one or more embodiments, the circuit layer may include: a first gate pattern layer including a gate electrode; a second gate pattern layer on the first gate pattern layer, the second gate pattern layer including first scan wirings, first reset control wirings, and an upper gate electrode; an additional gate pattern layer on the second gate pattern layer, the additional gate pattern layer including the horizontal connecting wirings; and a third gate pattern layer on the additional gate pattern layer, the third gate pattern layer including second scan wirings and second reset control wirings.

In one or more embodiments, the circuit layer may further include: a first data pattern layer on the third gate pattern layer, the first data pattern layer including the shielding patterns; a second data pattern layer on the first data pattern layer, the second data pattern layer including the readout lines; and a third data pattern layer on the second data pattern layer, the third data pattern layer including the plurality of vertical connecting wirings and the first and second data lines.

In one or more embodiments, the circuit layer may further include: a first data pattern layer on the third gate pattern layer; a second data pattern layer on the first data pattern layer, the second data pattern layer including the readout lines; and a third data pattern layer on the second data pattern layer, the third data pattern layer including the plurality of vertical connecting wirings and the first and second data lines. The shielding patterns may be included in the third gate pattern layer.

In one or more embodiments, the circuit layer may further include: a first gate pattern layer including a gate electrode; a second gate pattern layer on the first gate pattern layer, the second gate pattern layer including first scan wirings, first reset control wirings, and an upper gate electrode; a third gate pattern layer on the second gate pattern layer, the third gate pattern layer including second scan wirings and second reset control wirings; and an additional gate pattern layer on the third gate pattern layer, the additional gate pattern layer including the horizontal connecting wirings.

In one or more embodiments, the circuit layer may further include: a first data pattern layer on the third gate pattern layer, the first data pattern layer including the shielding patterns; a second data pattern layer on the first data pattern layer, the second data pattern layer including the readout lines; and a third data pattern layer on the second data pattern layer, the third data pattern layer including the plurality of vertical connecting wirings and the first and second data lines.

In one or more embodiments, the circuit layer may include: a first gate pattern layer including a gate electrode; a second gate pattern layer on the first gate pattern layer, the second gate pattern layer including first scan wirings, first reset control wirings, and an upper gate electrode; an additional gate pattern layer on the second gate pattern layer, the additional gate pattern layer including the readout lines; and a third gate pattern layer on the additional gate pattern layer, the third gate pattern layer including second scan wirings and second reset control wirings.

In one or more embodiments, the circuit layer may further include: a first data pattern layer on the third gate pattern layer, the first data pattern layer including the horizontal connecting wirings; a second data pattern layer on the first data pattern layer; and a third data pattern layer on the second data pattern layer, the third data pattern layer including the plurality of vertical connecting wirings and the first and second data lines. The shielding patterns may be included in the third gate pattern layer.

In one or more embodiments, the circuit layer may include: a first gate pattern layer including a gate electrode; a second gate pattern layer on the first gate pattern layer, the second gate pattern layer including first scan wirings, first reset control wirings, and an upper gate electrode; a third gate pattern layer on the second gate pattern layer, the third gate pattern layer including second scan wirings and second reset control wirings; and an additional gate pattern layer on the third gate pattern layer, the additional gate pattern layer including the readout lines.

In one or more embodiments, the circuit layer may further include: a first drive voltage line connected to the pixel drive circuits; a second drive voltage line connected to the light emitting elements and the light receiving elements; a reset voltage line connected to the sensor drive circuits; and an initialization voltage line connected to the pixel drive circuits.

### BRIEF DESCRIPTION OF THE DRAWINGS

The above and other aspects and features of the present disclosure will become apparent by describing in detail embodiments thereof with reference to the accompanying drawings.
FIG. 1 is a perspective view of a display device.
FIG. 2A is an exploded perspective view of the display device.
FIG. 2B is a sectional view of the display device.
FIG. 3 is a block diagram of the display device.
FIG. 4A is a circuit diagram illustrating a pixel and a sensor.
FIG. 4B is a waveform diagram for explaining operations of the pixel and the sensor illustrated in FIG. 4A.
FIG. 5A is a schematic plan view illustrating an arrangement of pixel drive circuits and sensor drive circuits.
FIG. 5B is a plan view illustrating an arrangement of light emitting elements and light receiving elements.
FIGS. 6A and 6B are sectional views of display panels.
FIG. 7 is a plan view of a display panel.
FIGS. 8A-8J are plan views illustrating a stacking process of a circuit layer.
FIGS. 9A and 9B are plan views illustrating a stacking process of the circuit layer.
FIG. 10 is a plan view illustrating an arrangement structure of reset control lines and reset voltage lines according to one or more embodiments.
FIGS. 11A-11E are plan views illustrating a stacking process of the circuit layer.
FIG. 12A is a sectional view taken along the line I-I' illustrated in FIG. 11D.
FIG. 12B is a sectional view of the display panel.
FIGS. 13A-13E are plan views illustrating a stacking process of the circuit layer.
FIG. 14 is a sectional view taken along the line II-II' illustrated in FIG. 13D.
FIGS. 15A and 15B are sectional views illustrating light emitting elements and a light receiving element of the display panel.

### DETAILED DESCRIPTION

In this specification, when it is mentioned that a component (or, a region, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components are exaggerated for effective description. As used herein, the term "and/or" includes all of one or more combinations defined by related components. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B," "at least one of A or B," or "at least one of A and/or B" may be understood to mean "A, B, or A and B."

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments of the present disclosure will be described with reference to the accompanying drawings.

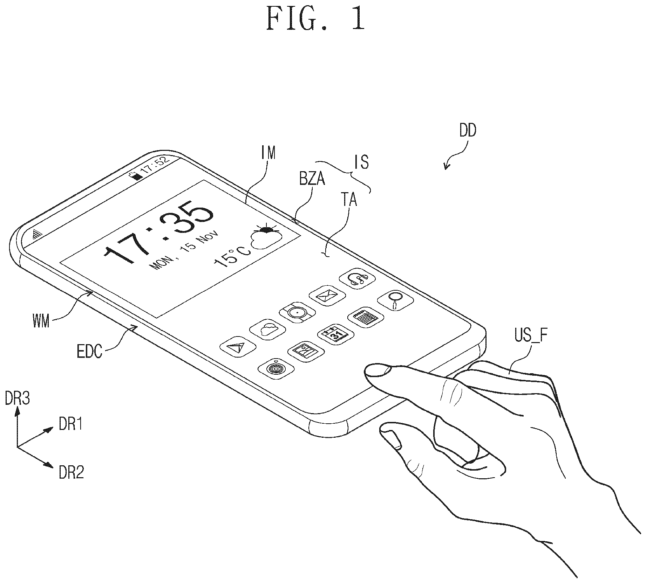

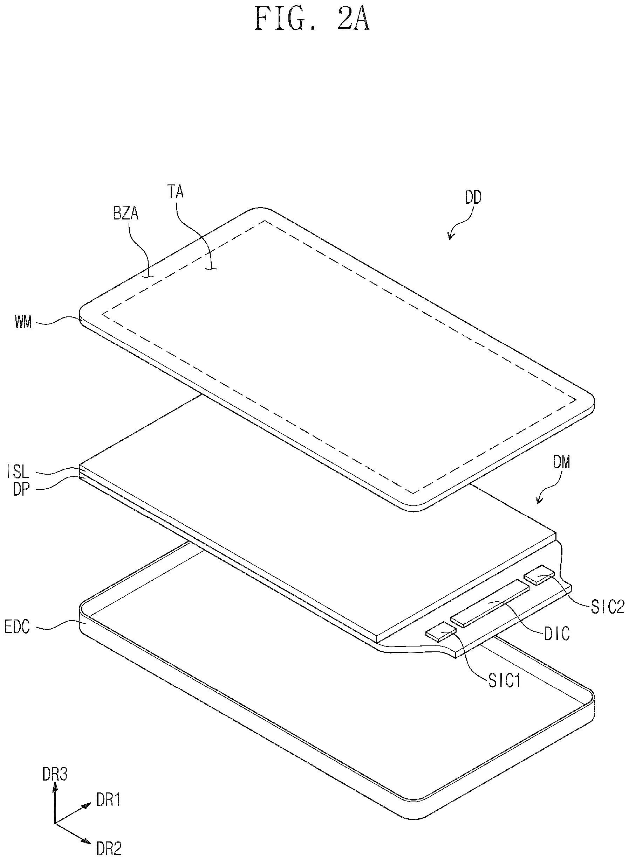

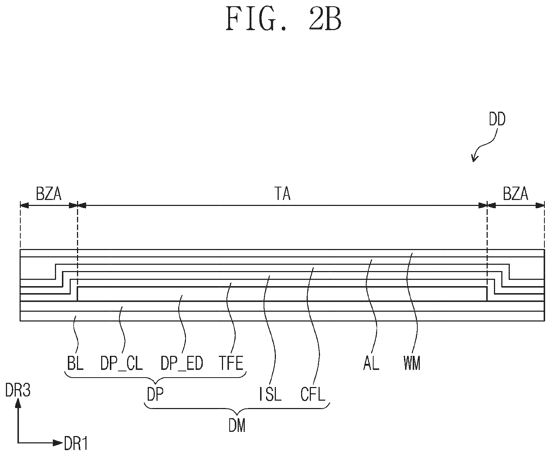

FIG. 1 is a perspective view of a display device. FIG. 2A is an exploded perspective view of the display device. FIG. 2B is a sectional view of the display device.

Referring to FIGS. 1, 2A, and 2B, the display device DD may have a rectangular shape with short sides parallel to a first direction DR1 and long sides parallel to a second direction DR2 crossing the first direction DR1. However, without being limited thereto, the display device DD may have various suitable shapes such as a circular shape, a polygonal shape, and/or the like.

The display device DD may be a device activated depending on an electrical signal. The display device DD may include various suitable embodiments. For example, the display device DD may be applied to an electronic device such as a smart watch, a tablet computer, a notebook computer, a computer, a smart television, and/or the like.

Hereinafter, a normal direction substantially perpendicular to a plane defined by the first direction DR1 and the second direction DR2 is defined as a third direction DR3. The expression "when viewed from above the plane" used herein may mean that it is viewed in the third direction DR3 (e.g., in a plan view).

The upper surface of the display device DD may be defined as a display surface IS and may be parallel to the plane defined by the first direction DR1 and the second direction DR2. Images IM generated by the display device DD may be provided to a user through the display surface IS. The third direction DR3 may also be referred to as a thickness direction of the display device DD and/or a direction normal to the display surface IS (or a display area) of the display device DD.

The display surface IS may be divided into a transmissive region TA and a bezel region BZA. The transmissive region TA may be a region on which the images IM are displayed. The user visually recognizes the images IM through the transmissive region TA. In FIG. 1, the transmissive region TA is illustrated in a rounded quadrangular shape. However, this is illustrative, and the transmissive region TA may have various suitable shapes and is not limited.

The bezel region BZA is adjacent to the transmissive region TA. The bezel region BZA may have a certain color. The bezel region BZA may be around (e.g., may surround) the transmissive region TA. Accordingly, the shape of the transmissive region TA may be substantially defined by the bezel region BZA. However, this is illustrative, and the bezel region BZA may be disposed adjacent to only one side, only two sides, or only three sides of the transmissive region TA, or may be omitted.

The display device DD may sense an external input applied from the outside. The external input may include various suitable types of inputs provided from outside the display device DD. For example, the external input may include not only contact by a part of the user's body (e.g., a hand US_F of the user) or contact by a separate device (e.g., an active pen and/or a digitizer) but also an external input (e.g., hovering) that is applied in proximity to the display device DD or applied adjacent to the display device DD at a certain distance. In addition, the external input may have various suitable forms such as force, pressure, temperature, light, and/or the like.

The display device DD may sense the user's biometric information applied from the outside. A biometric information sensing region capable of sensing the user's biometric information may be provided on the display surface IS of the display device DD. The biometric information sensing region may be provided in the entire area of the transmissive region TA, or may be provided in a partial area of the transmissive region TA. FIG. 1 illustrates an example that the entire transmissive region TA is used as the biometric information sensing region. However, the present disclosure is not limited thereto.

The display device DD may include a window WM, a display module DM, and a housing EDC. In the described example, the window WM and the housing EDC are combined with each other to form the exterior of the display device DD.

The front surface of the window WM defines the display surface IS of the display device DD. The window WM may include an optically clear insulating material. For example, the window WM may include glass or plastic. The window WM may have a multi-layer structure or a single-layer structure. For example, the window WM may include a plurality of plastic films coupled through an adhesive, or may include a glass substrate and a plastic film coupled through an adhesive.

The display module DM may include a display panel DP and an input sensing layer ISL. The display panel DP may display an image depending on an electrical signal, and the input sensing layer ISL may sense an external input applied from the outside. The external input may be provided in various suitable forms.

The display panel DP may be an emissive display panel, but is not particularly limited thereto. For example, the display panel DP may be an organic light emitting display panel, an inorganic light emitting display panel, or a quantum-dot light emitting display panel. A light emitting layer of the organic light emitting display panel may include an organic luminescent material, and a light emitting layer of the inorganic light emitting display panel may include an inorganic luminescent material. A light emitting layer of the quantum-dot light emitting display panel may include quantum dots and quantum rods. Hereinafter, the display panel DP will be described primarily as an organic light emitting display panel. However, it is not limited thereto.

Referring to FIG. 2B, the display panel DP includes a base layer BL, a circuit layer DP_CL, an element layer DP_ED, and an encapsulation layer TFE. The display panel DP may be a flexible display panel. However, it is not limited thereto. For example, the display panel DP may be a foldable display panel that is folded about a folding axis, or may be a rigid display panel.

The base layer BL may include a synthetic resin layer. The synthetic resin layer may be a polyimide-based resin layer, and the material thereof is not particularly limited thereto. In addition, the base layer BL may include a glass substrate, a metal substrate, and/or an organic/inorganic composite substrate.

The circuit layer DP_CL is disposed on the base layer BL. The circuit layer DP_CL is disposed between the base layer BL and the element layer DP_ED. The circuit layer DP_CL includes at least one insulating layer and a circuit element. Hereinafter, the insulating layer included in the circuit layer DP_CL is referred to as the intermediate insulating layer. The intermediate insulating layer includes at least one intermediate inorganic film and at least one intermediate organic film. The circuit element may include a pixel drive circuit included in each of a plurality of pixels for displaying an image and a sensor drive circuit included in each of a plurality of sensors for recognizing external information. The external information may be biometric information. The sensor may be a fingerprint recognition sensor, a proximity sensor, an iris recognition sensor, a blood pressure measurement sensor, an illuminance sensor, and/or the like. Alternatively, the sensor may be an optical sensor for optically recognizing biometric information. The circuit layer DP_CL may further include signal lines connected to the pixel drive circuit and/or the sensor drive circuit.

The element layer DP_ED may include a light emitting element included in each of the pixels and a light receiving element included in each of the sensors. The light receiving element may be a photo diode. The light receiving element may be a sensor that senses, or reacts to, light reflected by a fingerprint of the user.

The encapsulation layer TFE seals the element layer DP_ED. The encapsulation layer TFE may include at least one organic film and at least one inorganic film. The inorganic film may include an inorganic material and may protect the element layer DP_ED from moisture/oxygen. The inorganic film may include a silicon nitride layer, a silicon oxy nitride layer, a silicon oxide layer, a titanium oxide layer, and/or an aluminum oxide layer, but is not particularly limited thereto. The organic film may include an organic material and may protect the element layer DP_ED from foreign matter such as dust particles.

The input sensing layer ISL may be formed on the display panel DP. The input sensing layer ISL may be directly disposed on the encapsulation layer TFE. The input sensing layer ISL may be formed on the display panel DP by a continuous process. That is, when the input sensing layer ISL is directly disposed on the display panel DP, an adhesive film is not disposed between the input sensing layer ISL and the encapsulation layer TFE. Alternatively, an adhesive film may be disposed between the input sensing layer ISL and the display panel DP. In this case, the input sensing layer ISL may not be manufactured together with the display panel DP by a continuous process and may be manufactured separately from the display panel DP and then fixed to the upper surface of the display panel DP by the adhesive film.

The input sensing layer ISL may sense an external input (e.g., a touch of the user), may change the sensed external input into a certain input signal, and may provide the input signal to the display panel DP. The input sensing layer ISL may include a plurality of sensing electrodes for sensing the external input. The sensing electrodes may sense the external input in a capacitive type. The display panel DP may receive the input signal from the input sensing layer ISL and may generate an image corresponding to the input signal.

The display module DM may further include a color filter layer CFL. The color filter layer CFL may be disposed on the input sensing layer ISL. However, it is not limited thereto. The color filter layer CFL may be disposed between the display panel DP and the input sensing layer ISL. The color filter layer CFL may include a plurality of color filters and a black matrix.

The structures of the input sensing layer ISL and the color filter layer CFL will be described below in detail.

The display device DD may further include an adhesive layer AL. As shown in FIG. 2B, the window WM may be attached to the color filter layer CFL by the adhesive layer AL. The adhesive layer AL may include an optically clear adhesive, an optically clear adhesive resin, and/or a pressure sensitive adhesive (PSA). In examples in which the color filter layer CFL is disposed between the display panel DP and the input sensing layer ISL, the window WM may be attached to the input sensing layer ISL by the adhesive layer AL.

Referring back to FIG. 2A, the display module DM may further include a driver chip DIC and sensor chips SIC1 and SIC2. The driver chip DIC and the sensor chips SIC1 and SIC2 may be mounted on the display panel DP. The driver chip DIC and the sensor chips SIC1 and SIC2 may be disposed adjacent to one end portion (hereinafter, referred to as the first end portion) of the display panel DP. Although FIG. 2A illustrates a structure in which the driver chip DIC and the sensor chips SIC1 and SIC2 are disposed adjacent to the first end portion of the display panel DP, the it is not limited thereto. For example, the driver chip DIC may be disposed adjacent to the first end portion of the display panel DP, and the sensor chips SIC1 and SIC2 may be disposed adjacent to a second end portion of the display panel DP that is at an opposite end of the display panel DP from the first end portion.

The sensor chips SIC1 and SIC2 may include the first sensor chip SIC1 disposed on one side (hereinafter, referred to as the first side) of the driver chip DIC and the second sensor chip SIC2 disposed on a second side (or another side) of the driver chip DIC that differs from the first side. However, alternatively, the first and second sensor chips SIC1 and SIC2 may be integrated into one sensor chip, and the one sensor chip may be disposed adjacent to the driver chip DIC. The number of sensor chips SIC1 and SIC2 and the number of driver chips DIC are not particularly limited thereto.

The housing EDC is combined with the window WM. The housing EDC provides a certain inner space by being combined with the window WM. The display module DM may be accommodated in the inner space. The housing EDC may include a material having a relatively high rigidity. For example, the housing EDC may include glass, plastic, and/or metal, and/or may include a plurality of frames and/or plates formed of a combination thereof. The housing EDC may stably protect components of the display device DD accommodated in the inner space from external impact. A battery module for supplying power used for overall operation of the display device DD may be disposed between the display module DM and the housing EDC.

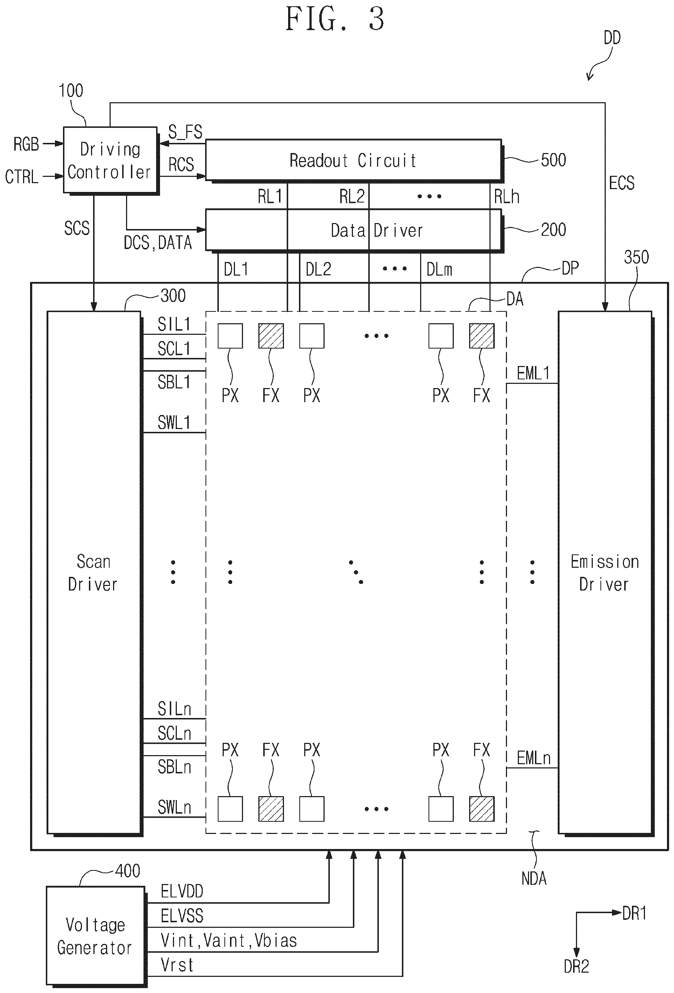

FIG. 3 is a block diagram of the display device.

Referring to FIG. 3, the display device DD includes the display panel DP, a panel driver, and a driving controller 100. The panel driver includes a data driver 200, a scan driver 300, an emission driver 350, a voltage generator 400, and a readout circuit 500.

The driving controller 100 receives an image signal RGB and a control signal CTRL. The driving controller 100 generates image data DATA by converting the data format of the image signal RGB according to the specification of an interface with the data driver 200. The driving controller 100 outputs a first control signal SCS, a second control signal ECS, a third control signal DCS, and a fourth control signal RCS.

The data driver 200 receives the third control signal DCS and the image data DATA from the driving controller 100. The data driver 200 converts the image data DATA into data signals and outputs the data signals to a plurality of data lines DL1 to DLm that will be described below. The data signals are analog voltages corresponding to gray level values of the image data DATA. The data driver 200 may be embedded in the driver chip DIC illustrated in FIG. 2A.

The scan driver 300 receives the first control signal SCS from the driving controller 100. The scan driver 300 may output scan signals to scan lines in response to the first control signal SCS.

The voltage generator 400 generates voltages used for operation of the display panel DP. In the described embodiment, the voltage generator 400 generates a first drive voltage ELVDD, a second drive voltage ELVSS, a first initialization voltage Vint, a second initialization voltage Vaint, a bias voltage Vbias, and a reset voltage Vrst.

The display panel DP may include a display region DA corresponding to the transmissive region TA (e.g., illustrated in FIG. 1) and a non-display region NDA corresponding to the bezel region BZA (e.g., illustrated in FIG. 1).

The display panel DP may include a plurality of pixels PX disposed in the display region DA and a plurality of sensors FX disposed in the display region DA. Each of the plurality of sensors FX may be disposed between two pixels PX adjacent to each other. The plurality of pixels PX and the plurality of sensors FX may be alternately arranged in the first and second directions DR1 and DR2. However, the arrangement is not limited thereto. That is, two or more pixels PX may be disposed between two sensors FX adjacent to each other in the first direction DR1 from among the plurality of sensors FX, or two or more pixels PX may be disposed between two sensors FX adjacent to each other in the second direction DR2 from among the plurality of sensors FX.

The display panel DP further includes initialization scan lines SIL1 to SILn, compensation scan lines SCL1 to SCLn, write scan lines SWL1 to SWLn, black scan lines SBL1 to SBLn, emission control lines EML1 to EMLn, the data lines DL1 to DLm, and readout lines RL1 to RLh. The initialization scan lines SIL1 to SILn, the compensation scan lines SCL1 to SCLn, the write scan lines SWL1 to SWLn, the black scan lines SBL1 to SBLn, and the emission control lines EML1 to EMLn extend in the first direction DR1. The initialization scan lines SIL1 to SILn, the compensation scan lines SCL1 to SCLn, the write scan lines SWL1 to SWLn, the black scan lines SBL1 to SBLn, and the emission control lines EML1 to EMLn are arranged along the second direction DR2 and are spaced (e.g., spaced apart) from each other. The data lines DL1 to DLm and the readout lines RL1 to RLh extend in the second direction DR2, are arranged along the first direction DR1 and are spaced (e.g., spaced apart) from each other. Here, "n", "m", and "h" are natural numbers of 1 or greater.

The plurality of pixels PX is electrically connected to the initialization scan lines SIL1 to SILn, the compensation scan lines SCL1 to SCLn, the write scan lines SWL1 to SWLn, the black scan lines SBL1 to SBLn, the emission control lines EML1 to EMLn, and the data lines DL1 to DLm, respectively. For example, each of the plurality of pixels PX may be electrically connected to four scan lines. However, without being limited thereto, the number of scan lines connected to each pixel PX may be changed (e.g., may be different in other examples).

The plurality of sensors FX is electrically connected to the write scan lines SWL1 to SWLn and the readout lines RL1 to RLh, respectively. Each of the plurality of sensors FX may be electrically connected to one scan line. However, the present disclosure is not limited thereto. The number of scan lines connected to each sensor FX may be varied. The number of readout lines RL1 to RLh may be less than or equal to the number of data lines DL1 to DLm. For example, the number of readout lines RL1 to RLh may correspond to 1/2, 1/4, or 1/8 of the number of data lines DL1 to DLm.

The scan driver 300 may be disposed in the non-display region NDA of the display panel DP. The scan driver 300 receives the first control signal SCS from the driving controller 100. In response to the first control signal SCS, the scan driver 300 outputs initialization scan signals to the initialization scan lines SIL1 to SILn and outputs compensation scan signals to the compensation scan lines SCL1 to SCLn. Furthermore, in response to the first control signal SCS, the scan driver 300 may output write scan signals to the write scan lines SWL1 to SWLn and may output black scan signals to the black scan lines SBL1 to SBLn. Alternatively, the scan driver 300 may include first and second scan drivers. The first scan driver may output the initialization scan signals and the compensation scan signals, and the second scan driver may output the write scan signals and the black scan signals. However, the present disclosure is not limited thereto.

The emission driver 350 may be disposed in the non-display region NDA of the display panel DP. The emission driver 350 receives the second control signal ECS from the driving controller 100. The emission driver 350 may output emission control signals to the emission control lines EML1 to EMLn in response to the second control signal ECS. Alternatively, the scan driver 300 may be connected to the emission control lines EML1 to EMLn. In this case, the emission driver 350 may be omitted, and the scan driver 300 may output the emission control signals to the emission control lines EML1 to EMLn. While the emission driver 350 in FIG. 3 is shown as being located at an opposite side of the display region DA from the scan driver 300, the emission driver 350 may be located at the same side of the display region DA as the scan driver 300.

The readout circuit 500 receives the fourth control signal RCS from the driving controller 100. In response to the fourth control signal RCS, the readout circuit 500 may receive detection signals from the readout lines RL1 to RLh. The readout circuit 500 may process the detection signals received from the readout lines RL1 to RLh and may provide processed detection signals S_FS to the driving controller 100. The driving controller 100 may recognize biometric information based on the processed detection signals S_FS. The readout circuit 500 may be embedded in the sensor chips SIC1 and SIC2 illustrated in FIG. 2A.

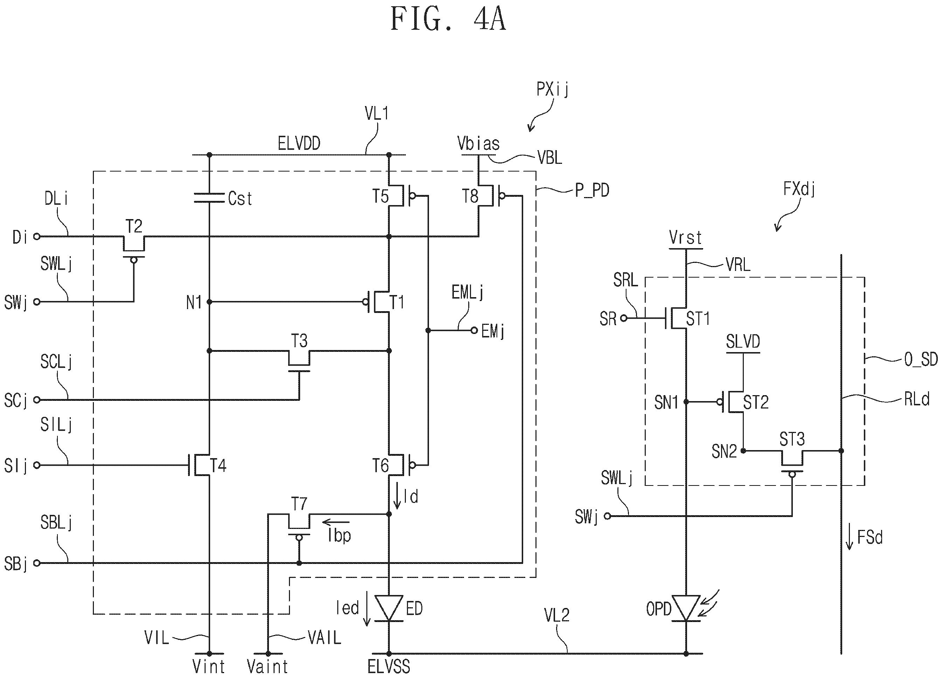

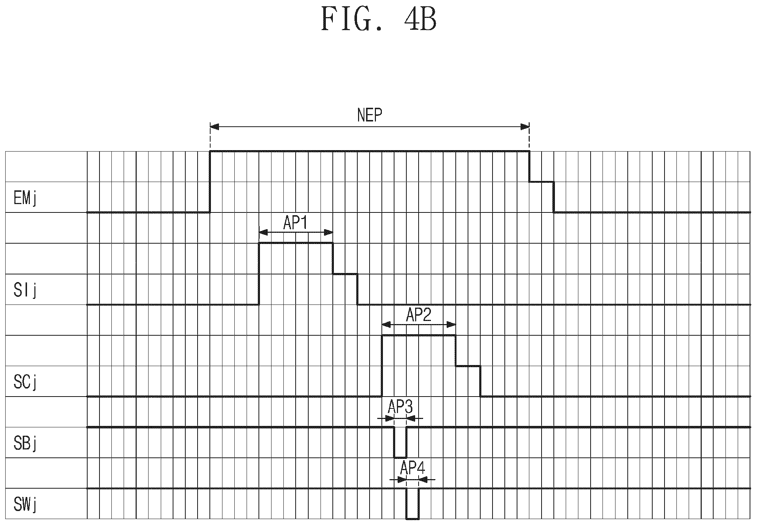

FIG. 4A is a circuit diagram illustrating a pixel and a sensor, and FIG. 4B is a waveform diagram for explaining operations of the pixel and the sensor illustrated in FIG. 4A.

In FIG. 4A, an equivalent circuit diagram of one pixel PXij from among the plurality of pixels PX illustrated in FIG. 3 is illustrated. Because each of the plurality of pixels PX has the same or substantially the same circuit structure, description of the circuit structure of the pixel PXij may be applied to the remaining pixels, and detailed description of the remaining pixels will be omitted. Furthermore, in FIG. 4A, an equivalent circuit diagram of one sensor FXdj from among the plurality of sensors FX illustrated in FIG. 3 is illustrated. Because each of the plurality of sensors FX has the same or substantially the same circuit structure, description of the circuit structure of the sensor FXdj may be applied to the remaining sensors, and detailed description of the remaining sensors will be omitted.

Referring to FIG. 4A, the pixel PXij is connected to an i-th data line DLi from among the data lines DL1 to DLm, a j-th initialization scan line SILj from among the initialization scan lines SIL1 to SILn, a j-th compensation scan line SCLj from among the compensation scan lines SCL1 to SCLn, a j-th write scan line SWLj from among the write scan lines SWL1 to SWLn, a j-th black scan line SBLj from among the black scan lines SBL1 to SBLn, and a j-th emission control line EMLj from among the emission control lines EML1 to EMLn. Here, i is a natural number greater than or equal to 1 and less than or equal to m, and j is a natural number greater than or equal to 1 and less than or equal to n.

The pixel PXij includes a light emitting element ED and a pixel drive circuit P_PD. The light emitting element ED may be a light emitting diode. The light emitting element ED may be an organic light emitting diode including an organic light emitting layer.

The pixel drive circuit P_PD includes first to eighth transistors T1, T2, T3, T4, T5, T6, T7, and T8 and one capacitor Cst. At least one of the first to eighth transistors T1 to T8 may be a transistor having a low-temperature polycrystalline silicon (LTPS) semiconductor layer. Some of the first to eighth transistors T1 to T8 may be P-type transistors, and the others may be N-type transistors. At least one of the first to eighth transistors T1 to T8 may be a transistor having an oxide semiconductor layer. For example, the third and fourth transistors T3 and T4 may be oxide semiconductor transistors, and the first, second, and fifth to eighth transistors T1, T2, and T5 to T8 may be LTPS transistors. The third and fourth transistors T3 and T4 may be NMOS transistors. Alternatively, the first to fourth transistors T1 to T4 and the seventh and eighth transistors T7 and T8 may be oxide semiconductor transistors, and the fifth and sixth transistors T5 and T6 may be LTPS transistors.

The configuration of the pixel drive circuit P_PD is not limited to that illustrated in FIG. 4A. The pixel drive circuit P_PD illustrated in FIG. 4A is merely an example, and various suitable changes and modifications may be made to the configuration of the pixel drive circuit P_PD as a person having ordinary skill in the art would appreciate. For example, the first, second, and fifth to eighth transistors T1, T2, and T5 to T8 may all be P-type transistors or N-type transistors.

The j-th initialization scan line SILj, the j-th compensation scan line SCLj, the j-th write scan line SWLj, the j-th black scan line SBLj, and the j-th emission control line EMLj may transfer a j-th initialization scan signal SIj, a j-th compensation scan signal SCj, a j-th write scan signal SWj, a j-th black scan signal SBj, and a j-th emission control signal EMj, respectively, to the pixel PXij. The i-th data line DLi transfers an i-th data signal Di to the pixel PXij. The i-th data signal Di may have a voltage level corresponding to the image signal RGB (e.g., refer to FIG. 3) that is input to the display device DD (e.g., refer to FIG. 3).

The pixel PXij may be connected to first and second drive voltage lines VL1 and VL2, first and second initialization voltage lines VIL and VAIL, and a bias voltage line VBL. The first drive voltage line VL1 may transfer the first drive voltage ELVDD to the pixel PXij, and the second drive voltage line VL2 may transfer the second drive voltage ELVSS to the pixel PXij. In addition, the first initialization voltage line VIL may transfer the first initialization voltage Vint to the pixel PXij, and the second initialization voltage line VAIL may transfer the second initialization voltage Vaint to the pixel PXij. The bias voltage line VBL may transfer the bias voltage Vbias to the pixel PXij.

The first transistor T1 is connected between the first drive voltage line VL1, which receives the first drive voltage ELVDD, and the light emitting element ED. The first transistor T1 includes a first electrode connected with the first drive voltage line VL1 via the fifth transistor T5, a second electrode connected with an anode electrode of the light emitting element ED via the sixth transistor T6, and a third electrode (e.g., a gate electrode) connected with one end of the capacitor Cst (e.g., a first node N1). The first transistor T1 may receive the i-th data signal Di that the i-th data line DLi transfers depending on a switching operation of the second transistor T2 and may supply a drive current Id to the light emitting element ED.

The second transistor T2 is connected between the i-th data line DLi and the first electrode of the first transistor T1. The second transistor T2 includes a first electrode connected with the i-th data line DLi, a second electrode connected with the first electrode of the first transistor T1, and a third electrode (e.g., a gate electrode) connected with the j-th write scan line SWLj. The second transistor T2 may be turned on depending on the j-th write scan signal SWj transferred through the j-th write scan line SWLj and may transfer, to the first electrode of the first transistor T1, the i-th data signal Di transferred from the i-th data line DLi.

The third transistor T3 is connected between the second electrode of the first transistor T1 and the first node N1. The third transistor T3 includes a first electrode connected with the third electrode of the first transistor T1, a second electrode connected with the second electrode of the first transistor T1, and a third electrode (e.g., a gate electrode) connected with the j-th compensation scan line SCLj. The third transistor T3 may be turned on depending on the j-th compensation scan signal SCj transferred through the j-th compensation scan line SCLj and may diode-connect the first transistor T1 by connecting the third electrode and the second electrode of the first transistor T1.

The fourth transistor T4 is connected between the first initialization voltage line VIL, to which the first initialization voltage Vint is applied, and the first node N1. The fourth transistor T4 includes a first electrode connected with the first initialization voltage line VIL to which the first initialization voltage Vint is transferred, a second electrode connected with the first node N1, and a third electrode (e.g., a gate electrode) connected with the j-th initialization scan line SILj. The fourth transistor T4 is turned on depending on the j-th initialization scan signal SIj transferred through the j-th initialization scan line SILj. The turned-on fourth transistor T4 initializes the potential of the third electrode of the first transistor T1 (that is, the potential of the first node N1) by transferring the first initialization voltage Vint to the first node N1.

The fifth transistor T5 includes a first electrode connected with the first drive voltage line VL1, a second electrode connected with the first electrode of the first transistor T1, and a third electrode (e.g., a gate electrode) connected to the j-th emission control line EMLj.

The sixth transistor T6 includes a first electrode connected with the second electrode of the first transistor T1, a second electrode connected to the anode electrode of the light emitting element ED, and a third electrode (e.g., a gate electrode) connected to the j-th emission control line EMLj.

The fifth and sixth transistors T5 and T6 are concurrently (e.g., simultaneously) turned on depending on the j-th emission control signal EMj transferred through the j-th emission control line EMLj. The first drive voltage ELVDD applied through the turned-on fifth transistor T5 may be compensated for through the diode-connected first transistor T1 and thereafter may be transferred to the light emitting element ED.

The seventh transistor T7 includes a first electrode connected to the second initialization voltage line VAIL to which the second initialization voltage Vaint is transferred, a second electrode connected with the second electrode of the sixth transistor T6, and a third electrode (e.g., a gate electrode) connected with the j-th black scan line SBLj. The second initialization voltage Vaint may have a voltage level lower than or equal to the voltage level of the first initialization voltage Vint.

The eighth transistor T8 includes a first electrode connected to the bias voltage line VBL to which the bias voltage Vbias is transferred, a second electrode connected with the first electrode of the first transistor T1, and a third electrode (e.g., a gate electrode) connected with the j-th black scan line SBLj.

The seventh and eighth transistors T7 and T8 are concurrently (e.g., simultaneously) turned on depending on the j-th black scan signal SBj transferred through the j-th black scan line SBLj. The second initialization voltage Vaint applied through the turned-on seventh transistor T7 may be transferred to the anode electrode of the light emitting element ED. Accordingly, the anode electrode of the light emitting element ED may be initialized to the second initialization voltage Vaint. The bias voltage Vbias applied through the turned-on eighth transistor T8 may be transferred to the first electrode of the first transistor T1. Accordingly, the bias voltage Vbias may be periodically applied to the first electrode of the first transistor T1. As a result, deterioration in display quality due to an increase in the potential difference between the first and second electrodes of the first transistor T1 to a certain level or higher by a magnetic hysteresis phenomenon may be prevented or reduced.

The one end of the capacitor Cst is connected with the third electrode of the first transistor T1 as described above, and the opposite end of the capacitor Cst is connected with the first drive voltage line VL1. A cathode electrode of the light emitting element ED may be connected with the second drive voltage line VL2 that transfers the second drive voltage ELVSS. The second drive voltage ELVSS may have a lower voltage level than the first drive voltage ELVDD. The second drive voltage ELVSS may have a lower voltage level than the first and second initialization voltages Vint and Vaint.

Referring to FIGS. 4A and 4B, the j-th emission control signal EMj has a high level during a non-light emission period NEP. Within the non-light emission period NEP, the j-th initialization scan signal SIj is activated. When the j-th initialization scan signal SIj having a high level is provided through the j-th initialization scan line SILj during an activation period AP1 (hereinafter, referred to as a first activation period) of the j-th initialization scan signal SIj, the fourth transistor T4 is turned on in response to the j-th initialization scan signal SIj having the high level. The first initialization voltage Vint is transferred to the third electrode of the first transistor T1 through the turned-on fourth transistor T4, and the first node N1 is initialized to the first initialization voltage Vint. Accordingly, the first activation period AP1 may be defined as an initialization period of the pixel PXij.

Next, when the j-th compensation scan signal SCj is activated and the j-th compensation scan signal SCj having a high level is supplied through the j-th compensation scan line SCLj during an activation period AP2 (hereinafter, referred to as a second activation period) of the j-th compensation scan signal SCj, the third transistor T3 is turned on. The first transistor T1 is diode-connected by the turned-on third transistor T3 and forward-biased. The first activation period AP1 may not overlap the second activation period AP2.

Within the second activation period AP2, the j-th write scan signal SWj is activated. The j-th write scan signal SWj has a low level during an activation period AP4 (hereinafter, referred to as a fourth activation period). During the fourth activation period AP4, the second transistor T2 is turned on by the j-th write scan signal SWj having the low level. Then, a compensation voltage "Di-Vth" obtained by subtracting the threshold voltage Vth of the first transistor T1 from the i-th data signal Di supplied from the i-th data line DLi is applied to the third electrode of the first transistor T1. That is, the potential of the third electrode of the first transistor T1 may be the compensation voltage "Di-Vth". The fourth activation period AP4 may overlap the second activation period AP2. The duration time of the second activation period AP2 may be greater than the duration time of the fourth activation period AP4.

The first drive voltage ELVDD and the compensation voltage "Di-Vth" may be applied to the opposite ends of the capacitor Cst, and charges corresponding to a difference between voltages at the opposite ends of the capacitor Cst may be stored in the capacitor Cst. Here, the period during which the j-th compensation scan signal SCj has the high level may be referred to as the compensation period of the pixel PXij.

Meanwhile, the j-th black scan signal SBj is activated within the second activation period AP2 of the j-th compensation scan signal SCj. The j-th black scan signal SBj has a low level during an activation period AP3 (hereinafter, referred to as a third activation period). During the third activation period AP3, the seventh transistor T7 is turned on by receiving the j-th black scan signal SBj having the low level through the j-th black scan line SBLj. A portion of the drive current Id may escape through the seventh transistor T7 as a bypass current Ibp. The third activation period AP3 may overlap the second activation period AP2. The duration time of the second activation period AP2 may be greater than the duration time of the third activation period AP3. The third activation period AP3 may precede the fourth activation period AP4 and may not overlap the fourth activation period AP4.

When the pixel PXij displays a black image, the pixel PXij is not able to normally display the black image if the light emitting element ED emits light even though the minimum drive current of the first transistor T1 flows as the drive current Id. Accordingly, the seventh transistor T7 in the pixel PXij may distribute a portion of the minimum drive current of the first transistor T1 as the bypass current Ibp to a current path other than the current path toward the light emitting element ED. Here, the minimum drive current of the first transistor T1 means a current flowing to the first transistor T1 under the condition that a gate-source voltage Vgs of the first transistor T1 is lower than the threshold voltage Vth so that the first transistor T1 is turned off. The minimum drive current (e.g., a current of about 10 pA or less) flowing to the first transistor T1 under the condition that the first transistor T1 is turned off is transferred to the light emitting element ED, and a black gray-scale (i.e., a black gray level) image is displayed. When the pixel PXij displays the black image, an influence of the bypass current Ibp on the minimum drive current is relatively great, whereas when the pixel PXij displays an image such as a general image or a white image, the bypass current Ibp has little influence on the drive current Id. Accordingly, when the pixel PXij displays the black image, the current obtained by subtracting the bypass current Ibp escaping through the seventh transistor T7 from the drive current Id (that is, a light emission current Ied) may be provided to the light emitting element ED so that the pixel PXij clearly expresses the black image. Thus, the pixel PXij may implement an accurate black gray-scale (i.e., a black gray level) image using the seventh transistor T7, thereby improving the contrast ratio.

After that, the j-th emission control signal EMj supplied from the j-th emission control line EMLj is changed from the high level to a low level. The fifth and sixth transistors T5 and T6 are turned on by the emission control signal EMj having the low level. Then, the drive current Id depending on the difference between the voltage of the third electrode of the first transistor T1 and the first drive voltage ELVDD is generated. The drive current Id is supplied to the light emitting element ED through the sixth transistor T6, and the light emission current led flows through the light emitting element ED.

Referring again to FIG. 4A, the sensor FXdj is connected to the d-th readout line RLd from among the readout lines RL1 to RLh, the j-th write scan line SWLj, and a reset control line SRL. Here, d is a natural number greater than or equal to 1 and less than or equal to h.

The sensor FXdj includes a light receiving element OPD and a sensor drive circuit O_SD. The light receiving element OPD may be an organic photo diode including an organic material as a photoelectric conversion layer. Although FIG. 4A illustrates a structure in which the sensor FXdj includes one light receiving element OPD, the present disclosure is not limited thereto. For example, the sensor FXdj may include a plurality of light receiving elements OPD connected in parallel.

An anode electrode of the light receiving element OPD may be connected to a first sensing node SN1, and a cathode electrode of the light receiving element OPD may be connected with the second drive voltage line VL2 that transfers the second drive voltage ELVSS. The cathode electrode of the light receiving element OPD may be electrically connected with the cathode electrode of the light emitting element ED. The cathode electrode of the light receiving element OPD may be integrally formed with the cathode electrode of the light emitting element ED to form a common cathode electrode.

The sensor drive circuit O_SD includes three transistors ST1, ST2, and ST3. The three transistors ST1, ST2, and ST3 may be the reset transistor ST1, the amplifying transistor ST2, and the output transistor ST3, respectively. At least one of the reset transistor ST1, the amplifying transistor ST2, or the output transistor ST3 may be an oxide semiconductor transistor. The reset transistor ST1 may be an oxide semiconductor transistor, and the amplifying transistor ST2 and the output transistor ST3 may be LTPS transistors. However, without being limited thereto, at least the reset transistor ST1 and the output transistor ST3 may be oxide semiconductor transistors, and the amplifying transistor ST2 may be an LTPS transistor.

Furthermore, some of the reset transistor ST1, the amplifying transistor ST2, and the output transistor ST3 may be P-type transistors, and the rest may be an N-type transistor. The amplifying transistor ST2 and the output transistor ST3 may be PMOS transistors, and the reset transistor ST1 may be an NMOS transistor. However, without being limited thereto, the reset transistor ST1, the amplifying transistor ST2, and the output transistor ST3 may all be N-type transistors or P-type transistors.

Some (e.g., the reset transistor ST1) of the reset transistor ST1, the amplifying transistor ST2, and the output transistor ST3 may be transistors of the same type as the third and fourth transistors T3 and T4 of the pixel PXij. The amplifying transistor ST2 and the output transistor ST3 may be transistors of the same type as the first, second, and fifth to eighth transistors T1, T2, and T5 to T8 of the pixel PXij.

The circuit configuration of the sensor drive circuit O_SD according to the present disclosure is not limited to that illustrated in FIG. 4A. The sensor drive circuit O_SD illustrated in FIG. 4A is merely illustrative, and various suitable changes and modifications may be made to the configuration of the sensor drive circuit O_SD as a person having ordinary skill in the art would appreciate.

The reset transistor ST1 includes a first electrode that receives the reset voltage Vrst, a second electrode connected with the first sensing node SN1, and a third electrode that receives a reset control signal SR. The reset transistor ST1 may reset the potential of the first sensing node SN1 to the reset voltage Vrst in response to the reset control signal SR. The reset control signal SR may be a signal provided through the reset control line SRL. However, the present disclosure is not limited thereto. Alternatively, the reset control signal SR may be the j-th compensation scan signal SCj supplied through the j-th compensation scan line SCLj. That is, the reset transistor ST1 may receive the j-th compensation scan signal SCj, which is supplied from the j-th compensation scan line SCLj, as the reset control signal SR. The reset voltage Vrst may have a lower voltage level than the second drive voltage ELVSS at least during an activation period of the reset control signal SR. The reset voltage Vrst may be transferred to the sensor FXdj through a reset voltage line VRL. The reset voltage Vrst may be a DC voltage maintained at a voltage level lower than that of the second drive voltage ELVSS.

The reset transistor ST1 may include a plurality of sub-reset transistors connected in series. For example, the reset transistor ST1 may include two sub-reset transistors (hereinafter, referred to as first and second sub-reset transistors). In this case, a third electrode of the first sub-reset transistor and a third electrode of the second sub-reset transistor are connected to the reset control line SRL. Furthermore, a second electrode of the first sub-reset transistor and a first electrode of the second sub-reset transistor may be electrically connected with each other. In addition, the reset voltage Vrst may be applied to a first electrode of the first sub-reset transistor, and a second electrode of the second sub-reset transistor may be electrically connected with the first sensing node SN1. However, the number of sub-reset transistors is not limited thereto and may be modified in various suitable ways.

The amplifying transistor ST2 includes a first electrode that receives a sensing drive voltage SLVD, a second electrode connected with a second sensing node SN2, and a third electrode connected with the first sensing node SN1. The amplifying transistor ST2 may be turned on depending on the potential of the first sensing node SN1 and may apply the sensing drive voltage SLVD to the second sensing node SN2. The sensing drive voltage SLVD may be one of the first drive voltage ELVDD, the first initialization voltage Vint, and the second initialization voltage Vaint. When the sensing drive voltage SLVD is the first drive voltage ELVDD, the first electrode of the amplifying transistor ST2 may be electrically connected to the first drive voltage line VL1. When the sensing drive voltage SLVD is the first initialization voltage Vint, the first electrode of the amplifying transistor ST2 may be electrically connected to the first initialization voltage line VIL, and when the sensing drive voltage SLVD is the second initialization voltage Vaint, the first electrode of the amplifying transistor ST2 may be electrically connected to the second initialization voltage line VAIL.

The output transistor ST3 includes a first electrode connected with the second sensing node SN2, a second electrode connected with the d-th readout line RLd, and a third electrode that receives an output control signal. In response to the output control signal, the output transistor ST3 may transfer a detection signal FSd to the d-th readout line RLd. The output control signal may be the j-th write scan signal SWj supplied through the j-th write scan line SWLj. That is, the output transistor ST3 may receive the j-th write scan signal SWj, which is supplied from the j-th write scan line SWLj, as the output control signal.

The light receiving element OPD of the sensor FXdj may be exposed to light during a light emission period of the light emitting element ED. The light may be light output from the light emitting element ED.

If the user's hand US_F (e.g., refer to FIG. 1) touches the display surface IS (e.g., refer to FIG. 1), the light receiving element OPD generates photo-charges corresponding to light reflected by ridges of a fingerprint and/or valleys between the ridges. The amount of current flowing through the light receiving element OPD varies depending on the generated photo-charges. When the light receiving element OPD receives light reflected by the ridges of the fingerprint, a current flowing through the light receiving element OPD may be referred to as a first current, and when the light receiving element OPD receives light reflected by the valleys of the fingerprint, a current flowing through the light receiving element OPD may be referred to as a second current. The amount of light reflected by the ridges of the fingerprint and the amount of light reflected by the valleys of the fingerprint differ from each other, and the difference between the amounts of light appears as a difference between the first and second currents. When the first current flows through the light receiving element OPD, the potential of the first sensing node SN1 may be referred to as the first potential, and when the second current flows through the light receiving element OPD, the potential of the first sensing node SN1 may be referred to as the second potential. The first current may be greater than the second current. In this case, the first potential may be lower than the second potential.

The amplifying transistor ST2 may be a source follower amplifier that generates a source-drain current in proportion to the potential of the first sensing node SN1 that is input to the third electrode.

During the fourth activation period AP4, the j-th write scan signal SWj having the low level is supplied to the output transistor ST3 through the j-th write scan line SWLj. When the output transistor ST3 is turned on in response to the j-th write scan signal SWj having the low level, the detection signal FSd corresponding to a current flowing through the amplifying transistor ST2 may be output to the d-th readout line RLd.

When the reset control signal SR having a high level is supplied through the reset control line SRL during a reset period, the reset transistor ST1 is turned on. The reset period may be defined as an activation period (that is, a high-level period) of the reset control signal SR. Alternatively, when the reset transistor ST1 is implemented with a P-type transistor, the reset control signal SR having a low level may be supplied to the reset control line SRL during the reset period. The first sensing node SN1 may be reset to a potential corresponding to the reset voltage Vrst during the reset period. The reset voltage Vrst may have a lower voltage level than the second drive voltage ELVSS.

When the reset period ends, the light receiving element OPD may generate photo-charges corresponding to received light, and the generated photo-charges may be accumulated in the first sensing node SN1.

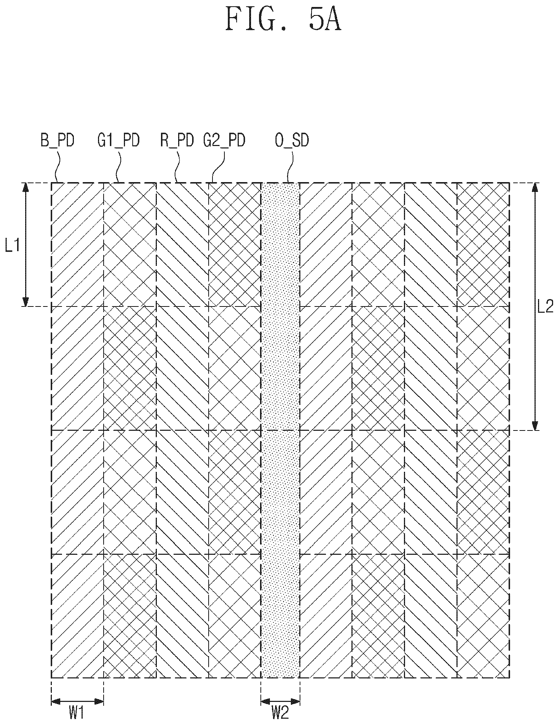

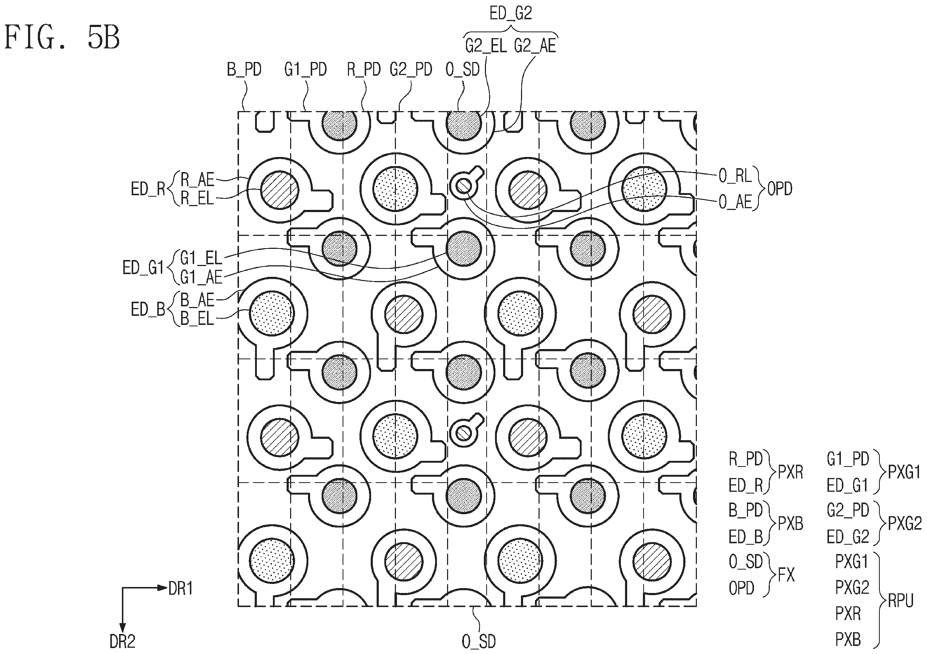

FIG. 5A is a schematic plan view illustrating an arrangement of pixel drive circuits and sensor drive circuits. FIG. 5B is a plan view illustrating an arrangement of light emitting elements and light receiving elements.

Referring to FIGS. 5A and 5B, the display panel DP (e.g., refer to FIG. 3) includes a plurality of pixels PXR, PXG1, PXG2, and PXB and a plurality of sensors FX.

The plurality of pixels PXR, PXG1, PXG2, and PXB may be grouped into a plurality of reference pixel units RPU. Each of the reference pixel units RPU may include four pixels, that is, a first pixel PXB (hereinafter, referred to as a blue pixel), a second pixel PXR (hereinafter, referred to as a red pixel), and two third pixels PXG1 and PXG2 (hereinafter, referred to as first and second green pixels). However, the number of pixels included in each reference pixel unit RPU is not limited thereto. Alternatively, each reference pixel unit RPU may include three pixels, that is, a blue pixel PXB, a red pixel PXR, and a green pixel (one of the first and second green pixels PXG1 and PXG2).

The blue pixel PXB includes a first light emitting element ED_B (hereinafter, referred to as a blue light emitting element) and a blue pixel drive circuit B_PD (or, a first pixel drive circuit). The red pixel PXR includes a second light emitting element ED_R (hereinafter, referred to as a red light emitting element) and a red pixel drive circuit R_PD (or, a second pixel drive circuit). The first green pixel PXG1 includes a third light emitting element ED_G1 (hereinafter, referred to as a first green light emitting element) and a first green pixel drive circuit G1_PD (or, a third pixel drive circuit), and the second green pixel PXG2 includes a fourth light emitting element ED_G2 (hereinafter, referred to as a second green light emitting element) and a second green pixel drive circuit G2_PD (or, a fourth pixel drive circuit).

The blue light emitting element ED_B outputs first color light (e.g., blue light), and the red light emitting element ED_R outputs second color light (e.g., red light) different from the first color light. Each of the first and second green light emitting elements ED_G1 and ED_G2 outputs third color light (e.g., green light) that is different from the first color light and the second color light. The green light output from the first green light emitting element ED_G1 may have the same wavelength band as the green light output from the second green light emitting element ED_G2.

The red light emitting elements ED_R and the blue light emitting elements ED_B may alternate with one another in the first and second directions DR1 and DR2. The first green light emitting elements ED_G1 and the second green light emitting elements ED_G2 alternate with one another in the first and second directions DR1 and DR2. In a first row (e.g., an odd-numbered row) parallel to the first direction DR1, the light emitting elements ED_R, ED_G1, ED_G2, and ED_B may be arranged in the order of the red light emitting element ED_R, the first green light emitting element ED_G1, the blue light emitting element ED_B, and the second green light emitting element ED_G2. Meanwhile, in a second row (e.g., an even-numbered row) parallel to the first direction DR1, the light emitting elements ED_R, ED_G1, ED_G2, and ED_B may be arranged in the order of the blue light emitting element ED_B, the second green light emitting element ED_G2, the red light emitting element ED_R, and the first green light emitting element ED_G1.

The red light emitting element ED_R may have a larger size than the first and second green light emitting elements ED_G1 and ED_G2. In addition, the blue light emitting element ED_B may have a size greater than or equal to the size of the red light emitting element ED_R. The sizes of the light emitting elements ED_R, ED_G1, ED_G2, and ED_B are not limited thereto and may be modified in various suitable ways. For example, The light emitting elements ED_R, ED_G1, ED_G2, and ED_B may have the same size.

The first and second green light emitting elements ED_G1 and ED_G2 may have the same shape as the red and blue light emitting elements ED_R and ED_B. The red and blue light emitting elements ED_R and ED_B and the first and second green light emitting elements ED_G1 and ED_G2 may have a circular shape. Alternatively, the red and blue light emitting elements ED_R and ED_B and the first and second green light emitting elements ED_G1 and ED_G2 may have a polygonal shape (e.g., an octagonal shape, a square shape, and/or a rectangular shape). However, the present disclosure is not limited thereto, and the red and blue light emitting elements ED_R and ED_B and the first and second green light emitting elements ED_G1 and ED_G2 may have different shapes.

The blue light emitting element ED_B is electrically connected to the blue pixel drive circuit B_PD. By way of example, the blue light emitting element ED_B includes a blue anode electrode B_AE and a blue light emitting layer B_EL, and the blue anode electrode B_AE is electrically connected with the blue pixel drive circuit B_PD.

The red light emitting element ED_R is electrically connected to the red pixel drive circuit R_PD. By way of example, the red light emitting element ED_R includes a red anode electrode R_AE and a red light emitting layer R_EL, and the red anode electrode R_AE is electrically connected with the red pixel drive circuit R_PD.

The first green light emitting element ED_G1 is electrically connected to the first green pixel drive circuit G1_PD. By way of example, the first green light emitting element ED_G1 includes a first green anode electrode G1_AE and a first green light emitting layer G1_EL, and the first green anode electrode G1_AE is electrically connected with the first green pixel drive circuit G1_PD. The second green light emitting element ED_G2 is electrically connected to the second green pixel drive circuit G2_PD. By way of example, the second green light emitting element ED_G2 includes a second green anode electrode G2_AE and a second green light emitting layer G2_EL, and the second green anode electrode G2_AE is electrically connected with the second green pixel drive circuit G2_PD.

The first green light emitting layer G1_EL and the second green light emitting layer G2_EL may have the same size and shape. However, the present disclosure is not limited thereto. For example, the first green light emitting layer G1_EL and the second green light emitting layer G2_EL may have the same size (or, area), but may have different shapes. Alternatively, the first green anode electrode G1_AE and the second green anode electrode G2_AE may have different sizes (or areas) and/or different shapes.

Each of the sensors FX includes a light receiving element OPD and a sensor drive circuit O_SD. One light receiving element OPD may be disposed to correspond to two reference pixel units RPU. However, the number of light receiving elements disposed to correspond to each reference pixel unit RPU is not limited thereto. For example, one light receiving element OPD may be disposed to correspond to three reference pixel units RPU.

The plurality of light receiving elements OPD is arranged in the first and second directions DR1 and DR2 in the display panel DP. Each of the light receiving elements OPD is disposed between the red and blue light emitting elements ED_R and ED_B in the first direction DR1. Each of the light receiving elements OPD is disposed between the first green light emitting elements ED_G1 and the second green light emitting element ED_G2 adjacent to each other in the second direction DR2.

The sensor drive circuits O_SD are arranged in the first and second directions DR1 and DR2 in the display panel DP. Each of the sensor drive circuits O_SD may be disposed between the blue pixel drive circuit B_PD and the second green pixel drive circuit G2_PD in the first direction DR1.

The light receiving elements OPD are connected to the sensor drive circuits O_SD, respectively. The light receiving elements OPD may be disposed in positions overlapping the sensor drive circuits O_SD when viewed from above the plane (e.g., in a plan view). However, the present disclosure is not limited thereto. Alternatively, the light receiving elements OPD may be disposed in positions not overlapping the sensor drive circuits O_SD when viewed from above the plane (e.g., in a plan view).

Each of the light receiving elements OPD includes a sensor anode electrode O_AE and a photoelectric conversion layer O_RL. The sensor anode electrode O_AE is connected with the sensor drive circuit O_SD.

The light receiving elements OPD may have the same shape as the light emitting elements ED_G1, ED_G2, ED_R, and ED_B. For example, the light receiving elements OPD may have a circular shape. However, the shapes of the light receiving elements OPD are not limited thereto. For example, the light receiving elements OPD may have a polygonal shape (e.g., an octagonal shape, a square shape, and/or a rectangular shape). Alternatively, the light receiving elements OPD may have a shape different from the shape of at least one of the light emitting elements ED_G1, ED_G2, ED_R, and/or ED_B.

The light receiving elements OPD may have a size smaller than or equal to the sizes of the first and second green light emitting elements ED_G1 and ED_G2. However, the sizes of the light receiving elements OPD are not particularly limited thereto and may be modified in various suitable ways.

The blue pixel drive circuits B_PD are repeatedly disposed in a first column, and the first green pixel drive circuits G1_PD and the second green pixel drive circuit G2_PD are alternately and repeatedly disposed in a second column. The red pixel drive circuits R_PD are repeatedly disposed in a third column, and the second green pixel drive circuits G2_PD and the first green pixel drive circuits G1_PD are alternately and repeatedly disposed in a fourth column. The sensor drive circuits O_SD are repeatedly disposed in a fifth column. The first to fifth columns may be repeated in the second direction DR2.

The sensor drive circuits O_SD may have a second length L2 greater than the first length L1 of the red and blue pixel drive circuits R_PD and B_PD and the first and second green pixel drive circuits G1_PD and G2_PD in the second direction DR2. For example, the second length L2 of the sensor drive circuits O_SD may be twice the first length L1. The sensor drive circuits O_SD may have a second width W2 smaller than the first width W1 of the red and blue pixel drive circuits R_PD and B_PD and the first and second green pixel drive circuits G1_PD and G2_PD in the first direction DR1. For example, the second width W2 of the sensor drive circuits O_SD may be half of the first width W1.

Accordingly, one sensor FX per two reference pixel units RPU may be disposed in the display panel DP, and thus the display resolution of the display panel DP may be increased (or improved).

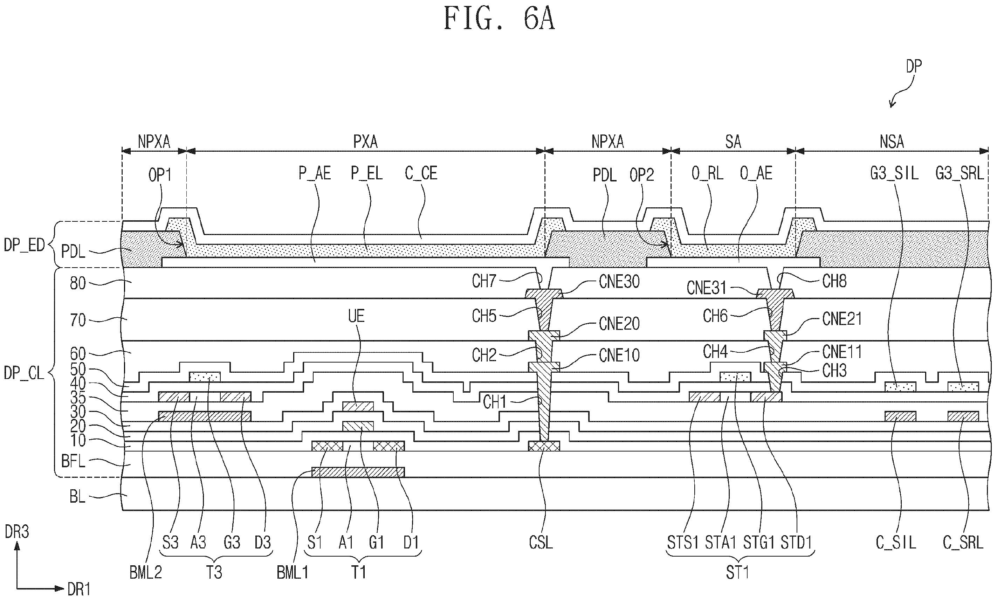

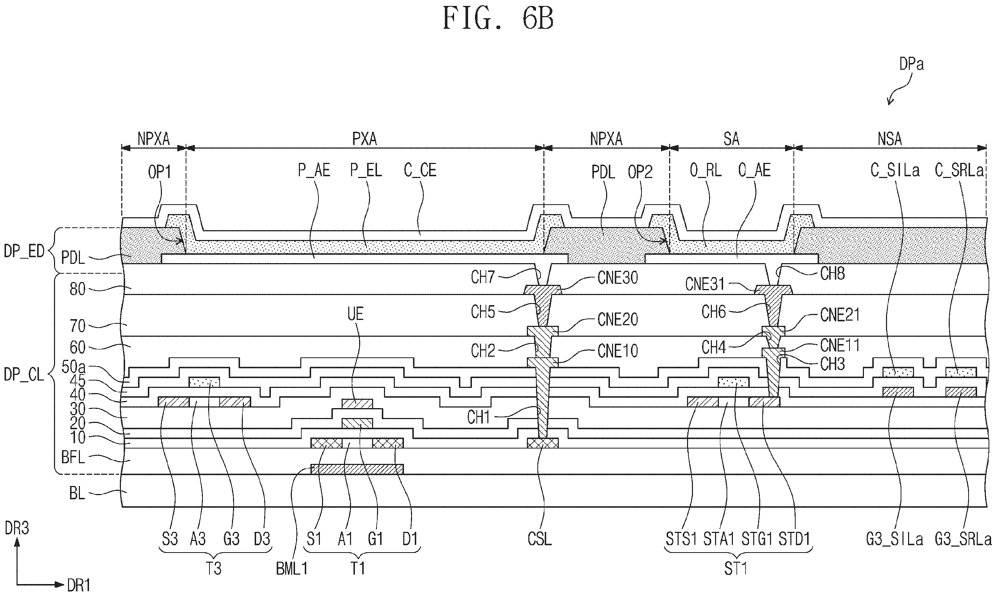

FIGS. 6A and 6B are sectional views of display panels.

Referring to FIG. 6A, the display panel DP may include the base layer BL, the circuit layer DP_CL, and the element layer DP_ED.

The base layer BL may include a synthetic resin layer. The synthetic resin layer may include a thermosetting resin. For example, the synthetic resin layer may be a polyimide-based resin layer, but the material thereof is not particularly limited thereto. The synthetic resin layer may include at least one of an acrylic resin, a methacrylic resin, a polyisoprene resin, a vinyl resin, an epoxy resin, a urethane-based resin, a cellulosic resin, a siloxane-based resin, a polyamide resin, and/or a perylene-based resin. In addition, the base layer BL may include a glass substrate, a metal substrate, or an organic/inorganic composite substrate.

At least one inorganic layer may be formed on the upper surface of the base layer BL. The inorganic layer may include at least one of aluminum oxide, titanium oxide, silicon oxide, silicon oxy nitride, zirconium oxide, and/or hafnium oxide. The inorganic layer may be formed of multiple layers.

The circuit layer DP_CL is disposed on the base layer BL. Referring to FIG. 6A, a first shielding layer BML1 may be disposed on the base layer BL. The first shielding layer BML1 may overlap the first transistor T1. The first shielding layer BML1 may include metal and may receive a constant voltage. When the constant voltage is applied to the first shielding layer BML1, the threshold voltage Vth of the first transistor T1 disposed over the first shielding layer BML1 may remain unchanged.

The first shielding layer BML1 may block light incident from below the first shielding layer BML1 toward the first transistor T1. For example, the first shielding layer BML1 may include a reflective metal. The first shielding layer BML1 may be omitted. A buffer layer BFL may be disposed on the base layer BL. The buffer layer BFL may include an inorganic layer. The buffer layer BFL may cover the first shielding layer BML1.

A semiconductor pattern is disposed on the buffer layer BFL. Hereinafter, the semiconductor pattern directly disposed on the buffer layer BFL is defined as a first semiconductor pattern. The first semiconductor pattern may include a silicon semiconductor. The first semiconductor pattern may include poly silicon. However, without being limited thereto, the first semiconductor pattern may include amorphous silicon.

In FIG. 6A, only a portion of the first semiconductor pattern is illustrated, and the first semiconductor pattern may be additionally disposed in another region of the pixel PXij (e.g., refer to FIG. 4A). The first semiconductor pattern has different electrical properties depending on whether the first semiconductor pattern is doped or not. The first semiconductor pattern may include a doped region and a non-doped region. The doped region may be doped with an N-type dopant or a P-type dopant. A P-type transistor includes a doped region doped with a P-type dopant, and an N-type transistor includes a doped region doped with an N-type dopant.

The doped region has a higher conductivity than the non-doped region and substantially serves as an electrode or a signal line of the first transistor T1. The non-doped region substantially corresponds to an active region (or, a channel part) of the first transistor T1. In other words, one portion of the first semiconductor pattern may be the active region of the first transistor T1, another portion may be a source or drain of the first transistor T1, and another portion may be a connecting signal line (or, a connecting electrode).

As illustrated in FIG. 6A, the first electrode S1 (the source), the channel part A1, and the second electrode D1 (the drain) of the first transistor T1 are formed from the first semiconductor pattern. The first electrode S1 and the second electrode D1 of the first transistor T1 extend from the channel part A1 in opposite directions.

In FIG. 6A, a portion of a connecting signal line CSL formed from the first semiconductor pattern is illustrated. Although not separately illustrated, the connecting signal line CSL may be connected to the second electrode of the sixth transistor T6 (e.g., refer to FIG. 4A) when viewed from above the plane (e.g., in a plan view).

A first insulating layer 10 is disposed on the buffer layer BFL. The first insulating layer 10 commonly overlaps the plurality of pixels PX (e.g., refer to FIG. 3) and covers the first semiconductor pattern. The first insulating layer 10 may be an inorganic layer and/or an organic layer and may have a single-layer structure or a multi-layer structure. The first insulating layer 10 may include at least one of aluminum oxide, titanium oxide, silicon oxide, silicon oxy nitride, zirconium oxide, and/or hafnium oxide. In the described embodiment, the first insulating layer 10 may be a single silicon oxide layer. Not only the first insulating layer 10 but also insulating layers of the circuit layer DP_CL that will be described below may be inorganic layers and/or organic layers and may have a single-layer structure or a multi-layer structure. The inorganic layers may include at least one of the aforementioned materials.

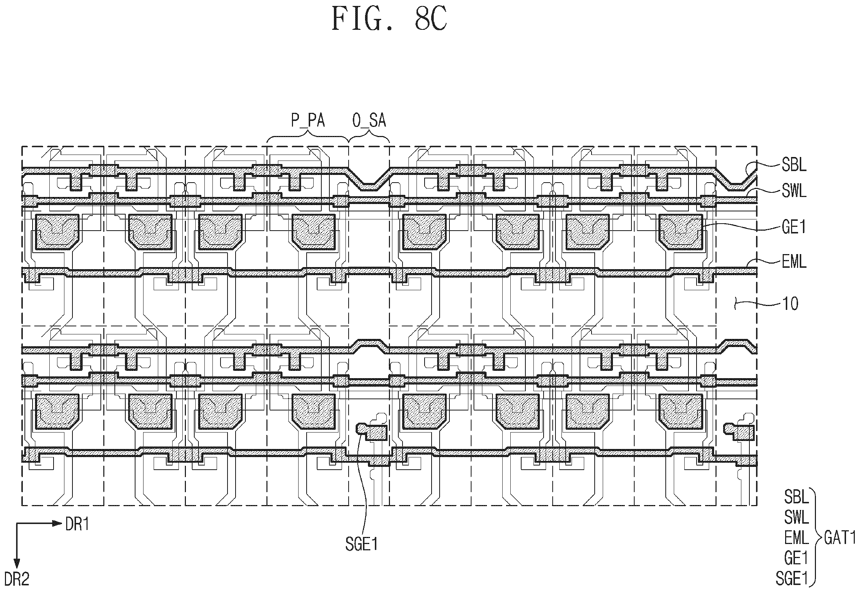

The third electrode G1 of the first transistor T1 is disposed on the first insulating layer 10. The third electrode G1 may be a portion of a first gate pattern layer GAT1 (e.g., refer to FIG. 8C). The third electrode G1 of the first transistor T1 overlaps the channel part A1 of the first transistor T1. The third electrode G1 of the first transistor T1 may serve as a mask in a process of doping the first semiconductor pattern.

A second insulating layer 20 that covers the third electrode G1 is disposed on the first insulating layer 10. The second insulating layer 20 commonly overlaps the plurality of pixels PX. The second insulating layer 20 may be an inorganic layer and/or an organic layer and may have a single-layer structure or a multi-layer structure. In the described embodiment, the second insulating layer 20 may be a single silicon oxide layer.

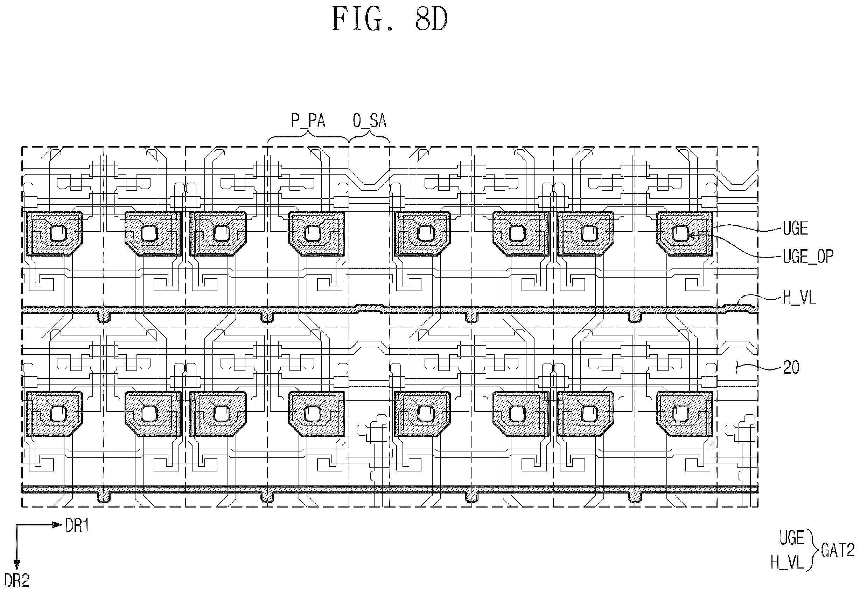

An upper electrode UE may be disposed on the second insulating layer 20. The upper electrode UE may overlap the third electrode G1. The upper electrode UE may a portion of a second gate pattern layer GAT2 (e.g., refer to FIG. 8D), or may be a portion of a doped semiconductor pattern. A portion of the third electrode G1 and the upper electrode UE overlapping the portion of the third electrode G1 may define the capacitor Cst (e.g., refer to FIG. 4A). The upper electrode UE may be omitted.

The second insulating layer 20 may be replaced with an insulating pattern. The upper electrode UE is disposed on the insulating pattern. The upper electrode UE may serve as a mask that forms the insulating pattern from the second insulating layer 20.

A third insulating layer 30 that covers the upper electrode UE is disposed on the second insulating layer 20. In the described embodiment, the third insulating layer 30 may be a single silicon oxide layer.

A second shielding layer BML2 may be disposed on the third insulating layer 30. The second shielding layer BML2 may overlap the third transistor T3. The second shielding layer BML2 may include metal and may receive a constant voltage. When the constant voltage is applied to the second shielding layer BML2, the threshold voltage Vth of the third transistor T3 disposed over the second shielding layer BML2 may remain unchanged.

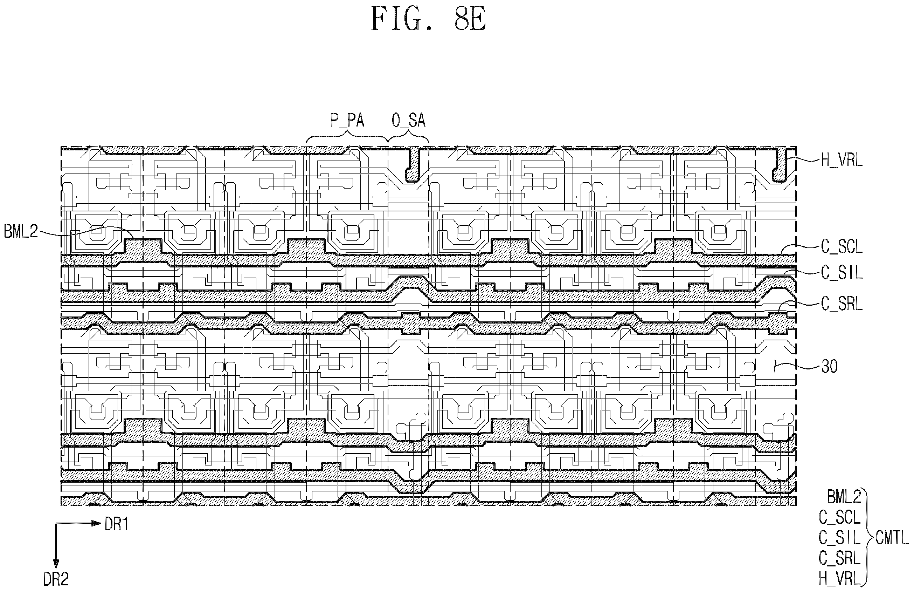

The second shielding layer BML2 may block light incident from below the second shielding layer BML2 toward the third transistor T3. The second shielding layer BML2 may be a portion of an additional gate pattern layer CMTL (e.g., refer to FIG. 8E).

A fourth gate wiring C_SRL (or, a first reset control wiring) constituting the reset control line SRL (e.g., refer to FIG. 4A), a fifth gate wiring C_SCL (e.g., refer to FIG. 8E) (or, a first compensation scan wiring) constituting the compensation scan lines SCL1 to SCLn (e.g., refer to FIG. 3), and a sixth gate wiring C_SIL (or, a first initialization scan wiring) constituting the initialization scan lines SIL1 to SILn (e.g., refer to FIG. 3) may be additionally disposed on the third insulating layer 30. The fourth to sixth gate wirings C_SRL, C_SCL, and C_SIL may be portions of the additional gate pattern layer CMTL. The second shielding layer BML2 may extend from the fifth gate wiring C_SCL or the sixth gate wiring C_SIL. An additional insulating layer 35 may cover the additional gate pattern layer CMTL.

A semiconductor pattern is disposed on the additional insulating layer 35. Hereinafter, the semiconductor pattern directly disposed on the additional insulating layer 35 is defined as a second semiconductor pattern. The second semiconductor pattern may include a metal oxide semiconductor. The metal oxide semiconductor may include a crystalline and/or amorphous oxide semiconductor. For example, the metal oxide semiconductor may include metal oxide of zinc (Zn), indium (In), gallium (Ga), tin (Sn), and/or titanium (Ti). Alternatively, the metal oxide semiconductor may include a mixture of metal such as zinc (Zn), indium (In), gallium (Ga), tin (Sn), and/or titanium (Ti) and oxide thereof. The metal oxide semiconductor may include indium-tin oxide (ITO), indium-gallium-zinc oxide (IGZO), zinc oxide (ZnO), indium-zinc oxide (IZO), zinc-indium oxide (ZIO), indium oxide (InO), titanium oxide (TiO), indium-zinc-tin oxide (IZTO), and/or zinc-tin oxide (ZTO).

In FIG. 6A, only a portion of the second semiconductor pattern is illustrated, and the second semiconductor pattern may be additionally disposed in another region of the pixel PXij. The second semiconductor pattern may include a plurality of regions distinguished depending on whether metal oxide is reduced or not. A region where metal oxide is reduced (hereinafter, referred to as the reduced region) has a higher conductivity than a region where metal oxide is not reduced (hereinafter, referred to as the non-reduced region). The reduced region substantially serves as an electrode or a signal line of the third transistor T3. The non-reduced region substantially corresponds to a channel part A3 of the third transistor T3. In other words, one portion of the second semiconductor pattern may be the channel part A3 of the third transistor T3, and another portion of the second semiconductor pattern may be the first electrode S3 or the second electrode D3 of the third transistor T3.

The circuit layer DP_CL may further include a portion of a semiconductor pattern of the sensor drive circuit O_SD (e.g., refer to FIG. 4A). For convenience of description, the reset transistor ST1 of the semiconductor pattern of the sensor drive circuit O_SD is illustrated. The first electrode STS1, a channel part STA1, and the second electrode STD1 of the reset transistor ST1 are formed from the second semiconductor pattern. The first electrode STS1 and the second electrode STD1 include metal reduced from a metal oxide semiconductor.

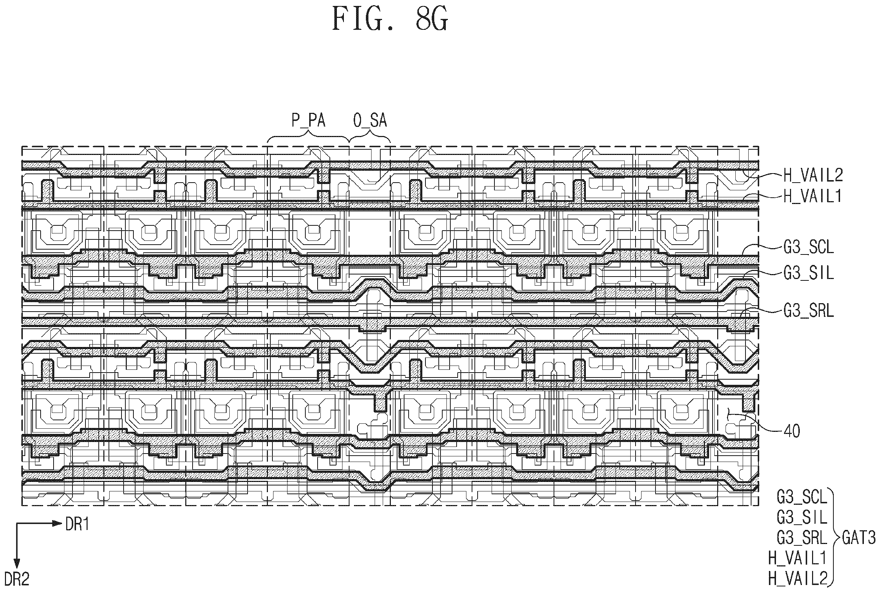

A fourth insulating layer 40 is disposed to cover the first electrode S3, the channel part A3, and the second electrode D3 of the third transistor T3 and the first electrode STS1, the channel part STA1, and the second electrode STD1 of the reset transistor ST1. The third electrode G3 of the third transistor T3 and the third electrode STG1 of the reset transistor ST1 are disposed on the fourth insulating layer 40. In the described embodiment, the third electrode G3 of the third transistor T3 and the third electrode STG1 of the reset transistor ST1 may be portions of a third gate pattern layer GAT3 (e.g., refer to FIG. 8G). The third electrode G3 of the third transistor T3 overlaps the channel part A3 of the third transistor T3, and the third electrode STG1 of the reset transistor ST1 overlaps the channel part STA1 of the reset transistor ST1. Although one third electrode STG1 is illustrated in the described embodiment for convenience of description, the reset transistor ST1 may include two third electrodes STG1.

A seventh gate wiring G3_SRL (or, a second reset control wiring) constituting the reset control line SRL (e.g., refer to FIG. 4A), an eighth gate wiring G3_SCL (e.g., refer to FIG. 8G) (or, a second compensation scan wiring) constituting the compensation scan lines SCL1 to SCLn (e.g., refer to FIG. 3), and a ninth gate wiring G3_SIL (or, a second initialization scan wiring) constituting the initialization scan lines SIL1 to SILn (e.g., refer to FIG. 3) may be additionally disposed on the fourth insulating layer 40. The seventh to ninth gate wirings G3_SRL, G3_SCL, and G3_SIL may be portions of the third gate pattern layer GAT3.

A fifth insulating layer 50 is disposed on the fourth insulating layer 40 to cover the third electrode G3 of the third transistor T3 and the third electrode STG1 of the reset transistor ST1. The fifth insulating layer 50 may cover the seventh to ninth gate wirings G3_SRL, G3_SCL, and G3_SIL. In the described embodiment, the fifth insulating layer 50 may include a silicon oxide layer and/or a silicon nitride layer. The fifth insulating layer 50 may include a plurality of silicon oxide layers and a plurality of silicon nitride layers alternately stacked one above another.

At least one insulating layer is additionally disposed on the fifth insulating layer 50. A sixth insulating layer 60 and a seventh insulating layer 70 may be disposed on the fifth insulating layer 50. The sixth insulating layer 60 and the seventh insulating layer 70 may be organic layers and may have a single-layer structure or a multi-layer structure. Each of the sixth insulating layer 60 and the seventh insulating layer 70 may be a single polyimide-based resin layer. Without being limited thereto, the sixth insulating layer 60 and the seventh insulating layer 70 may include at least one of an acrylic resin, a methacrylic resin, a polyisoprene resin, a vinyl resin, an epoxy resin, a urethane-based resin, a cellulosic resin, a siloxane-based resin, a polyamide resin, and/or a perylene-based resin.

A first connecting electrode CNE10 may be disposed on the fifth insulating layer 50. The first connecting electrode CNE10 is connected to the connecting signal line CSL through a first contact hole CH1 penetrating the first to fifth insulating layers 10 to 50. A second connecting electrode CNE20 may be connected to the first connecting electrode CNE10 through a second contact hole CH2 penetrating the sixth insulating layer 60. At least one of the fifth to seventh insulating layers 50 to 70 may be omitted, and one of the first and second connecting electrodes CNE10 and CNE20 may also be omitted.

A third connecting electrode CNE11 may be additionally disposed on the fifth insulating layer 50. The third connecting electrode CNE11 is connected with the second electrode STD1 of the reset transistor ST1 through a third contact hole CH3 penetrating the fourth and fifth insulating layers 40 and 50. A fourth connecting electrode CNE21 may be connected to the third connecting electrode CNE11 through a fourth contact hole CH4 penetrating the sixth insulating layer 60.

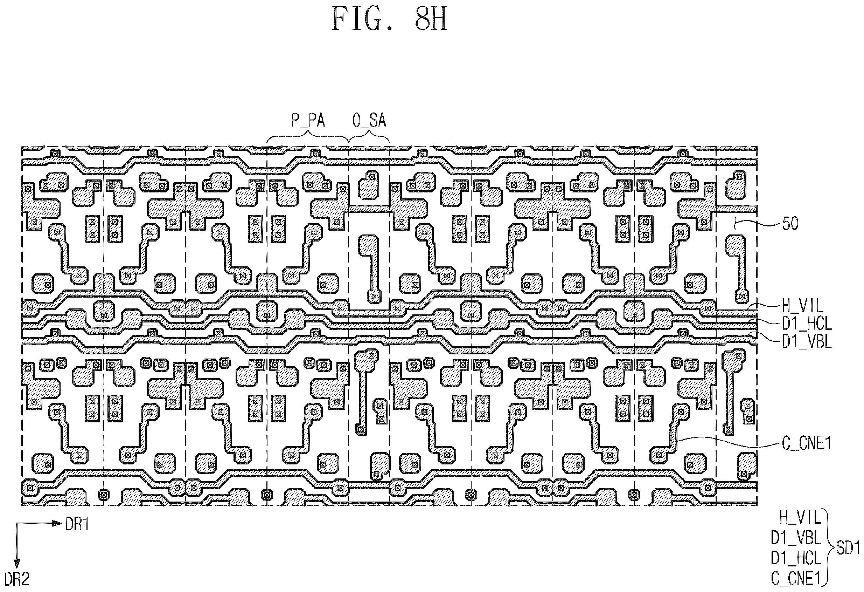

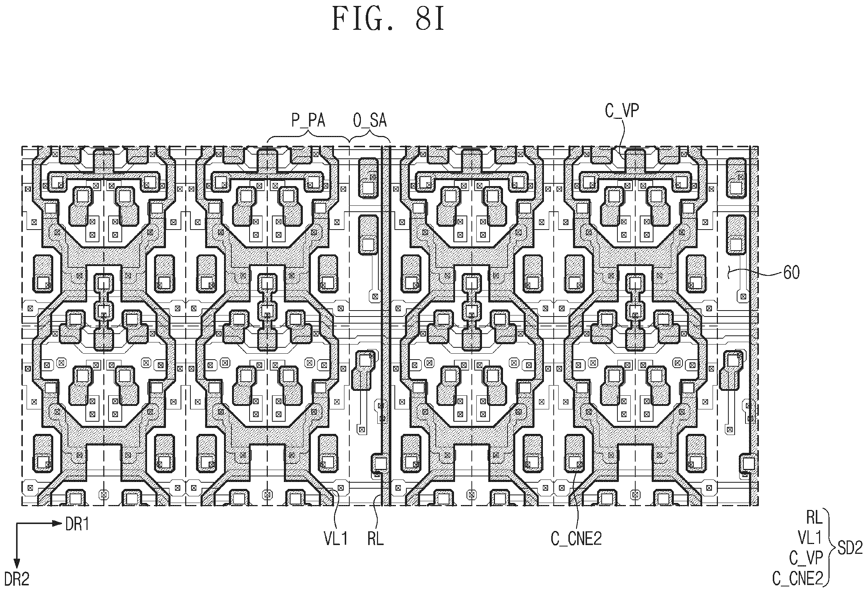

The first and third connecting electrodes CNE10 and CNE11 may be portions of a first data pattern layer SD1 (e.g., refer to FIG. 8H), and the second and fourth connecting electrodes CNE20 and CNE21 may be portions of a second data pattern layer SD2 (e.g., refer to FIG. 8I). The second and fourth connecting electrodes CNE20 and CNE21 are covered by the seventh insulating layer 70.

A fifth connecting electrode CNE30 and a sixth connecting electrode CNE31 may be additionally disposed on the seventh insulating layer 70. The fifth connecting electrode CNE30 may be connected with the second connecting electrode CNE20 through a fifth contact hole CH5 penetrating the seventh insulating layer 70. The sixth connecting electrode CNE31 may be connected to the fourth connecting electrode CNE21 through a sixth contact hole CH6 penetrating the seventh insulating layer 70. The fifth and sixth connecting electrodes CNE30 and CNE31 are covered by an eighth insulating layer 80.

The element layer DP_ED is disposed on the circuit layer DP_CL. The element layer DP_ED may include the anode electrode P_AE of the light emitting element ED (e.g., refer to FIG. 4A) and the anode electrode O_AE of the light receiving element OPD (e.g., refer to FIG. 4A). As illustrated in FIG. 6A, the anode electrode P_AE of the light emitting element ED may be connected to the fifth connecting electrode CNE30 through a seventh contact hole CH7 penetrating the eighth insulating layer 80. The anode electrode O_AE of the light receiving element OPD may be connected to the sixth connecting electrode CNE31 through an eighth contact hole CH8 penetrating the eighth insulating layer 80.

Although the structure in which the circuit layer DP_CL includes the fifth connecting electrode CNE30 and the sixth connecting electrode CNE31 is illustrated in FIG. 6A, the present disclosure is not limited thereto. Alternatively, the fifth connecting electrode CNE30 and the sixth connecting electrode CNE31 may be omitted from the circuit layer DP_CL. In this case, the anode electrode P_AE may be directly connected with the second connecting electrode CNE20, and the anode electrode O_AE may be directly connected with the fourth connecting electrode CNE21.

The element layer DP_ED further includes a pixel defining layer PDL disposed on the circuit layer DP_CL. The pixel defining layer PDL may include a light emitting opening OP1 defined to correspond to the light emitting element ED and a light receiving opening OP2 defined to correspond to the light receiving element OPD. The light emitting opening OP1 exposes at least a portion of the anode electrode P_AE of the light emitting element ED. The light emitting opening OP1 of the pixel defining layer PDL may define an emissive region PXA. For example, the plurality of pixels PX (e.g., refer to FIG. 3) may be arranged on the plane of the display panel DP (e.g., refer to FIG. 3) according to a certain rule. Regions where the plurality of pixels PX is disposed may be defined as pixel regions, and one pixel region may include an emissive region PXA and a non-emissive region NPXA adjacent to the emissive region PXA. The non-emissive region NPXA may surround the emissive region PXA.

The light receiving opening OP2 exposes the anode electrode O_AE of the light receiving element OPD. The light receiving opening OP2 of the pixel defining layer PDL may define a light receiving region SA. For example, the plurality of sensors FX (e.g., refer to FIG. 3) may be arranged on the plane of the display panel DP according to a certain rule. Regions where the plurality of sensors FX is disposed may be defined as sensing regions, and one sensing region may include a light receiving region SA and a non-light receiving region NSA adjacent to the light receiving region SA. The non-light receiving region NSA may surround the light receiving region SA.

A light emitting layer P_EL is disposed to correspond to the light emitting opening OP1 defined in the pixel defining layer PDL, and a photoelectric conversion layer O_RL is provided to correspond to the light receiving opening OP2 defined in the pixel defining layer PDL. Although a structure in which the light emitting layer P_EL is patterned for each pixel PX is illustrated, the structure is not limited thereto. A common light emitting layer may be commonly disposed for the plurality of pixels PX. In this case, the common light emitting layer may generate white light or blue light. The common cathode electrode C_CE is commonly connected to the light emitting element ED and the light receiving element OPD. The common cathode electrode C_CE may face the anode electrode O_AE and the anode electrode P_AE. The common cathode electrode C_CE is disposed on the light emitting layer P_EL and the photoelectric conversion layer O_RL. The common cathode electrode C_CE is commonly disposed for the plurality of pixels PX and the plurality of sensors FX.

Although the structure in which the additional pattern layer CMTL is disposed below the third gate pattern layer GAT3 is illustrated in FIG. 6A, it is not limited thereto. For example, the additional pattern layer CMTL may be disposed above the third gate pattern layer GAT3.

Referring to FIG. 6B, a display panel DPa may include the base layer BL, the circuit layer DP_CL, and the element layer DP_ED.

The second semiconductor pattern is disposed on the third insulating layer 30. One portion of the second semiconductor pattern may be the channel part A3 of the third transistor T3, and another portion of the second semiconductor pattern may be the first electrode S3 or the second electrode D3 of the third transistor T3. The first electrode STS1, the channel part STA1, and the second electrode STD1 of the reset transistor ST1 may be formed from the second semiconductor pattern.

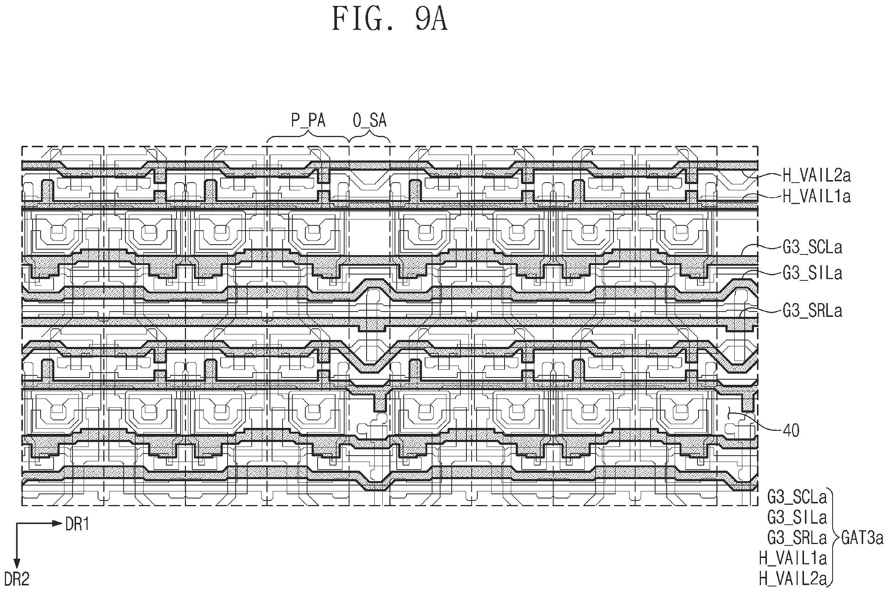

The fourth insulating layer 40 is disposed to cover the first electrode S3, the channel part A3, and the second electrode D3 of the third transistor T3 and the first electrode STS1, the channel part STA1, and the second electrode STD1 of the reset transistor ST1. The third electrode G3 of the third transistor T3 and the third electrode STG1 of the reset transistor ST1 are disposed on the fourth insulating layer 40. In the described embodiment, the third electrode G3 of the third transistor T3 and the third electrode STG1 of the reset transistor ST1 may be portions of a third gate pattern layer GAT3a (e.g., refer to FIG. 9A).

A fourth gate wiring G3_SRLa (or, a first reset control wiring) constituting the reset control line SRL (e.g., refer to FIG. 4A), a fifth gate wiring G3_SCLa (e.g., refer to FIG. 9A) (or, a first compensation scan wiring) constituting the compensation scan lines SCL1 to SCLn (e.g., refer to FIG. 3), and a sixth gate wiring G3_SILa (or, a first initialization scan wiring) constituting the initialization scan lines SIL1 to SILn (e.g., refer to FIG. 3) may be additionally disposed on the fourth insulating layer 40. The fourth to sixth gate wirings G3_SRLa, G3_SCLa, and G3_SILa may be portions of the third gate pattern layer GAT3a.

An additional insulating layer 45 is disposed on the fourth insulating layer 40 to cover the third electrode G3 of the third transistor T3 and the third electrode STG1 of the reset transistor ST1. The additional insulating layer 45 may cover the fourth to sixth gate wirings G3_SRLa, G3_SCLa, and G3_SILa.

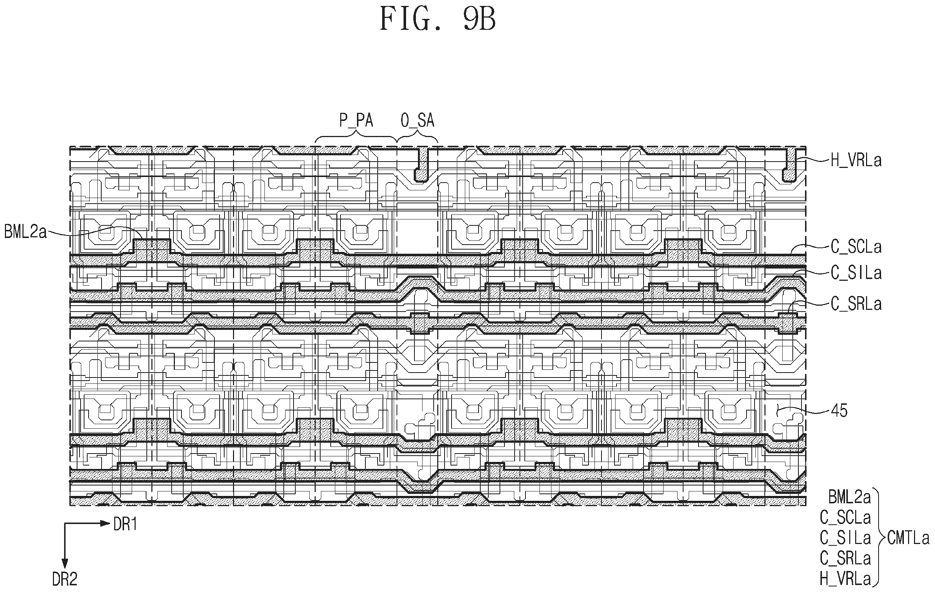

A seventh gate wiring C_SRLa (or, a second reset control wiring) constituting the reset control line SRL (e.g., refer to FIG. 4A), an eighth gate wiring C_SCLa (e.g., refer to FIG. 9B) (or, a second compensation scan wiring) constituting the compensation scan lines SCL1 to SCLn (e.g., refer to FIG. 3), and a ninth gate wiring C_SILa (or, a second initialization scan wiring) constituting the initialization scan lines SIL1 to SILn (e.g., refer to FIG. 3) may be additionally disposed on the additional insulating layer 45. The seventh to ninth gate wirings C_SRLa, C_SCLa, and C_SILa may be portions of an additional gate pattern layer CMTLa (e.g., refer to FIG. 9B). A fifth insulating layer 50a may cover the additional gate pattern layer CMTLa.

The sixth insulating layer 60 and the seventh insulating layer 70 may be disposed on the fifth insulating layer 50a. The remaining structure is the same as the structure illustrated in FIG. 6A, and therefore repetitive descriptions will be omitted.

Because the additional gate pattern layers CMTL and CMTLa are added to the display panels DP and DPa as described above, an enough space in which scan lines are disposed in one pixel row may be secured without degradation in display resolution.

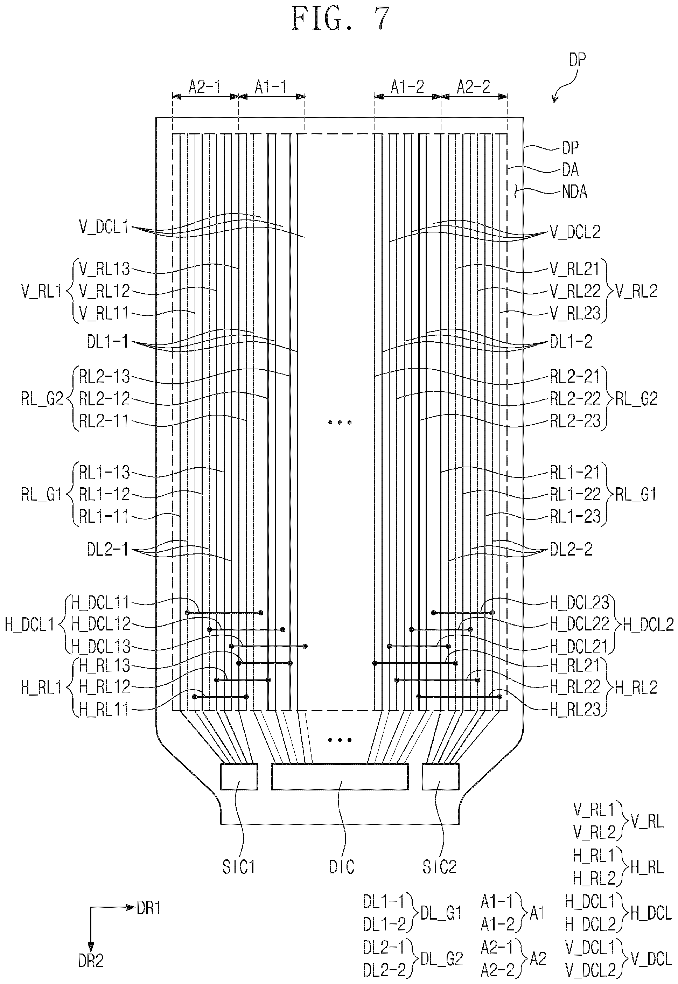

FIG. 7 is a plan view of the display panel DP.

Referring to FIG. 7, the display panel DP includes the display region DA and the non-display region NDA. The plurality of pixels PX (e.g., refer to FIG. 3) and the plurality of sensors FX (e.g., refer to FIG. 3) are disposed in the display region DA. The drive chip DIC and the sensor chips SIC1 and SIC2 are mounted on the non-display region NDA.

The data lines DL1 to DLm (e.g., refer to FIG. 3) are connected to the plurality of pixels PX in the display region DA and connected to the driver chip DIC in the non-display region NDA. The readout lines RL1 to RLh (e.g., refer to FIG. 3) are connected to the plurality of sensors FX in the display region DA and connected to the sensor chips SIC1 and SIC2 in the non-display region NDA.

The data lines DL1 to DLm may be divided into a first group and a second group. The first group includes a plurality of first data lines DL_G1, and the second group includes a plurality of second data lines DL_G2. The plurality of first data lines DL_G1 is arranged in the first direction DR1, and the plurality of second data lines DL_G2 is arranged in the first direction DR1. The plurality of first data lines DL_G1 is spaced (e.g., spaced apart) from the plurality of second data lines DL_G2 in the first direction DR1.

The plurality of first data lines DL_G1 is connected to pixel drive circuits P_PD of a first group of pixels from among the plurality of pixels PX, and the plurality of second data lines DL_G2 is connected to pixel drive circuits P_PD of a second group of pixels from among the plurality of pixels PX. The first group of pixels and the first data lines DL_G1 are disposed in a first region A1, and the second group of pixels and the second data lines DL_G2 are disposed in a second region A2. The first region A1 includes a first-first region A1-1 defined on a first side with respect to a center line of the display panel DP parallel to the second direction DR2 and a first-second region A1-2 defined on a second side with respect to the center line. The second region A2 includes a second-first region A2-1 disposed between the first-first region A1-1 and the non-display region NDA and a second-second region A2-2 disposed between the first-second region A1-2 and the non-display region NDA.

The plurality of first data lines DL_G1 includes first-first data lines DL1-1 disposed in the first-first region A1-1 and first-second data lines DL1-2 disposed in the first-second region A1-2. The plurality of second data lines DL_G2 includes second-first data lines DL2-1 disposed in the second-first region A2-1 and second-second data lines DL2-2 disposed in the second-second region A2-2.

The first-first data lines DL1-1 and the first-second data lines DL1-2 are connected to the driver chip DIC. Although FIG. 7 illustrates an example that the first-first data lines DL1-1 and the first-second data lines DL1-2 are connected to the same driver chip DIC, the present disclosure is not limited thereto. For example, the first-first data lines DL1-1 and the first-second data lines DL1-2 may be connected to different driver chips, respectively.

The display panel DP further includes data connecting lines that connect the second data lines DL_G2 to the driver chip DIC. The data connecting lines include a plurality of vertical data connecting lines V_DCL extending along the first data lines DL_G1 and a plurality of horizontal data connecting lines H_DCL extending in the first direction DR1.

The plurality of horizontal data connecting lines H_DCL includes first horizontal data connecting lines H_DCL11 to H_DCL13 and second horizontal data connecting lines H_DCL21 to H_DCL23. The first horizontal data connecting lines H_DCL11 to H_DCL13 are connected with the second-first data lines DL2-1, and the second horizontal data connecting lines H_DCL21 to H_DCL23 are connected with the second-second data lines DL2-2. The plurality of vertical data connecting lines V_DCL includes first vertical data connecting lines V_DCL1 and second vertical data connecting lines V_DCL2. The first vertical data connecting lines V_DCL1 are connected to the first horizontal data connecting lines H_DCL11 to H_DCL13, and the second vertical data connecting lines V_DCL2 are connected with the second horizontal data connecting lines H_DCL21 to H_DCL23.

Accordingly, the first vertical data connecting lines V_DCL1 are electrically connected with the second-first data lines DL2-1 by the first horizontal data connecting lines H_DCL11 to H_DCL13. The second vertical data connecting lines V_DCL2 are electrically connected with the second-second data lines DL2-2 by the second horizontal data connecting lines H_DCL21 to H_DCL23.

The first vertical data connecting lines V_DCL1 alternate with the first-first data lines DL1-1 in the first-first region A1-1. The second vertical data connecting lines V_DCL2 alternate with the first-second data lines DL1-2 in the first-second region A1-2.

The plurality of horizontal data connecting lines H_DCL and portions of the vertical data connecting lines V_DCL may be disposed in the display region DA. That is, portions of the data connecting lines for connecting the second data lines DL_G2 and the driver chip DIC are disposed in the display region DA. Accordingly, the area of the region occupied by the data connecting lines in the non-display region NDA may be decreased, and thus the area of dead space of the display panel DP may be decreased.

The readout lines RL1 to RLh may be divided into a first group and a second group. The first group includes a plurality of first readout lines RL_G1, and the second group includes a plurality of second readout lines RL_G2. The plurality of first readout lines RL_G1 is arranged in the first direction DR1, and the plurality of second readout lines RL_G2 is arranged in the first direction DR1. The plurality of first readout lines RL_G1 are spaced (e.g., spaced apart) from the plurality of second readout lines RL_G2 in the first direction DR1.

The plurality of first readout lines RL_G1 is connected to sensor drive circuits O_SD of a first group of sensors from among the plurality of sensors FX, and the plurality of second readout lines RL_G2 is connected to sensor drive circuits O_SD of a second group of sensors from among the plurality of sensors FX. The first group of sensors and the first readout lines RL_G1 are disposed in the second region A2, and the second group of sensors and the second readout lines RL_G2 are disposed in the first region A1.

The plurality of first readout lines RL_G1 includes first-first readout lines RL1-11 to RL1-13 and first-second readout lines RL1-21 to RL1-23. The first-first readout lines RL1-11 to RL1-13 are disposed in the second-first region A2-1 and connected to the first sensor chip SIC1. The first-second readout lines RL1-21 to RL1-23 are disposed in the second-second region A2-2 and connected to the second sensor chip SIC2.

The plurality of second readout lines RL_G2 includes second-first readout lines RL2-11 to RL2-13 and second-second readout lines RL2-21 to RL2-23. The second-first readout lines RL2-11 to RL2-13 are disposed in the first-first region A1-1 and electrically connected to the first sensor chip SIC1. The second-second readout lines RL2-21 to RL2-23 are disposed in the first-second region A1-2 and electrically connected to the second sensor chip SIC2. The plurality of second readout lines RL_G2 may be disposed between the first-first readout lines RL1-11 to RL1-13 and the first-second readout lines RL1-21 to RL1-23.

The display panel DP further includes connecting lines electrically connected with the second readout lines RL_G2. The connecting lines include a plurality of vertical connecting lines V_RL extending along the first readout lines RL_G1 and a plurality of horizontal connecting lines H_RL extending in the first direction DR1. The vertical connecting lines V_RL may include first vertical connecting lines V_RL1 electrically connected to the first sensor chip SIC1 and second vertical connecting lines V_RL2 electrically connected to the second sensor chip SIC2.

The first vertical connecting lines V_RL1 may alternate with the first-first readout lines RL1-11 to RL1-13 in the first direction DR1. The second vertical connecting lines V_RL2 may alternate with the first-second readout lines RL1-21 to RL1-23 in the first direction DR1. The first vertical connecting lines V_RL1 may include first vertical connecting lines V_RL11 to VRLV_RL13. The second vertical connecting lines V_RL2 may include first vertical connecting lines V_RL21 to VRLV_RL23.

The horizontal connecting lines H_RL electrically connect the vertical connecting lines V_RL to the second readout lines RL_G2. The horizontal connecting lines H_RL include first horizontal connecting lines H_RL1 that connect the first vertical connecting lines V_RL1 to the second-first readout lines RL2-11 to RL2-13, respectively, and second horizontal connecting lines H_RL2 that connect the second vertical connecting lines V_RL2 to the second-second readout lines RL2-21 to RL2-23, respectively. The first horizontal connecting lines H_RL1 may include first horizontal connecting lines H_RL11 to H_RL13. The second horizontal connecting lines H_RL2 may include second horizontal connecting lines H_RL21 to H_RL23.

The plurality of horizontal connecting lines H_RL and portions of the vertical connecting lines V_RL may be disposed in the display region DA. That is, portions of the connecting lines for connecting the second readout lines RL_G2 and the first and second sensor chips SIC1 and SIC2 are disposed in the display region DA. Accordingly, the area of the region occupied by the connecting lines in the non-display region NDA may be decreased, and thus the area of dead space of the display panel DP may be decreased.

Even though the first or second sensor chip SIC1 or SIC2 is disposed adjacent to the driver chip DIC, the readout lines and the data lines may not cross each other in the non-display region NDA when the second readout lines RL_G2 are connected to the first or second sensor chip SIC1 or SIC2 through the connecting lines and the second data lines DL_G2 are connected to the driver chip DIC through the data connecting lines. Accordingly, coupling capacitance between the readout lines and the data lines may be decreased, and thus the sensing accuracy of the sensors FX may be improved.

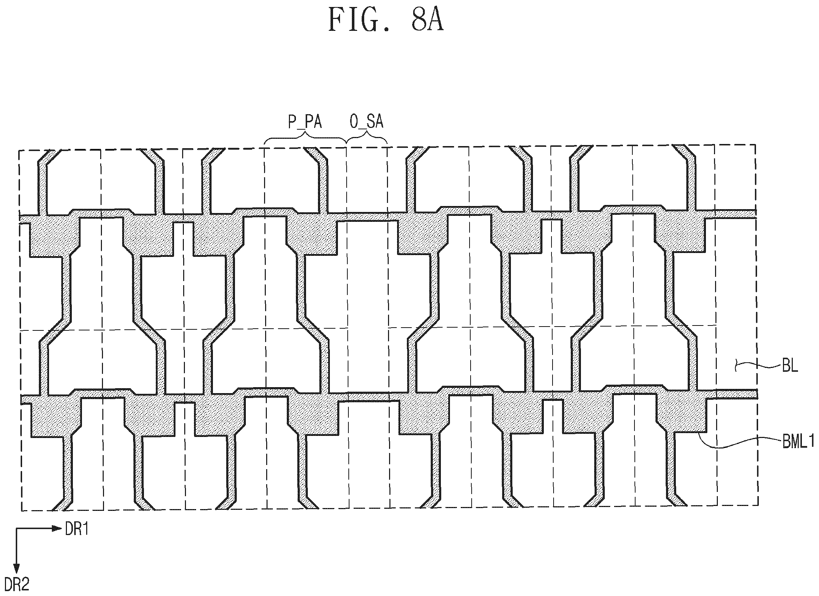

FIGS. 8A-8J are plan views illustrating a stacking process of the circuit layer.

Referring to FIGS. 8A-8J, conductive patterns and semiconductor patterns may be repeatedly arranged according to a certain rule when viewed from above the plane (e.g., in a plan view). In FIGS. 8A-8J, some of the pixel drive circuits P_PD (e.g., refer to FIG. 4A) and the sensor drive circuits O_SD (e.g., refer to FIG. 4A) disposed in two pixel rows are illustrated. Sixteen pixel drive circuits P_PD and two sensor drive circuits O_SD are provided in the two pixel rows. Sixteen first circuit regions P_PA corresponding to the sixteen pixel drive circuits P_PD and two second circuit regions O_SA corresponding to the two sensor drive circuits O_SD are defined in the two pixel rows. In FIGS. 8A-8J, the boundaries between the first and second circuit regions P_PA and O_SA are illustrated by dotted lines.

Referring to FIG. 8A, the first shielding layer BML1 may be formed on the base layer BL. The first shielding layer BML1 may be a conductive pattern having a light blocking function. The first shielding layer BML1 may be disposed under at least one of the transistors T1 to T8 (e.g., refer to FIG. 4A) included in each of the first circuit regions P_PA and may block light incident to the transistors T1 to T8 from the outside.

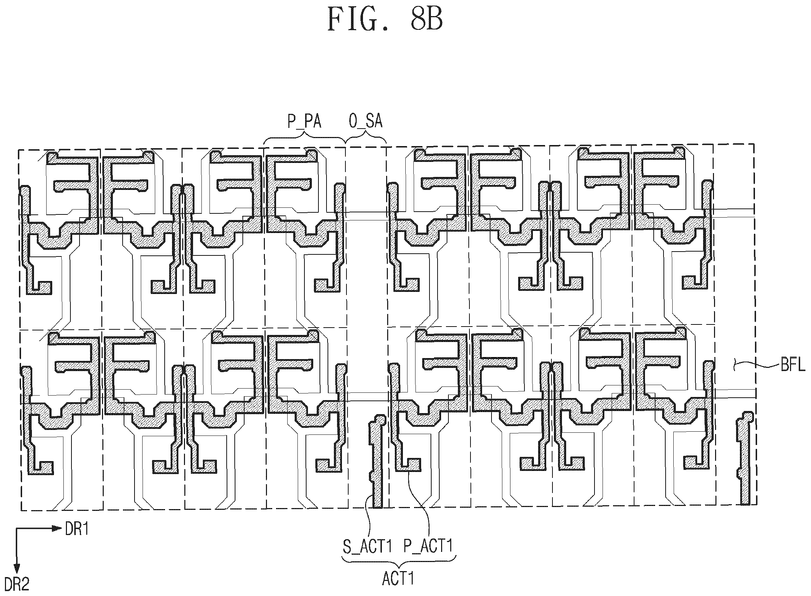

Referring to FIGS. 8A and 8B, the first shielding layer BML1 may be covered by the buffer layer BFL. A first semiconductor pattern layer ACT1 may be disposed on the buffer layer BFL. The first semiconductor pattern layer ACT1 may overlap the first shielding layer BML1 on the buffer layer BFL. The first semiconductor pattern layer ACT1 may include a silicon semiconductor. For example, the silicon semiconductor may include amorphous silicon or polycrystalline silicon. For example, the first semiconductor pattern layer ACT1 may include low-temperature polycrystalline silicon (LTPS).

The first semiconductor pattern layer ACT1 includes a first semiconductor pattern P_ACT1 disposed in each of the first circuit regions P_PA and a second semiconductor pattern S_ACT1 disposed in each of the second circuit regions O_SA.

Referring to FIG. 8C, the first gate pattern layer GAT1 may be disposed on the first insulating layer 10. The first gate pattern layer GAT1 may include metal, an alloy, conductive metal oxide, or a transparent conductive material. For example, the first gate pattern layer GAT1 may include silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), indium tin oxide (ITO), and/or indium zinc oxide (IZO), but is not particularly limited thereto.

The first gate pattern layer GAT1 may include a first gate wiring SBL, a second gate wiring EML, a third gate wiring SWL, a first gate electrode GE1, and a first sensor gate electrode SGE1.

Each of the first to third gate wirings SBL, EML, and SWL may extend in the first direction DR1. The first gate wiring SBL corresponds to the j-th black scan line SBLj of FIG. 4A. For example, the j-th black scan signal SBj (e.g., refer to FIG. 4A) may be provided to the first gate wiring SBL. The first gate wiring SBL may constitute the seventh transistor T7 and the eighth transistor T8 of FIG. 4A together with the first semiconductor pattern P_ACT1.

The second gate wiring EML corresponds to the j-th emission control line EMLj of FIG. 4A. For example, the j-th emission control signal EMj (e.g., refer to FIG. 4A) may be provided to the second gate wiring EML. The second gate wiring EML may constitute the fifth and sixth transistors T5 and T6 of FIG. 4A together with the first semiconductor pattern P_ACT1.

The third gate wiring SWL corresponds to the j-th write scan line SWLj of FIG. 4A. For example, the j-th write scan signal SWj (e.g., refer to FIG. 4A) may be provided to the third gate wiring SWL. The third gate wiring SWL may constitute the second transistor T2 of FIG. 4A together with the first semiconductor pattern P_ACT1 and may constitute the output transistor ST3 of FIG. 4A together with the second semiconductor pattern S_ACT1.

The first gate electrode GE1 and the first sensor gate electrode SGE1 may be disposed in an island shape. The first gate electrode GE1 may constitute the first transistor T1 of FIG. 4A together with the first semiconductor pattern P_ACT1. The first gate electrode GE1 may correspond to the third electrode G1 of the first transistor T1 illustrated in FIG. 6A. The first sensor gate electrode SGE1 may constitute the amplifying transistor ST2 of FIG. 4A together with the second semiconductor pattern S_ACT1.

Referring to FIGS. 8C and 8D, the second insulating layer 20 may be disposed on the first insulating layer 10 and may cover the first gate pattern layer GAT1. The second gate pattern layer GAT2 may be disposed on the second insulating layer 20. The second gate pattern layer GAT2 may include metal, an alloy, conductive metal oxide, and/or a transparent conductive material.

The second gate pattern layer GAT2 may include a horizontal voltage wiring H_VL and an upper gate electrode UGE.

The horizontal voltage wiring H_VL may extend in the first direction DR1. The horizontal voltage wiring H_VL corresponds to (or, is included in) the second drive voltage line VL2 (e.g., refer to FIG. 4A).

The upper gate electrode UGE may overlap the first gate electrode GE1 and may be disposed in an island shape. For example, the upper gate electrode UGE may constitute the capacitor Cst (e.g., refer to FIG. 4A) together with the first gate electrode GE1. The upper gate electrode UGE may correspond to the upper electrode UE illustrated in FIG. 6A. An opening UGE_OP may be formed through the upper gate electrode UGE, and the first gate electrode GE1 may be partially exposed through the opening UGE_OP. In other embodiments, the second gate pattern layer GAT2 may further include a fourth gate wiring C_SRL, a fifth gate wiring C_SCL and a sixth gate wiring C_SIL illustrated in FIG. 8E.

Referring to FIGS. 8D and 8E, the third insulating layer 30 may be disposed on the second insulating layer 20 and may cover the second gate pattern layer GAT2. The additional gate pattern layer CMTL may be disposed on the third insulating layer 30. The additional gate pattern layer CMTL may include metal, an alloy, conductive metal oxide, and/or a transparent conductive material.

The additional gate pattern layer CMTL may include the fourth gate wiring C_SRL, the fifth gate wiring C_SCL, the sixth gate wiring C_SIL, and a horizontal reset voltage wiring H_VRL.

The fourth to sixth gate wirings C_SRL, C_SCL, and C_SIL may extend in the first direction DR1. The fourth gate wiring C_SRL corresponds to (or, is included in) the reset control line SRL (e.g., refer to FIG. 4A). The fifth gate wiring C_SCL may correspond to (or, may be included in) the j-th compensation scan line SCLj (e.g., refer to FIG. 4A). The sixth gate wiring C_SIL may correspond to (or, may be included in) the j-th initialization scan line SILj (e.g., refer to FIG. 4A).

The horizontal reset voltage wiring H_VRL may be a component included in the reset voltage line VRL of FIG. 4A. The reset voltage Vrst (e.g., refer to FIG. 4A) may be provided to the horizontal reset voltage wiring H_VRL. The horizontal reset voltage wiring H_VRL may be electrically connected with the reset transistor ST1. The reset transistor ST1 may receive the reset voltage Vrst through the horizontal reset voltage wiring H_VRL.

The additional gate pattern layer CMTL may further include the second shielding layer BML2. The second shielding layer BML2 may be a portion extending from the fifth gate wiring C_SCL or the sixth gate wiring C_SIL.

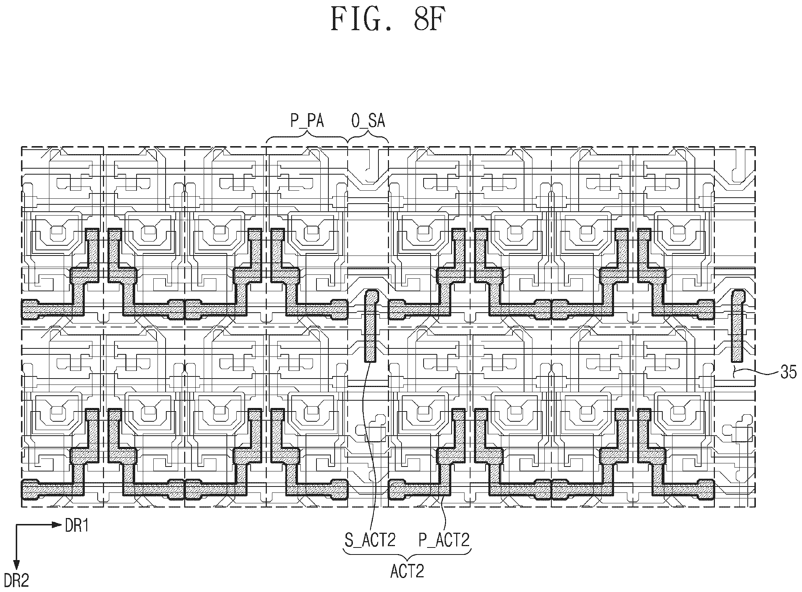

Referring to FIGS. 8E and 8F, the additional insulating layer 35 may be disposed on the third insulating layer 30 and may cover the additional gate pattern layer CMTL. A second semiconductor pattern layer ACT2 may be disposed on the additional insulating layer 35. The second semiconductor pattern layer ACT2 may include an oxide semiconductor. The second semiconductor pattern layer ACT2 may be disposed in a layer different from the first semiconductor pattern layer ACT1 and may not overlap the first semiconductor pattern layer ACT1.

The second semiconductor pattern layer ACT2 includes a third semiconductor pattern P_ACT2 disposed in each of the first circuit regions P_PA and a fourth semiconductor pattern S_ACT2 disposed in each of the second circuit regions O_SA.

Referring to FIGS. 8F and 8G, the fourth insulating layer 40 may be disposed on the additional insulating layer 35 and may cover the additional gate pattern layer CMTL. The third gate pattern layer GAT3 may be disposed on the fourth insulating layer 40. The third gate pattern layer GAT3 may include metal, an alloy, conductive metal oxide, and/or a transparent conductive material.

The third gate pattern layer GAT3 may include the seventh gate wiring G3_SRL, the eighth gate wiring G3_SCL, the ninth gate wiring G3_SIL, a second-first horizontal initialization voltage line H_VAIL1, and a second-second horizontal initialization voltage line H_VAIL2. The second-first horizontal initialization voltage line H_VAIL1 and the second-second horizontal initialization voltage line H_VAIL2 may be referred to as a second horizontal initialization voltage line.

The seventh to ninth gate wirings G3_SRL, G3_SCL, and G3_SIL may extend in the first direction DR1. The seventh gate wiring G3_SRL may overlap the fourth semiconductor pattern S_ACT2. The seventh gate wiring G3_SRL may constitute the reset transistor ST1 of FIG. 4A together with the fourth semiconductor pattern S_ACT2. The seventh gate wiring G3_SRL may be electrically connected with the fourth gate wiring C_SRL illustrated in FIG. 8E.

The eighth gate wiring G3_SCL may overlap the fifth gate wiring C_SCL and the third semiconductor pattern P_ACT2. In some embodiments, the eighth gate wiring G3_SCL may make contact with the fifth gate wiring C_SCL through a contact portion. Accordingly, the j-th compensation scan signal SCj applied to the fifth gate wiring C_SCL may be provided to the eighth gate wiring G3_SCL. The fifth gate wiring C_SCL, the third semiconductor pattern P_ACT2, and the eighth gate wiring G3_SCL may constitute the third transistor T3 of FIG. 4A.

The ninth gate wiring G3_SIL may overlap the sixth gate wiring C_SIL and the third semiconductor pattern P_ACT2. The ninth gate wiring G3_SIL may be electrically connected with the sixth gate wiring C_SIL. The j-th initialization scan signal SIj may be provided to the ninth gate wiring G3_SIL through the sixth gate wiring C_SIL. The sixth gate wiring C_SIL, the third semiconductor pattern P_ACT2, and the ninth gate wiring G3_SIL may constitute the fourth transistor T4 of FIG. 4A.

The second-first horizontal initialization voltage line H_VAIL1 and the second-second horizontal initialization voltage line H_VAIL2 may be components included in the second initialization voltage line VAIL (e.g., refer to FIG. 4A). The second-first horizontal initialization voltage line H_VAIL1 is connected to a first color pixel (e.g., a red pixel) from among the plurality of pixels PX illustrated in FIG. 3, and the second-second horizontal initialization voltage line H_VAIL2 is connected to a second and/or third color pixel (e.g., a blue and/or green pixel) different from the first color pixel from among the plurality of pixels PX.

The second-first horizontal initialization voltage line H_VAIL1 applies a second-first initialization voltage to the first color pixel as the second initialization voltage Vaint (e.g., refer to FIG. 4A), and the second-second horizontal initialization voltage line H_VAIL2 applies a second-second initialization voltage to the second or third color pixel as the second initialization voltage Vaint. The second-second initialization voltage may have a voltage level different from the voltage level of the second-first initialization voltage.

Referring to FIGS. 8G and 8H, the fifth insulating layer 50 may be disposed on the fourth insulating layer 40 and may cover at least a portion of the third gate pattern layer GAT3. The first data pattern layer SD1 may be disposed on the fifth insulating layer 50. The first data pattern layer SD1 may include, for example, metal, an alloy, conductive metal oxide, and/or a transparent conductive material. Hereinafter, for convenience of description, only some of the components included in the first data pattern layer SD1 are illustrated in FIG. 8H.

The first data pattern layer SD1 may include a first horizontal initialization voltage line H_VIL, a bias voltage line D1_VBL, and a plurality of first connecting electrode patterns C_CNE1.

The first horizontal initialization voltage line H_VIL and the bias voltage line D1_VBL may extend in the first direction DR1. The first horizontal initialization voltage line H_VIL and the bias voltage line D1_VBL may be spaced (e.g., spaced apart) from each other in the second direction DR2.

The first horizontal initialization voltage line H_VIL may be a component included in the first initialization voltage line VIL of FIG. 4A. The first initialization voltage Vint (e.g., refer to FIG. 4A) may be provided to the first horizontal initialization voltage line H_VIL. The first horizontal initialization voltage line H_VIL may be connected with the fourth transistor T4 through a contact portion. The fourth transistor T4 may receive the first initialization voltage Vint through the first horizontal initialization voltage line H_VIL.

The bias voltage line D1_VBL may correspond to the bias voltage line VBL of FIG. 4A. The bias voltage Vbias (e.g., refer to FIG. 4A) may be provided to the bias voltage line D1_VBL. The bias voltage line D1_VBL may be connected with the eighth transistor T8 through a contact portion. The eighth transistor T8 may receive the bias voltage Vbias through the bias voltage line D1_VBL.

The plurality of first connecting electrode patterns C_CNE1 may make contact with one of the first to fourth semiconductor patterns P_ACT1, S_ACT1, P_ACT2, and S_ACT2. The plurality of first connecting electrode patterns C_CNE1 may perform a function of electrically connecting one of the first to fourth semiconductor patterns P_ACT1, S_ACT1, P_ACT2, and S_ACT2 to other wiring or lines. The plurality of first connecting electrode patterns C_CNE1 may be connected with one of the first to fourth semiconductor patterns P_ACT1, S_ACT1, P_ACT2, and S_ACT2 through a contact portion. The plurality of first connecting electrode patterns C_CNE1 may include the first and third connecting electrodes CNE10 and CNE11 illustrated in FIGS. 6A and 6B.

The first data pattern layer SD1 may further include a horizontal connecting wiring D1_HCL. The horizontal connecting wiring D1_HCL may extend in the first direction DR1. The horizontal connecting wiring D1_HCL may be a component used as the horizontal data connecting lines H_DCL illustrated in FIG. 7 or the horizontal connecting lines H_RL illustrated in FIG. 7.

Referring to FIGS. 8H and 8I, the sixth insulating layer 60 may be disposed on the fifth insulating layer 50 and may cover at least a portion of the first data pattern layer SD1. The second data pattern layer SD2 may be disposed on the sixth insulating layer 60. The second data pattern layer SD2 may include, for example, metal, an alloy, conductive metal oxide, and/or a transparent conductive material.

The second data pattern layer SD2 includes a readout wiring RL, a first drive voltage line VL1, and a plurality of voltage connecting patterns C_VP.

The readout wiring RL extends in the second direction DR2 in each of the second circuit regions O_SA. That is, the readout wiring RL may overlap the plurality of second circuit regions O_SA. The readout wiring RL may be connected to the sensor drive circuit O_SD illustrated in FIG. 4A (for example, the output transistor ST3).

The first drive voltage line VL1 may overlap the first circuit regions P_PA. The first drive voltage line VL1 may correspond to the first drive voltage line VL1 of FIG. 4A. The first drive voltage ELVDD (e.g., refer to FIG. 4A) may be provided to the first drive voltage line VL1. The first drive voltage line VL1 may be disposed in a mesh form in the display region DA (e.g., refer to FIG. 3) of the display panel DP. The first drive voltage line VL1 may be connected with the fifth transistor T5 and the capacitor Cst, which are illustrated in FIG. 4A, through a contact portion.

The plurality of voltage connecting patterns C_VP may be connected with vertical voltage wirings V_VL that will be described below.

The second data pattern layer SD2 may further include a plurality of second connecting electrode patterns C_CNE2. The plurality of second connecting electrode patterns C_CNE2 may include the second and fourth connecting electrodes CNE20 and CNE21 illustrated in FIGS. 6A and 6B.

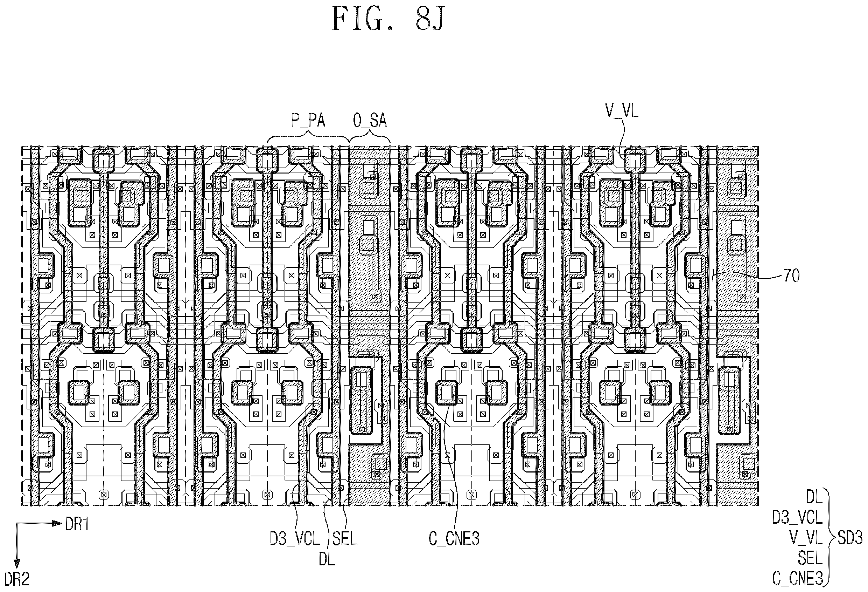

Referring to FIGS. 8I and 8J, the seventh insulating layer 70 may be disposed on the sixth insulating layer 60 and may cover at least a portion of the second data pattern layer SD2. A third data pattern layer SD3 may be disposed on the seventh insulating layer 70. The third data pattern layer SD3 may include, for example, metal, an alloy, conductive metal oxide, and/or a transparent conductive material.

The third data pattern layer SD3 may include a data wiring DL, a vertical connecting wiring D3_VCL, a shielding electrode wiring SEL, the vertical voltage wirings V_VL, and a plurality of third connecting electrode patterns C_CNE3.

The data wiring DL, the vertical connecting wiring D3_VCL, and the vertical voltage wirings V_VL may extend in the second direction DR2. The data wiring DL, the vertical connecting wiring D3_VCL, and the vertical voltage wirings V_VL may be spaced (e.g., spaced apart) from each other in the first direction DR1.

The data wiring DL may correspond to the data lines DL1 to DLm illustrated in FIG. 3. The data wiring DL may be connected to the pixel drive circuit P_PD illustrated in FIG. 4A (for example, the second transistor T2). The vertical connecting wiring D3_VCL may be a component used as the vertical data connecting lines V_DCL illustrated in FIG. 7 or the vertical connecting lines V_RL illustrated in FIG. 7. The vertical connecting wiring D3_VCL may be electrically connected with the horizontal connecting wiring D1_HCL illustrated in FIG. 8H.

One of the vertical voltage wirings V_VL may be electrically connected to the second-first horizontal initialization voltage line H_VAIL1, which is illustrated in FIG. 8G, through a corresponding voltage connecting pattern C_VP (e.g., refer to FIG. 8I), and another one of the vertical voltage wirings V_VL may be electrically connected to the second-second horizontal initialization voltage line H_VAIL2, which is illustrated in FIG. 8G, through a corresponding voltage connecting pattern C_VP. That is, one of the vertical voltage wirings V_VL may be used as the second initialization voltage line VAIL (e.g., refer to FIG. 4A). In addition, another one of the vertical voltage wirings V_VL may be electrically connected to the first horizontal initialization voltage line H_VIL, which is illustrated in FIG. 8H, through a corresponding voltage connecting pattern C_VP (e.g., refer to FIGS. 8I) and may be used as the first initialization voltage line VIL (e.g., refer to FIG. 4A).

A part of the vertical voltage wirings V_VL may be connected with the horizontal voltage wiring H_VL illustrated in FIG. 8D and may be used as the second drive voltage line VL2 of FIG. 4A. As described above, the vertical voltage wirings V_VL may be used as different voltage lines connected to the pixels PX (e.g., refer to FIG. 3) and the sensors FX (e.g., refer to FIG. 3) and may alleviate a drop in the voltages applied to the respective voltage lines.

The plurality of third connecting electrode patterns C_CNE3 may include the fifth connecting electrode CNE30 and the sixth connecting electrode CNE31 illustrated in FIGS. 6A and 6B.

The shielding electrode wiring SEL may overlap the readout wiring RL when viewed from above the plane (e.g., in a plan view). The shielding electrode wiring SEL may make contact with the horizontal reset voltage wiring H_VRL through a contact portion. Accordingly, the reset voltage Vrst (e.g., refer to FIG. 4A) applied to the horizontal reset voltage wiring H_VRL may be applied to the shielding electrode wiring SEL.

The shielding electrode wiring SEL may be disposed to partially cover the sensor drive circuit O_SD in each of the second circuit regions O_SA. For example, the shielding electrode wiring SEL may be disposed to cover all or part of the reset transistor ST1 (e.g., refer to FIG. 4A), the amplifying transistor ST2, and the output transistor ST3.

The shielding electrode wiring SEL may perform a shielding function such that a detection signal output from the readout wiring RL is not coupled by a data signal applied to the data wiring DL.

Referring to FIGS. 8J and 6A, the eighth insulating layer 80 may be disposed on the seventh insulating layer 70 and may cover at least a portion of the third data pattern layer SD3. The anode electrode P_AE and the sensor anode electrode O_AE may be disposed on the eighth insulating layer 80. The anode electrode P_AE and the sensor anode electrode O_AE may include metal, an alloy, conductive metal oxide, and/or a transparent conductive material.

One sensor FX may be disposed per two reference pixel units RPU, and the horizontal reset voltage wiring H_VRL and the fourth gate wiring C_SRL may be alternately arranged in units of one pixel row. Accordingly, as compared with when the horizontal reset voltage wiring H_VRL and the fourth gate wiring C_SRL are disposed in each pixel row, the total number of horizontal reset voltage wirings H_VRL and fourth gate wirings C_SRL in the display panel DP may be reduced by one half, and thus the display resolution of the display panel DP in the second direction DR2 may be increased.

FIGS. 9A and 9B are plan views illustrating a stacking process of the circuit layer.

Referring to FIGS. 6B, 8E, and 9A, the fourth insulating layer 40 may be disposed on the third insulating layer 30 and may cover the second gate pattern layer GAT2. The third gate pattern layer GAT3a may be disposed on the fourth insulating layer 40.

The third gate pattern layer GAT3a may include the fourth gate wiring G3_SRLa, the fifth gate wiring G3_SCLa, the sixth gate wiring G3_SILa, a second-first horizontal initialization voltage line H_VAIL1a, and a second-second horizontal initialization voltage line H_VAIL2a. The second-first horizontal initialization voltage line H_VAIL1a and the second-second horizontal initialization voltage line H_VAIL2a may be referred to as a second horizontal initialization voltage line.

The fourth to sixth gate wirings G3_SRLa, G3_SCLa, and G3_SILa may extend in the first direction DR1. The fourth gate wiring G3_SRLa corresponds to (or, is included in) the reset control line SRL (e.g., refer to FIG. 4A). The fifth gate wiring G3_SCLa may correspond to (or, may be included in) the j-th compensation scan line SCLj (e.g., refer to FIG. 4A). The sixth gate wiring G3_SILa may correspond to (or, may be included in) the j-th initialization scan line SILj (e.g., refer to FIG. 4A).

The second-first horizontal initialization voltage line H_VAIL1a and the second-second horizontal initialization voltage line H_VAIL2a may be components included in the second initialization voltage line VAIL (e.g., refer to FIG. 4A). The second-first horizontal initialization voltage line H_VAIL1a is connected to a first color pixel (e.g., a red pixel) from among the plurality of pixels PX illustrated in FIG. 3, and the second-second horizontal initialization voltage line H_VAIL2a is connected to a second and/or third color pixel (e.g., a blue and/or green pixel) different from the first color pixel from among the plurality of pixels PX.

The second-first horizontal initialization voltage line H_VAIL1a applies a second-first initialization voltage to the first color pixel as the second initialization voltage Vaint (e.g., refer to FIG. 4A), and the second-second horizontal initialization voltage line H_VAIL2a applies a second-second initialization voltage to the second or third color pixel as the second initialization voltage Vaint. The second-second initialization voltage may have a voltage level different from the voltage level of the second-first initialization voltage.

Referring to FIGS. 6B, 9A, and 9B, the additional insulating layer 45 may be disposed on the fourth insulating layer 40 and may cover the third gate pattern layer GAT3a. The additional gate pattern layer CMTLa may be disposed on the additional insulating layer 45. The additional gate pattern layer CMTLa may include metal, an alloy, conductive metal oxide, and/or a transparent conductive material.

The additional gate pattern layer CMTLa may include the seventh gate wiring C_SRLa, the eighth gate wiring C_SCLa, the ninth gate wiring C_SILa, and a horizontal reset voltage wiring H_VRLa.

The seventh to ninth gate wirings C_SRLa, C_SCLa, and C_SILa may extend in the first direction DR1. The seventh gate wiring C_SRLa may overlap the fourth semiconductor pattern S_ACT2. The seventh gate wiring C_SRLa may constitute the reset transistor ST1 of FIG. 4A together with the fourth semiconductor pattern S_ACT2. The seventh gate wiring C_SRLa may be electrically connected with the fourth gate wiring G3_SRLa illustrated in FIG. 9A.

The eighth gate wiring C_SCLa may overlap the fifth gate wiring G3_SCLa and the third semiconductor pattern P_ACT2. In some embodiments, the eighth gate wiring C_SCLa may make contact with the fifth gate wiring G3_SCLa through a contact portion. Accordingly, the j-th compensation scan signal SCj applied to the fifth gate wiring G3_SCLa may be provided to the eighth gate wiring C_SCLa.

The ninth gate wiring C_SILa may overlap the sixth gate wiring G3_SILa and the third semiconductor pattern P_ACT2. The ninth gate wiring C_SILa may be electrically connected with the sixth gate wiring G3_SILa. The j-th initialization scan signal SIj may be provided to the ninth gate wiring C_SILa through the sixth gate wiring G3_SILa.

The horizontal reset voltage wiring H_VRLa may be a component included in the reset voltage line VRL of FIG. 4A. The reset voltage Vrst (e.g., refer to FIG. 4A) may be provided to the horizontal reset voltage wiring H_VRLa. The horizontal reset voltage wiring H_VRLa may be electrically connected with the reset transistor ST1.

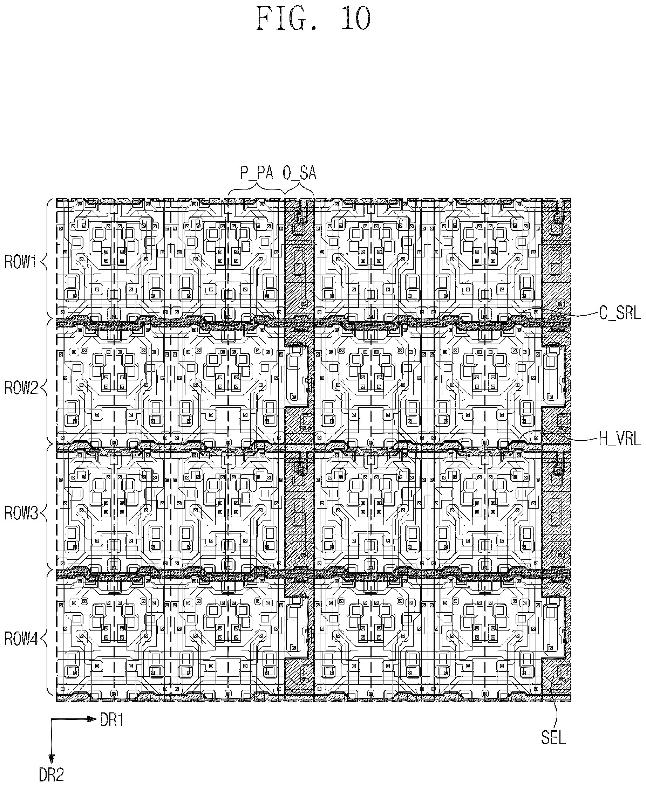

FIG. 10 is a plan view illustrating an arrangement structure of reset control lines and reset voltage lines. Although a plurality of pixel rows is disposed in the display panel DP (e.g., refer to FIG. 3), only four pixel rows ROW1 to ROW4 (hereinafter, referred to as the first to fourth pixel rows) are illustrated in FIG. 10 for convenience of description.

Referring to FIG. 10, the horizontal reset voltage wiring H_VRL is disposed in the first and third pixel rows ROW1 and ROW3, and the fourth gate wiring C_SRL constituting the reset control line SRL (e.g., refer to FIG. 4A) is disposed in the second and fourth pixel rows ROW2 and ROW4. The horizontal reset voltage wiring H_VRL and the fourth gate wiring C_SRL extend in the first direction DR1. The first and third pixel rows ROW1 and ROW3 may be odd-numbered pixel rows, and the second and fourth pixel rows ROW2 and ROW4 may be even-numbered pixel rows. However, the present disclosure is not limited thereto. Alternatively, the first and third pixel rows ROW1 and ROW3 may be even-numbered pixel rows, and the second and fourth pixel rows ROW2 and ROW4 may be odd-numbered pixel rows.

The horizontal reset voltage wiring H_VRL and the fourth gate wiring C_SRL may be alternately disposed in units of one pixel row. Accordingly, as compared with when the horizontal reset voltage wiring H_VRL and the fourth gate wiring C_SRL are disposed in each pixel row, the total number of horizontal reset voltage wirings H_VRL and fourth gate wirings C_SRL in the display panel DP may be reduced by one half. Thus, the resolution of the display panel DP in the second direction DR2 may be increased.

The horizontal reset voltage wiring H_VRL may be connected with the shielding electrode wiring SEL extending in the second direction DR2. The horizontal reset voltage wiring H_VRL and the shielding electrode wiring SEL may be included in the configuration of the reset voltage line VRL illustrated in FIG. 4A. The reset voltage line VRL illustrated in FIG. 4A may be disposed in a mesh form in the display panel DP (e.g., refer to FIG. 3) by the horizontal reset voltage wiring H_VRL and the shielding electrode wiring SEL.

Because the reset voltage line VRL is disposed in the mesh structure in the display panel DP (e.g., refer to FIG. 3) as described above, the reset voltage Vrst (e.g., refer to FIG. 4A) may be uniformly supplied to all of the sensors FX disposed in the display panel DP. Accordingly, degradation in sensing accuracy due to a voltage drop of the reset voltage Vrst may be prevented.

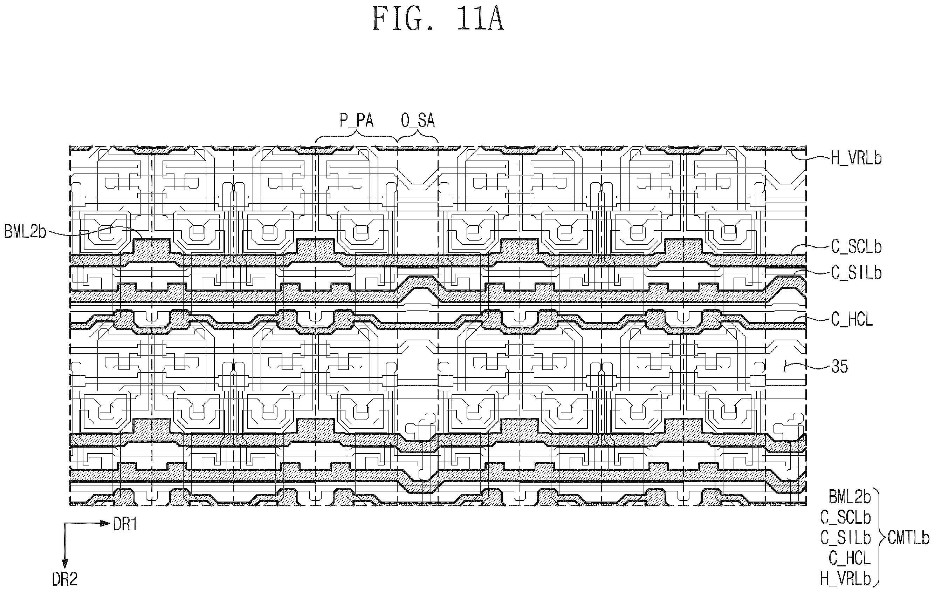

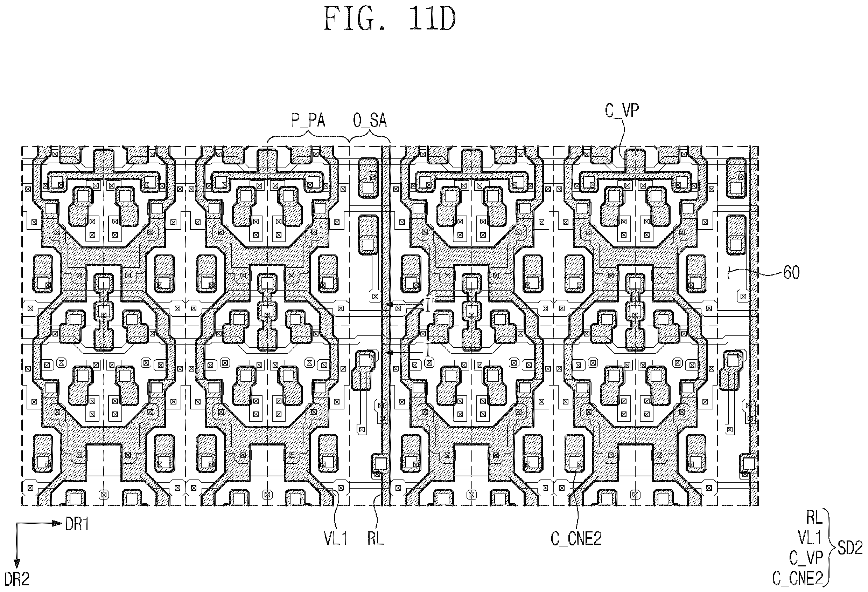

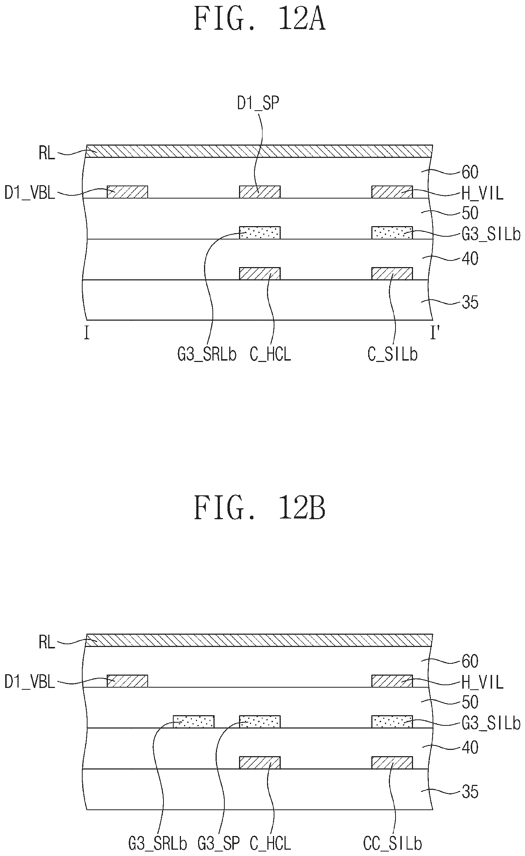

FIGS. 11A-11E are plan views illustrating a stacking process of the circuit layer. FIG. 12A is a sectional view taken along the line I-I' illustrated in FIG. 11D. FIG. 12B is a sectional view of the display panel.

Referring to FIGS. 8E and 11A, the additional insulating layer 35 may be disposed on the third insulating layer 30 and may cover the second semiconductor pattern layer ACT2. An additional gate pattern layer CMTLb may be disposed on the additional insulating layer 35.

The additional gate pattern layer CMTLb may include a second shielding layer BML2b, a fourth gate wiring C_SCLb, a fifth gate wiring C_SILb, a horizontal connecting wiring C_HCL, and a horizontal reset voltage wiring H_VRLb.

The fourth and fifth gate wirings C_SCLb and C_SILb may extend in the first direction DR1. The fourth gate wiring C_SCLb may correspond to (or, may be included in) the j-th compensation scan line SCLj (e.g., refer to FIG. 4A). The fifth gate wiring C_SILb may correspond to (or, may be included in) the j-th initialization scan line SILj (e.g., refer to FIG. 4A).

The horizontal reset voltage wiring H_VRLb may be a component included in the reset voltage line VRL of FIG. 4A. The reset voltage Vrst (e.g., refer to FIG. 4A) may be provided to the horizontal reset voltage wiring H_VRLb.

The horizontal connecting wiring C_HCL may extend in the first direction DR1 and may be spaced (e.g., spaced apart) from the fourth and fifth gate wirings C_SCLb and C_SILb in the second direction DR2. The horizontal connecting wiring C_HCL may be a component used as the horizontal data connecting lines H_DCL illustrated in FIG. 7 or the horizontal connecting lines H_RL illustrated in FIG. 7.

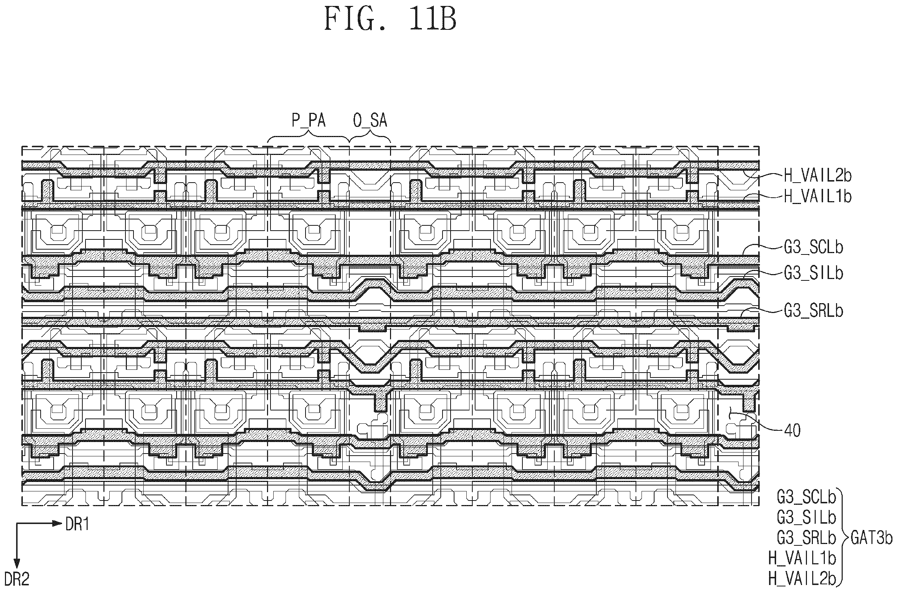

Referring to FIGS. 11A, 8F, and 11B, the fourth insulating layer 40 may be disposed on the additional insulating layer 35 and may cover the additional gate pattern layer CMTLb. A third gate pattern layer GAT3b may be disposed on the fourth insulating layer 40.

The third gate pattern layer GAT3b may include a sixth gate wiring G3_SRLb, a seventh gate wiring G3_SCLb, an eighth gate wiring G3_SILb, a second-first horizontal initialization voltage line H_VAIL1b, and a second-second horizontal initialization voltage line H_VAIL2b.

The sixth to eighth gate wirings G3_SRLb, G3_SCLb, and G3_SILb may extend in the first direction DR1. The sixth gate wiring G3_SRLb may overlap the fourth semiconductor pattern S_ACT2 (e.g., refer to FIG. 8F). The sixth gate wiring G3_SRLb may constitute the reset transistor ST1 of FIG. 4A together with the fourth semiconductor pattern S_ACT2.

The seventh gate wiring G3_SCLb may overlap the fourth gate wiring C_SCLb and the third semiconductor pattern P_ACT2 (e.g., refer to FIG. 8F). In some embodiments, the seventh gate wiring G3_SCLb may make contact with the fourth gate wiring C_SCLb through a contact portion. Accordingly, the j-th compensation scan signal SCj applied to the fourth gate wiring C_SCLb may be provided to the seventh gate wiring G3_SCLb. The fourth gate wiring C_SCLb, the third semiconductor pattern P_ACT2, and the seventh gate wiring G3_SCLb may constitute the third transistor T3 of FIG. 4A.

The eighth gate wiring G3_SILb may overlap the fifth gate wiring C_SILb and the third semiconductor pattern P_ACT2. The eighth gate wiring G3_SILb may be electrically connected with the fifth gate wiring C_SILb. The j-th initialization scan signal SIj may be provided to the eighth gate wiring G3_SILb through the fifth gate wiring C_SILb. The fifth gate wiring C_SILb, the third semiconductor pattern P_ACT2, and the eighth gate wiring G3_SILb may constitute the fourth transistor T4 of FIG. 4A.

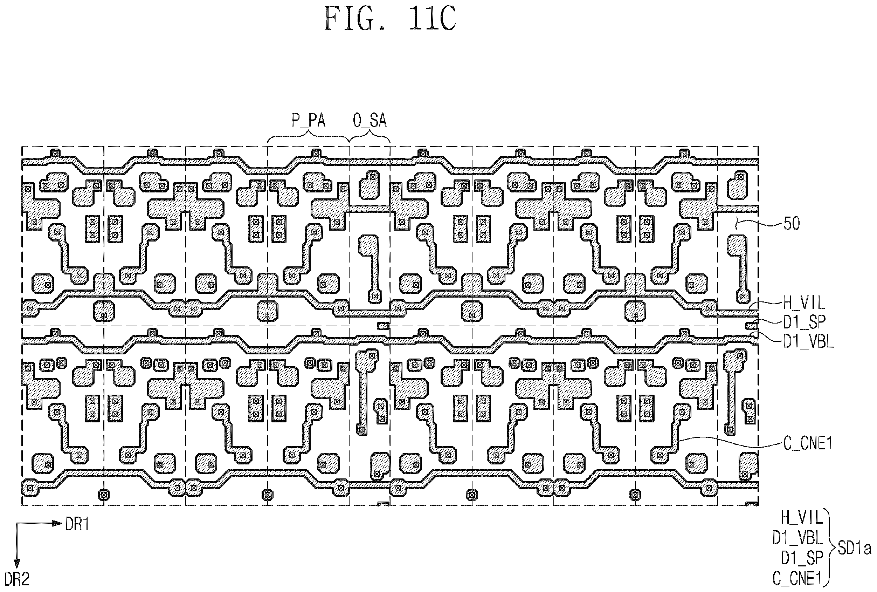

Referring to FIGS. 11B and 11C, the fifth insulating layer 50 may be disposed on the fourth insulating layer 40 and may cover at least a portion of the third gate pattern layer GAT3b. A first data pattern layer SD1a may be disposed on the fifth insulating layer 50.

The first data pattern layer SD1a may include a first horizontal initialization voltage line H_VIL, a bias voltage line D1_VBL, and a plurality of first connecting electrode patterns C_CNE1.

The first horizontal initialization voltage line H_VIL and the bias voltage line D1_VBL may extend in the first direction DR1. The first horizontal initialization voltage line H_VIL and the bias voltage line D1_VBL may be spaced (e.g., spaced apart) from each other in the second direction DR2.

The first horizontal initialization voltage line H_VIL may be a component included in the first initialization voltage line VIL of FIG. 4A. The first initialization voltage Vint (e.g., refer to FIG. 4A) may be provided to the first horizontal initialization voltage line H_VIL. The bias voltage line D1_VBL may correspond to the bias voltage line VBL of FIG. 4A. The bias voltage Vbias (e.g., refer to FIG. 4A) may be provided to the bias voltage line D1_VBL.

The plurality of first connecting electrode patterns C_CNE1 may make contact with one of the first to fourth semiconductor patterns P_ACT1, S_ACT1, P_ACT2, and S_ACT2. The plurality of first connecting electrode patterns C_CNE1 may perform a function of electrically connecting one of the first to fourth semiconductor patterns P_ACT1, S_ACT1, P_ACT2, and S_ACT2 to other wiring or lines.

The first data pattern layer SD1a may further include a shielding pattern D1_SP. In the second circuit region O_SA, the shielding pattern D1_SP may be disposed between the first horizontal initialization voltage line H_VIL and the bias voltage line D1_VBL.

Referring to FIGS. 11C, 11D, and 12A, the sixth insulating layer 60 may be disposed on the fifth insulating layer 50 and may cover at least a portion of the first data pattern layer SD1a. A second data pattern layer SD2 may be disposed on the sixth insulating layer 60.

The second data pattern layer SD2 includes a readout wiring RL, a first drive voltage line VL1, and a plurality of voltage connecting patterns C_VP.

The readout wiring RL extends in the second direction DR2 in each of the second circuit regions O_SA. That is, the readout wiring RL may overlap the plurality of second circuit regions O_SA. The readout wiring RL may overlap the shielding pattern D1_SP in each of the second circuit regions O_SA. The shielding pattern D1_SP is disposed between the readout wiring RL and the horizontal connecting wiring C_HCL at the point where the readout wiring RL and the horizontal connecting wiring C_HCL cross each other.

The shielding pattern D1_SP may shield the horizontal connecting wiring C_HCL such that a detection signal output from the readout wiring RL is not coupled by a data signal applied through the horizontal connecting wiring C_HCL. Accordingly, distortion of the detection signal may be prevented, and thus the sensing reliability of the sensors FX may be improved.

Alternatively, referring to FIG. 12B, the third gate pattern layer GAT3b may include a shielding pattern G3_SP. Although the shielding pattern D1_SP of FIG. 12A is disposed on the fifth insulating layer 50, the shielding pattern G3_SP of FIG. 12B may be disposed on the fourth insulating layer 40.

The readout wiring RL may overlap the shielding pattern G3_SP in each of the second circuit regions O_SA. The shielding pattern G3_SP is disposed between the readout wiring RL and the horizontal connecting wiring C_HCL at the point where the readout wiring RL and the horizontal connecting wiring C_HCL cross each other.

The shielding pattern G3_SP may shield the horizontal connecting wiring C_HCL such that a detection signal output from the readout wiring RL is not coupled by a data signal applied through the horizontal connecting wiring C_HCL. Thus, the sensing reliability of the sensors FX may be improved.

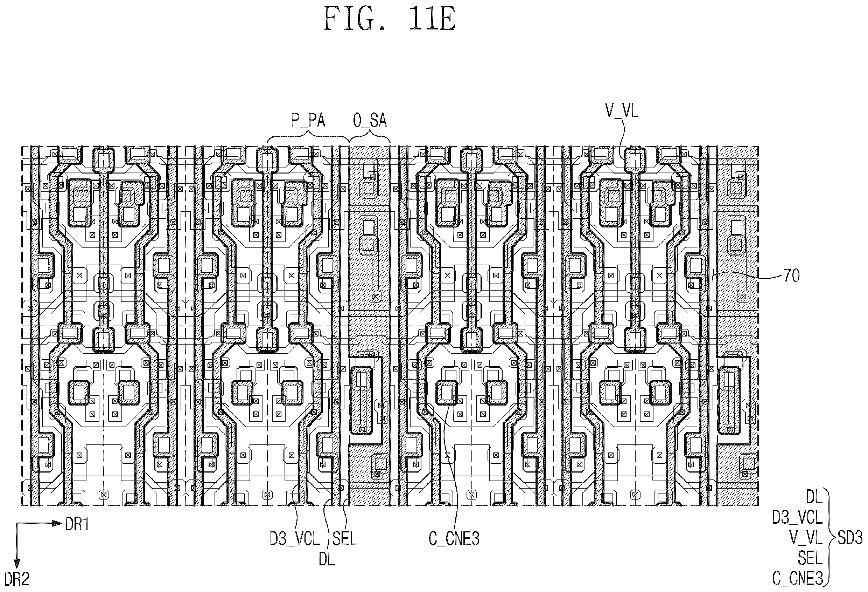

Referring to FIGS. 11D and 11E, the seventh insulating layer 70 may be disposed on the sixth insulating layer 60 and may cover at least a portion of the second data pattern layer SD2. A third data pattern layer SD3 may be disposed on the seventh insulating layer 70.

The third data pattern layer SD3 may include a data wiring DL, a vertical connecting wiring D3_VCL, a shielding electrode wiring SEL, a vertical voltage wiring V_VL, and a plurality of third connecting electrode patterns C_CNE3.

Although the structure in which the additional pattern layer CMTLb is disposed below the third gate pattern layer GAT3b is illustrated in FIGS. 11A-11E, the present disclosure is not limited thereto. For example, the additional pattern layer CMTLb may be disposed above the third gate pattern layer GAT3b.

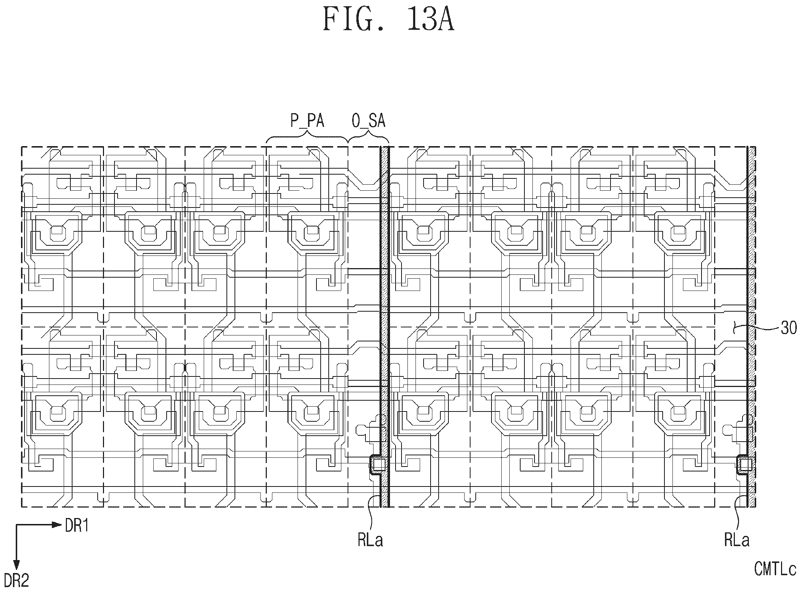

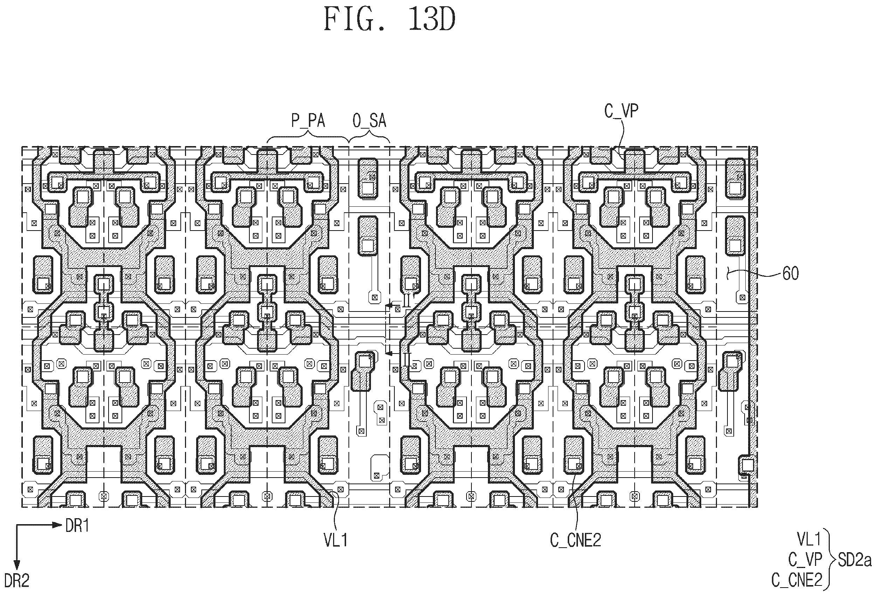

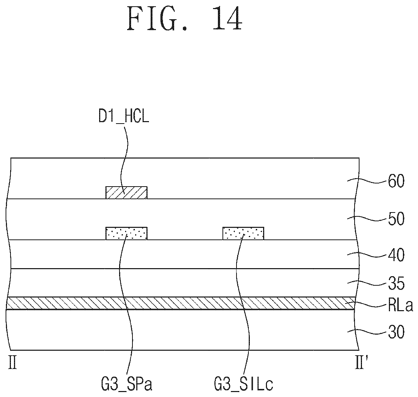

FIGS. 13A-13E are plan views illustrating a stacking process of the circuit layer. FIG. 14 is a sectional view taken along the line II-II' illustrated in FIG. 13D.

Referring to FIG. 13A, an additional gate pattern layer CMTLc may be disposed on the third insulating layer 30.

The additional gate pattern layer CMTLc may include a readout wiring RLa. The readout wiring RLa extends in the second direction DR2 in each of the second circuit regions O_SA. That is, the readout wiring RLa may overlap the plurality of second circuit regions O_SA. The readout wiring RLa may be connected to the sensor drive circuit O_SD illustrated in FIG. 4A (for example, the output transistor ST3).

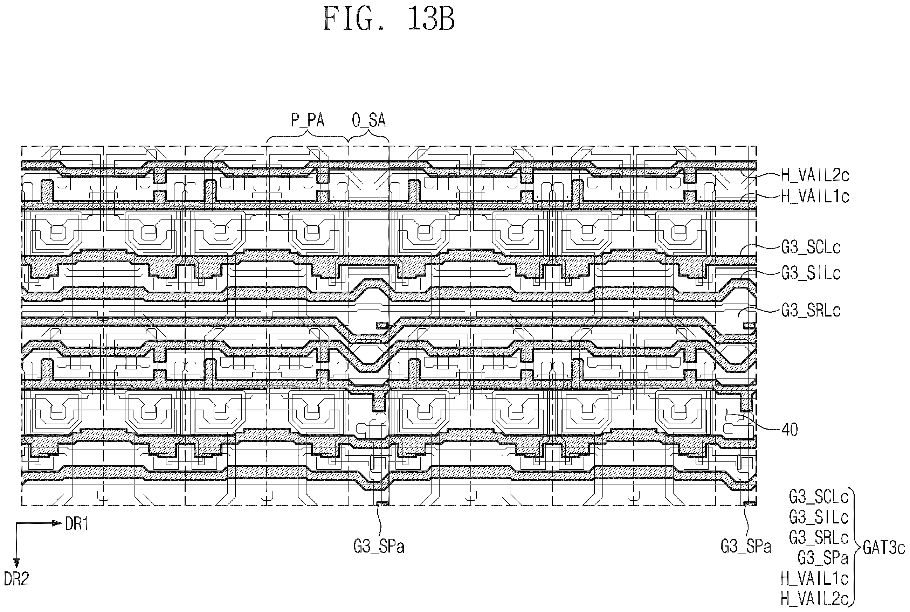

Referring to FIGS. 13A and 13B, the fourth insulating layer 40 may be disposed on the additional insulating layer 35 (e.g., refer to FIG. 6A) and may cover the additional gate pattern layer CMTLc. A third gate pattern layer GAT3c may be disposed on the fourth insulating layer 40.

The third gate pattern layer GAT3c may include a fourth gate wiring G3_SRLc, a fifth gate wiring G3_SCLc, a sixth gate wiring G3_SILc, a second-first horizontal initialization voltage line H_VAIL1c, a second-second horizontal initialization voltage line H_VAIL2c, and a shielding pattern G3_SPa.

The fourth to sixth gate wirings G3_SRLc, G3_SCLc, and G3_SILc may extend in the first direction DR1. The fourth gate wiring G3_SRLc may overlap the fourth semiconductor pattern S_ACT2. The fourth gate wiring G3_SRLc may constitute the reset transistor ST1 of FIG. 4A together with the fourth semiconductor pattern S_ACT2.

The fifth gate wiring G3_SCLc may overlap the third semiconductor pattern P_ACT2. In some embodiments, the fifth gate wiring G3_SCLc may correspond to (or, may be included in) the j-th compensation scan line SCLj (e.g., refer to FIG. 4A). Accordingly, the j-th compensation scan signal SCj may be provided to the fifth gate wiring G3_SCLc. The third semiconductor pattern P_ACT2 and the fifth gate wiring G3_SCLc may constitute the third transistor T3 of FIG. 4A.

The sixth gate wiring G3_SILc may overlap the third semiconductor pattern P_ACT2. The sixth gate wiring G3_SILc may correspond to (or, may be included in) the j-th initialization scan line SILj (e.g., refer to FIG. 4A). Accordingly, the j-th initialization scan signal SIj may be provided to the sixth gate wiring G3_SILc.

The shielding pattern G3_SPa may be disposed between the fourth and sixth gate wirings G3_SRLc and G3_SILc. The readout wiring RLa may overlap the shielding pattern G3_SPa in each of the second circuit regions O_SA.

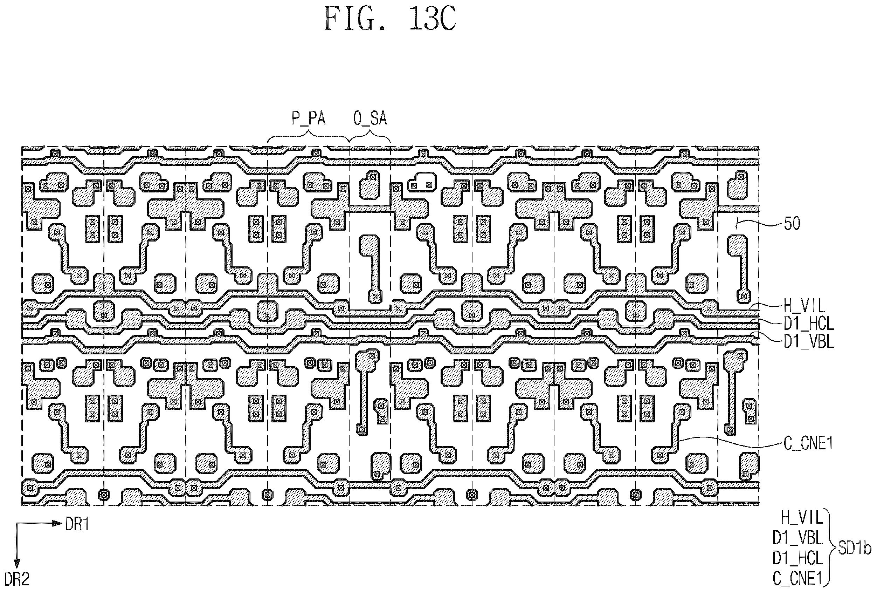

Referring to FIGS. 13B, 13C, and 14, the fifth insulating layer 50 may be disposed on the fourth insulating layer 40 and may cover at least a portion of the third gate pattern layer GAT3c. A first data pattern layer SD1b may be disposed on the fifth insulating layer 50.

The first data pattern layer SD1b may include a horizontal connecting wiring D1_HCL, a first horizontal initialization voltage line H_VIL, a bias voltage line D1_VBL, and a plurality of first connecting electrode patterns C_CNE1.

The horizontal connecting wiring D1_HCL may extend in the first direction DR1 and may cross the readout wiring RLa.

The shielding pattern G3_SPa is disposed between the readout wiring RLa and the horizontal connecting wiring D1_HCL at the point where the readout wiring RLa and the horizontal connecting wiring D1_HCL cross each other. The shielding pattern G3_SPa may shield the horizontal connecting wiring D1_HCL such that a detection signal output from the readout wiring RLa is not coupled by a data signal applied through the horizontal connecting wiring D1_HCL. Thus, the sensing reliability of the sensors FX may be improved.

Referring to FIGS. 13C and 13D, the sixth insulating layer 60 may be disposed on the fifth insulating layer 50 and may cover at least a portion of the first data pattern layer SD1b. A second data pattern layer SD2a may be disposed on the sixth insulating layer 60.

The second data pattern layer SD2a includes a first drive voltage line VL1 and a plurality of voltage connecting patterns C_VP.

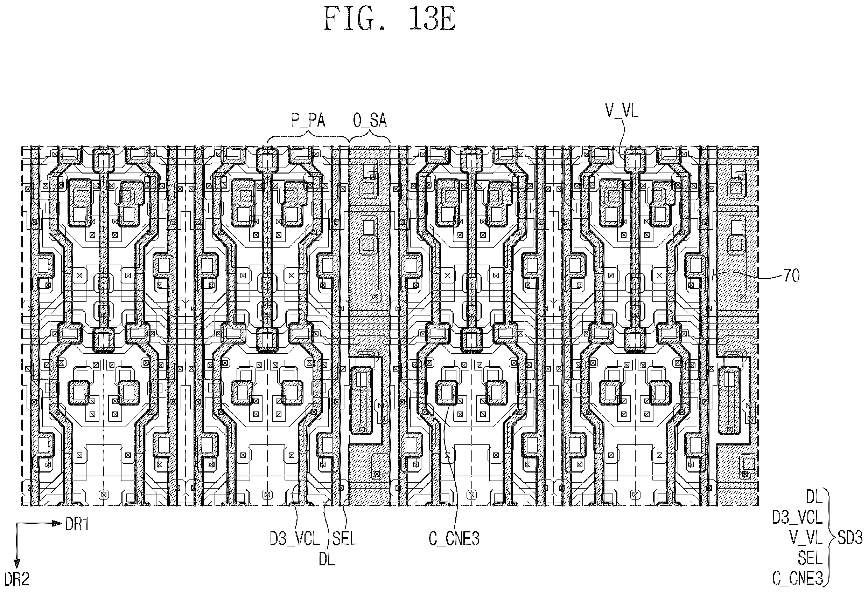

Referring to FIGS. 13D and 13E, the seventh insulating layer 70 may be disposed on the sixth insulating layer 60 and may cover at least a portion of the second data pattern layer SD2a. A third data pattern layer SD3 may be disposed on the seventh insulating layer 70.

The third data pattern layer SD3 may include a data wiring DL, a vertical connecting wiring D3_VCL, a shielding electrode wiring SEL, a vertical voltage wirings V_VL, and a plurality of third connecting electrode patterns C_CNE3.

Although the structure in which the additional pattern layer CMTLc is disposed below the third gate pattern layer GAT3c is illustrated in FIGS. 13A-13E, the present disclosure is not limited thereto. For example, the additional pattern layer CMTLc may be disposed above the third gate pattern layer GAT3c.

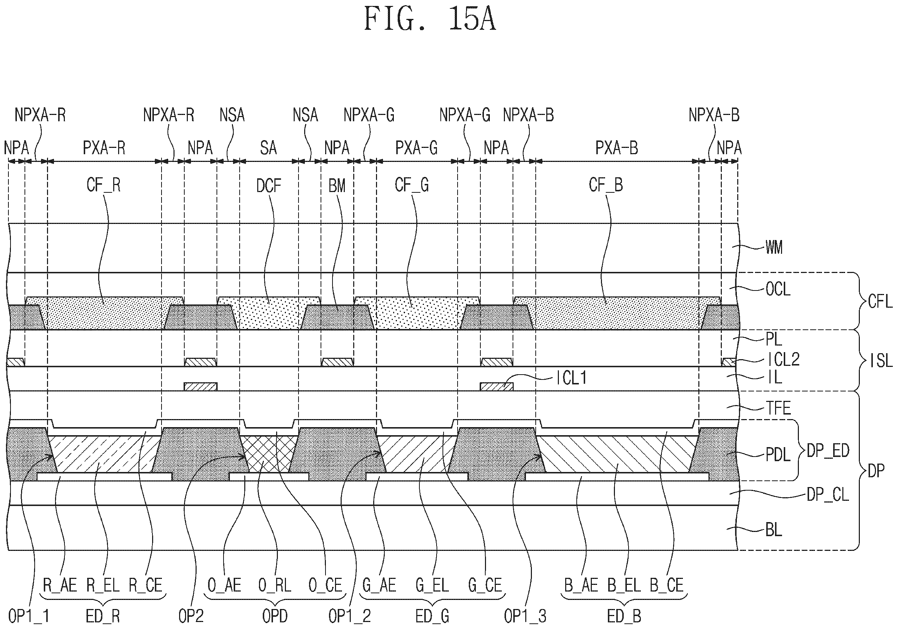

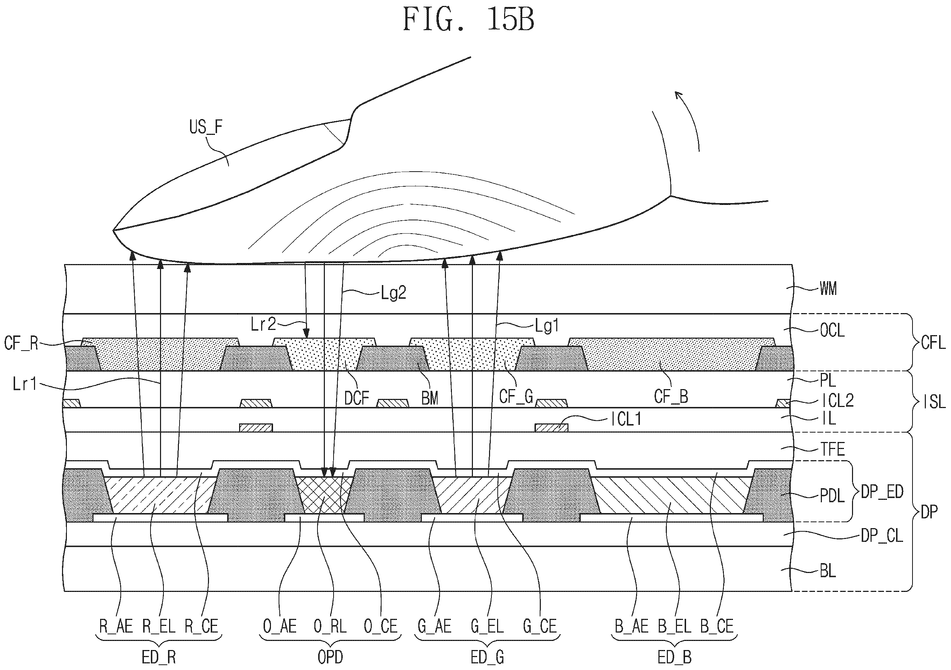

FIGS. 15A and 15B are sectional views illustrating light emitting elements and a light receiving element of the display panel.

Referring to FIGS. 15A and 15B, a first electrode layer is disposed on the circuit layer DP_CL. The pixel defining layer PDL is formed on the first electrode layer. The first electrode layer may include red, green, and blue anode electrodes R_AE, G_AE, and B_AE. First to third light emitting openings OP1_1, OP1_2, and OP1_3 of the pixel defining layer PDL expose at least portions of the red, green, and blue anode electrodes R_AE, G_AE, and B_AE, respectively. The pixel defining layer PDL may further include a black material. The pixel defining layer PDL may further include a black organic dye/pigment, such as carbon black, aniline black, and/or the like. The pixel defining layer PDL may be formed by mixing a blue organic material and a black organic material. The pixel defining layer PDL may further include a liquid-repellent organic material.

As illustrated in FIG. 15A, the display panel DP may include first to third emissive regions PXA-R, PXA-G, and PXA-B and first to third non-emissive regions NPXA-R, NPXA-G, and NPXA-B adjacent to the first to third emissive regions PXA-R, PXA-G, and PXA-B. The non-emissive regions NPXA-R, NPXA-G, and NPXA-B may surround the corresponding emissive regions PXA-R, PXA-G, and PXA-B, respectively. In the described embodiment, the first emissive region PXA-R is defined to correspond to a partial region of the red anode electrode R_AE exposed by the first light emitting opening OP1_1. The second emissive region PXA-G is defined to correspond to a partial region of the green anode electrode G_AE exposed by the second light emitting opening OP1_2. The third emissive region PXA-B is defined to correspond to a partial region of the blue anode electrode B_AE exposed by the third light emitting opening OP1_3. A non-pixel region NPA may be defined between the first to third non-emissive regions NPXA-R, NPXA-G, and NPXA-B.

A light emitting layer may be disposed on the first electrode layer. The light emitting layer may include red, green, and blue light emitting layers R_EL, G_EL, and B_EL. The red, green, and blue light emitting layers R_EL, G_EL, and B_EL may be disposed in regions corresponding to the first to third light emitting openings OP1_1, OP1_2, and OP1_3, respectively. The red, green, and blue light emitting layers R_EL, G_EL, and B_EL may be formed to be separated from one another. Each of the red, green, and blue light emitting layers R_EL, G_EL, and B_EL may include an organic material and/or an inorganic material. The red, green, and blue light emitting layers R_EL, G_EL, and B_EL may generate light of predetermined colors. For example, the red light emitting layer R_EL may generate red light, the green light emitting layer G_EL may generate green light, and the blue light emitting layer B_EL may generate blue light.

Although the patterned red, green, and blue light emitting layers R_EL, G_EL, and B_EL are illustrated, one light emitting layer may be commonly disposed in the first to third emissive regions PXAR, PXAG, and PXAB. In this case, the light emitting layer may generate white light or blue light. In addition, the light emitting layer may have a multilayer structure called tandem.

Each of the red, green, and blue light emitting layers R_EL, G_EL, and B_EL may include a low molecular weight organic material and/or a high molecular weight organic material as a luminescent material. Alternatively, each of the red, green, and blue light emitting layers R_EL, G_EL, and B_EL may include a quantum-dot material as a luminescent material. A core of a quantum dot may be selected from Group II-VI compounds, Group III-V compounds, Group IV-VI compounds, Group IV elements, Group IV compounds, and/or combinations thereof.

A second electrode layer is disposed on the red, green, and blue light emitting layers R_EL, G_EL, and B_EL. The second electrode layer may include red, green, and blue cathode electrodes R_CE, G_CE, and B_CE. The red, green, and blue cathode electrodes R_CE, G_CE, and B_CE may be electrically connected with one another. The red, green, and blue cathode electrodes R_CE, G_CE, and B_CE may have a one-body shape. In this case, the red, green, and blue cathode electrodes R_CE, G_CE, and B_CE may be commonly disposed in the first to third emissive regions PXA-R, PXA-G, and PXA-B, the first to third non-emissive regions NPXA-R, NPXA-G, and NPXA-B, and the non-pixel region NPA.

The element layer DP_ED may further include a light receiving element OPD. The light receiving element OPD may be a photo diode. The pixel defining layer PDL may further include a light receiving opening OP2 provided to correspond to the light receiving element OPD.

The light receiving element OPD may include a sensing anode electrode O_AE, a photoelectric conversion layer O_RL, and a sensing cathode electrode O_CE. The sensing anode electrode O_AE may be disposed on the same layer as the first electrode layer. That is, the sensing anode electrode O_AE may be disposed on the circuit layer DP_CL and may be concurrently (e.g., simultaneously) formed through the same process as the red, green, and blue anode electrodes R_AE, G_AE, and B_AE.

The light receiving opening OP2 of the pixel defining layer PDL exposes at least a portion of the sensing anode electrode O_AE. The photoelectric conversion layer O_RL is disposed on the sensing anode electrode O_AE exposed by the light receiving opening OP2. The photoelectric conversion layer O_RL may include an organic photo sensing material. The sensing cathode electrode O_CE may be disposed on the photoelectric conversion layer O_RL. The sensing cathode electrode O_CE may be concurrently (e.g., simultaneously) formed through the same process as the red, green, and blue cathode electrodes R_CE, G_CE, and B_CE. The sensing cathode electrode O_CE may be integrally formed with the red, green, and blue cathode electrodes R_CE, G_CE, and B_CE to form the common cathode electrode C_CE (e.g., refer to FIGS. 6A and 6B).

The encapsulation layer TFE is disposed on the element layer DP_ED. The encapsulation layer TFE includes at least an inorganic layer and/or an organic layer. The encapsulation layer TFE may include two inorganic layers and an organic layer disposed therebetween. The encapsulation layer TFE may include a plurality of inorganic layers and a plurality of organic layers alternately stacked one above another.

The inorganic layers protect the red, green, and blue light emitting elements ED_R, ED_G, and ED_B and the light receiving element OPD from moisture/oxygen, and the organic layers protect the red, green, and blue light emitting elements ED_R, ED_G, and ED_B and the light receiving element OPD from foreign matter such as dust particles. The inorganic layers may include a silicon nitride layer, a silicon oxy nitride layer, a silicon oxide layer, a titanium oxide layer, and/or an aluminum oxide layer, but are not particularly limited thereto. The organic layers may include an acrylic organic layer, but are not particularly limited thereto.

The display device DD includes the input sensing layer ISL disposed on the display panel DP and the color filter layer CFL disposed on the input sensing layer ISL.

The input sensing layer ISL may be directly disposed on the encapsulation layer TFE. The input sensing layer ISL includes a first conductive layer ICL1, an insulating layer IL, a second conductive layer ICL2, and a protective layer PL. The first conductive layer ICL1 may be disposed on the encapsulation layer TFE. Although FIGS. 15A and 15B illustrate a structure in which the first conductive layer ICL1 is directly disposed on the encapsulation layer TFE, the present disclosure is not limited thereto. The input sensing layer ISL may further include a base insulating layer disposed between the first conductive layer ICL1 and the encapsulation layer TFE. In this case, the encapsulation layer TFE may be covered by the base insulating layer, and the first conductive layer ICL1 may be disposed on the base insulating layer. The base insulating layer may include an inorganic insulating material.

The insulating layer IL may cover the first conductive layer ICL1. The second conductive layer ICL2 is disposed on the insulating layer IL. Although FIGS. 15A and 15B illustrate a structure in which the input sensing layer ISL includes the first and second conductive layers ICL1 and ICL2, the present disclosure is not limited thereto. For example, the input sensing layer ISL may include only one of the first and second conductive layers ICL1 and ICL2.

The protective layer PL may be disposed on the second conductive layer ICL2. The protective layer PL may include an organic insulating material. The protective layer PL may serve to protect the first and second conductive layers ICL1 and ICL2 from moisture/oxygen and may serve to protect the first and second conductive layers ICL1 and ICL2 from foreign matter.

The color filter layer CFL may be disposed on the input sensing layer ISL. The color filter layer CFL may be directly disposed on the protective layer PL. The color filter layer CFL may include a first color filter CF_R, a second color filter CF_G, and a third color filter CF_B. The first color filter CF_R has a first color, the second color filter CF_G has a second color, and the third color filter CF_B has a third color. The first color may be red, the second color may be green, and the third color may be blue.

The color filter layer CFL may further include a dummy color filter DCF. In one or more embodiments of the present disclosure, when a region where the photoelectric conversion layer O_RL is disposed is defined as a sensing region SA and a region around the sensing region SA is defined as a non-sensing region NSA, the dummy color filter DCF may be disposed to correspond to the sensing region SA. The dummy color filter DCF may overlap the sensing region SA and the non-sensing region NSA. The dummy color filter DCF may have the same color as one of the first to third color filters CF_R, CF_G, and CF_B. The dummy color filter DCF may have the same green color as the second color filter CF_G.

The color filter layer CFL may further include a black matrix BM. The black matrix BM may be disposed to correspond to the non-pixel region NPA. The black matrix BM may be disposed to overlap the first and second conductive layers ICL1 and ICL2 in the non-pixel region NPA. The black matrix BM may overlap the non-pixel region NPA and the first to third non-emissive regions NPXA-R, NPXA-G, and NPXA-B. The black matrix BM may not overlap the first to third emissive regions PXA-R, PXA-G, and PXA-B.

The color filter layer CFL may further include an overcoating layer OCL. The overcoating layer OCL may include an organic insulating material. The overcoating layer OCL may have a thickness sufficient to remove steps between the first to third color filters CF_R, CF_G, and CF_B. Without any specific limitation, the overcoating layer OCL may include any material that has a certain thickness and is capable of flattening the upper surface of the color filter layer CFL. For example, the overcoating layer OCL may include an acrylic organic material.

Referring to FIG. 15B, when the display device DD (e.g., refer to FIG. 1) operates, the red, green, and blue light emitting elements ED_R, ED_G, and ED_B may output light. The red light emitting elements ED_R output red light in a red wavelength band, the green light emitting elements ED_G output green light in a green wavelength band, and the blue light emitting elements ED_B output blue light in a blue wavelength band.

The light receiving element OPD may receive light from specific light emitting elements (e.g., the green light emitting elements ED_G) from among the red, green, and blue light emitting elements ED_R, ED_G, and ED_B. That is, second light Lg1 may be output from the green light emitting elements ED_G, and the light receiving element OPD may receive second reflected light Lg2 obtained by reflection of the second light Lg1 by the user's fingerprint. The second light Lg1 and the second reflected light Lg2 may be green light in the green wavelength band. The dummy color filter DCF is disposed over the light receiving element OPD. The dummy color filter DCF may be green in color. Accordingly, the second reflected light Lg2 may pass through the dummy color filter DCF and may be incident to the light receiving element OPD.

Meanwhile, the red light output from the red light emitting elements ED_R and the blue light output from the blue light emitting elements ED_B may also be reflected by the user's hand US_F. For example, when light obtained by reflection of first light Lr1 output from the red light emitting elements ED_R by the user's hand US_F is defined as first reflected light Lr2, the first reflected light Lr2 may fail to pass through the dummy color filter DCF and may be absorbed by the dummy color filer DCF. Accordingly, the first reflected light Lr2 is not able to pass through the dummy color filter DCF and is not able to be incident to the light receiving element OPD. Likewise, even though blue light is reflected by the user's hand US_F, the blue light may be absorbed by the dummy color filter DCF. Thus, only the second reflected light Lg2 may be provided to the light receiving element OPD.

As described above, the additional gate pattern layer may be added to the display panel. Accordingly, an enough space in which the scan lines are disposed in one pixel row may be secured without degradation in display resolution.

Furthermore, as the number of sensors included in the display panel is decreased, the display resolution of the display panel may be increased or improved. In addition, as the number of sensors is decreased, the reset voltage lines and the reset control lines that are connected to the sensors may be alternately arranged in units of at least one pixel row. Thus, as compared with when the reset voltage line and the reset control line are disposed in each pixel row, the display resolution of the display panel may be increased or improved.

While the present disclosure has been described with reference to embodiments thereof, it will be apparent to those of ordinary skill in the art that various suitable changes and modifications may be made thereto without departing from the scope of the invention as set forth in the following claims.

## Claims

1. A display device comprising:
a base layer (BL);
a circuit layer (DP_CL) on the base layer; and
an element layer (DP_ED) on the circuit layer, the element layer comprising light emitting elements and light receiving elements in a display region,
wherein the circuit layer (DP_CL) comprises:
pixel drive circuits (P_PD) connected to the light emitting elements (ED);
sensor drive circuits (O_SD) connected to the light receiving elements (OPD);
scan lines (SWLj, SCLj, SILj, SBLj) connected to the pixel drive circuits and extending in a first direction; and
reset control lines (SRL) connected to the sensor drive circuits and extending in the first direction,
wherein lengths of the sensor drive circuits in a second direction are greater than lengths of the pixel drive circuits in the second direction, and
wherein the scan lines are arranged in units of one pixel row, the reset control lines are arranged in units of p pixel rows, and p is greater than or equal to 2.

2. The display device of claim 1, wherein the circuit layer further comprises reset voltage lines (VRL) connected to the sensor drive circuits and extending in the first direction, and
wherein the reset voltage lines are arranged in units of q pixel rows, and q is greater than or equal to 2.

3. The display device of claim 2, wherein p is equal to q, and
wherein the reset voltage lines (VRL) and the reset control lines (SRL) are alternately arranged.

4. The display device of claim 1, 2 or 3, wherein the scan lines comprise:
compensation scan lines (SCLj); and
initialization scan lines (SILj), and
wherein a gap between the reset control lines in the second direction is greater than a gap between the compensation scan lines in the second direction and a gap between the initialization scan lines in the second direction.

5. The display device of claim 4, wherein the circuit layer further comprises:
a first gate pattern layer (GAT1) comprising a gate electrode;
a second gate pattern layer (GAT2) on the first gate pattern layer, the second gate pattern layer comprising an upper gate electrode;
an additional gate pattern layer (CMTL) on the second gate pattern layer, the additional gate pattern layer comprising first scan wirings and first reset control wirings; and
a third gate pattern layer (GAT3) on the additional gate pattern layer, the third gate pattern layer comprising second scan wirings and second reset control wirings.

6. The display device of claim 4, wherein the circuit layer further comprises:
a first gate pattern layer (GAT1) comprising a gate electrode;
a second gate pattern layer (GAT2) on the first gate pattern layer, the second gate pattern layer comprising an upper gate electrode;
a third gate pattern layer (GAT3) on the second gate pattern layer, the third gate pattern layer comprising first scan wirings and first reset control wirings; and
an additional gate pattern layer (CMTL) on the third gate pattern layer, the additional gate pattern layer comprising second scan wirings and second reset control wirings.

7. The display device of claim 5 or 6, wherein the first scan wirings comprise:
first compensation scan wirings; and
first initialization scan wirings,
wherein the second scan wirings comprise:
second compensation scan wirings connected to the first compensation scan wirings, respectively; and
second initialization scan wirings connected to the first initialization scan wirings, respectively,
wherein the compensation scan lines are defined by the first and second compensation scan wirings, respectively, and
wherein the initialization scan lines are defined by the first and second initialization scan wirings, respectively.

8. The display device of claim 7, wherein the first reset control wirings are connected to the second reset control wirings, respectively, and
wherein the reset control lines are defined by the first and second reset control wirings, respectively.

9. The display device of claim 5 or 6, wherein the additional gate pattern layer further comprises horizontal reset voltage wirings connected to the sensor drive circuits and extending in the first direction,
wherein the horizontal reset voltage wirings are arranged in units of q pixel rows, and q is greater than or equal to 2, and
wherein the first reset control wirings and the horizontal reset voltage wirings are alternately arranged.

10. A display device comprising:
a base layer (BL);
a circuit layer (DP_CL) on the base layer; and
an element layer (DP_ED) on the circuit layer, the element layer comprising light emitting elements (ED) and light receiving elements (OPD) in a display region,
wherein the circuit layer (DP_CL) comprises:
pixel drive circuits (P_PD) connected to the light emitting elements;
sensor drive circuits (O_SD) connected to the light receiving elements;
readout lines (RL) connected to the sensor drive circuits;
first data lines (DL_G1) connected to a first group of pixel drive circuits from among the pixel drive circuits;
second data lines (DL_G2) spaced from the first data lines in a first direction and connected to a second group of pixel drive circuits from among the pixel drive circuits;
data connecting lines (V_DCL, H_DCL) electrically connected with the second data lines, respectively, in the display region; and
shielding patterns (D1_SP) located between the readout lines and the data connecting lines at points where the readout lines and the data connecting lines cross each other.

11. The display device of claim 10, wherein the data connecting lines comprise:
a plurality of vertical connecting wirings extending along the first data lines; and
a plurality of horizontal connecting wirings extending in the first direction and crossing the readout lines,
wherein the plurality of horizontal connecting wirings electrically connects the plurality of vertical connecting wirings to the second data lines, and
wherein the shielding patterns are located between the plurality of horizontal connecting wirings and the readout lines.

12. The display device of claim 11, wherein the circuit layer further comprises:
a first gate pattern layer comprising a gate electrode;
a second gate pattern layer on the first gate pattern layer, the second gate pattern layer comprising first scan wirings, first reset control wirings, and an upper gate electrode; and
an additional gate pattern layer on the second gate pattern layer, the additional gate pattern layer comprising the horizontal connecting wirings; and
a third gate pattern layer on the additional gate pattern layer, the third gate pattern layer comprising second scan wirings and second reset control wirings;
or
a third gate pattern layer on the second gate pattern layer, the third gate pattern layer comprising second scan wirings and second reset control wirings; and
an additional gate pattern layer on the third gate pattern layer, the additional gate pattern layer comprising the horizontal connecting wirings.

13. The display device of claim 12, wherein the circuit layer further comprises:
a first data pattern layer on the third gate pattern layer;
a second data pattern layer on the first data pattern layer, the second data pattern layer comprising the readout lines; and
a third data pattern layer on the second data pattern layer, the third data pattern layer comprising the plurality of vertical connecting wirings and the first and second data lines, and
wherein the first data pattern layer comprises the shielding patterns or the shielding patterns are included in the third gate pattern layer.

14. The display device of claim 11, wherein the circuit layer further comprises:
a first gate pattern layer comprising a gate electrode;
a second gate pattern layer on the first gate pattern layer, the second gate pattern layer comprising first scan wirings, first reset control wirings, and an upper gate electrode;
and
an additional gate pattern layer on the second gate pattern layer, the additional gate pattern layer comprising the readout lines; and
a third gate pattern layer on the additional gate pattern layer, the third gate pattern layer comprising second scan wirings and second reset control wirings,
or
a third gate pattern layer on the second gate pattern layer, the third gate pattern layer comprising second scan wirings and second reset control wirings; and
an additional gate pattern layer on the third gate pattern layer, the additional gate pattern layer comprising the readout lines.

15. The display device of claim 12, wherein the circuit layer further comprises:
a first data pattern layer on the third gate pattern layer, the first data pattern layer comprising the horizontal connecting wirings;
a second data pattern layer on the first data pattern layer; and
a third data pattern layer on the second data pattern layer, the third data pattern layer comprising the plurality of vertical connecting wirings and the first and second data lines, and
wherein the shielding patterns are included in the third gate pattern layer.
